(19) Europäisches Patentamt / European Patent Office / Office européen des brevets

(11) **EP 2 083 509 A1**

(12) **EUROPEAN PATENT APPLICATION**
published in accordance with Art. 153(4) EPC

(43) Date of publication:
**29.07.2009 Bulletin 2009/31**

(51) Int Cl.:
**H02M 3/00** *(2006.01)*  **H02M 3/24** *(2006.01)*

(21) Application number: **07737133.4**

(22) Date of filing: **03.05.2007**

(86) International application number:
**PCT/JP2007/000477**

(87) International publication number:
**WO 2007/129468 (15.11.2007 Gazette 2007/46)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **10.05.2006 JP 2006130906**
**30.01.2007 JP 2007018715**
**09.04.2007 JP 2007101471**

(71) Applicant: **Imori, Masatoshi**
**Tokyo 112-0003 (JP)**

(72) Inventor: **Imori, Masatoshi**
**Tokyo 112-0003 (JP)**

(74) Representative: **Groth, Wieland**
**Schopenstehl 22**
**20095 Hamburg (DE)**

(54) **FEEDBACK FOR STABILIZING DC VOLTAGE PRODUCED FROM RESONANCE CIRCUIT**

(57)    Composition and evaluation are shown about the feedback circuit and its circuit constants which stabilize the direct-current output voltage obtained by rectifying a high-frequency carrier outputted from a resonance circuit against a wide range of load. An equivalent power supply is introduced, including a virtual resonance circuit and a virtual rectification circuit. The virtual resonance circuit, supplied with the same input with a resonance circuit, outputs the envelop of such the carrier that is outputted by the resonance circuit. The virtual rectification circuit, supplied with the envelop of the carrier, works as a first-order delay and outputs the direct-current voltage equivalent with the output of a rectification circuit. The equivalent power supply is described by the system of differential equations. The sufficient condition that the system of differential equations becomes stable is given. The feedback circuit satisfying the sufficient condition is shown to be stable by simulation.

Fig. 12:

**Description**

**[Technical Field]**

The present invention relates to stabilization of the output voltage of the power supply which generates direct-current output voltage using a resonance circuit. The stabilization enables the power supply to output a wide range of the direct-current voltage to the load of broad extent.

**[Background Art]**

For example, the power supply which generates the direct-current high voltage using a piezo-electric transformer is exactly the power supply which generates voltage using a resonance circuit. The power supply with the piezo-electric transformer was used where a comparatively high voltage was needed. In those usages, the output voltage needed not to be accurately or highly stabilized. So far the power supply with the piezo-electric transformer showed inferior stability of the output voltage against the change of the input voltage or the load current. For these reasons, the power supplies of the kind have been restricted to the usages subject to fixed input voltage and/or fixed load current.

[Patent Citation 1]

特開 2002-359967

[Patent Citation 2]

特開 2005-137085

The patent reference 1 makes it a subject to offer the simple circuit of the direct-current power supply providing the stabilized high voltage with sufficient efficiency. Efficiency is improved by using not a conventional electromagnetic transformer but a piezo-electric transformer. The high voltage is stabilized by using the frequency dependability of the resonance characteristics of a piezo-electric transformer. The piezoelectric transformer simplifies the circuit and reduces parts in number, by which the subject is solved.

The patent reference 2 realizes improvement of the output voltage both in the accuracy of stabilization and in the speed of response by implementing feedback of a little delay in addition to the feedback of a large delay where the output voltage is stabilized based on the frequency dependability of the resonance characteristic.

**Disclosure of Invention]**

**[Technical Problem]**

Composition of a circuit and its circuit constants are given to the feedback circuit which stabilizes the direct-current output voltage supplied to the load of a wide range where the direct-current voltage is obtained by rectifying a high-frequency alternating current carrier outputted by the resonance circuit.

In order to maintain stability and accuracy of the output voltage against the change of input voltage and of load current, a pole located in the neighborhood of the origin is integrated to the transfer function of the feedback circuit. The pole causes the delay of $\pi/2$ in phases. In order to stabilize the output voltage, it is required to compensate the delay. By introducing plural zeros to the feedback circuit and compensating the delay of both a rectification circuit and the resonance circuit, the feedback becomes stable, and the output of a power supply is stabilized against a wide range of load.

**[Technical Solution]**

The resonance circuit with a high Q value is driven by the carrier of the frequency near the resonance frequency where the carrier is of a locally constant amplitude. The direct-current voltage obtained by rectifying the carrier outputted from the resonance circuit depends on the frequency of the carrier. The direct-current voltage is stabilized by feeding back the direct-current voltage to the frequency of the carrier.

A power supply providing the stabilized direct-current output voltage consists of a voltage generation circuit and the feedback circuit. The voltage generation circuit is composed of a driver circuit, the resonance circuit, and the rectification circuit. The driver circuit generates the carrier which is the high-frequency alternating current of a locally constant amplitude. The carrier drives the resonance circuit. The feedback circuit consists of an error amplifier and a voltage controlled oscillator (VCO). The error amplifier compares the direct-current output voltage with the reference voltage supplied externally to set the output voltage. The VCO is enabled to control the frequency of the carrier generated by the driver circuit. The output voltage of the power supply, which is the output of the rectification circuit, is fed back to the frequency of the carrier through the feedback circuit so as to be stabilized

An equivalent power supply was developed, where the equivalent power supply approximates the direct-current stabilized high voltage power supply and can be analyzed by mathematical methods. Mathematical analysis of the equivalent power supply showed sufficient condition that the feedback becomes stable while the output voltage is in the neighborhood of the reference voltage. The problem was solved by selecting such circuit constants that implement sufficient condition to the circuit where the voltage difference between the output voltage and the reference voltage is fed back to the driving frequency of the carrier.

The power supply to be approximated by the equivalent circuit is schematically composed of a voltage generation circuit and a feedback circuit. The voltage generation circuit includes a driver circuit generating a carrier of locally fixed amplitude, a resonance circuit driven by the carrier supplied by the driver circuit, and a rectification circuit generating direct-current voltage by rectifying the carrier modulated in amplitude by the resonance circuit. The output of the power supply is the output of the rectification circuit. The feedback circuit includes an error amplifier comparing the output voltage with the reference voltage supplied externally to set the output voltage and a voltage controlled oscillator generating the frequency decided by the output of the error amplifier. The voltage controlled oscillator is enabled to control the frequency of the carrier generated by the driver circuit, and thus the output voltage is fed back to the frequency of the carrier so as to be stabilized.

An equivalent power supply consists of a virtual voltage generation circuit and the feedback circuit. This virtual voltage generation circuit consists of a driver circuit, a virtual resonance circuit, and a virtual rectification circuit. The resonance circuit converts the modulation of the carrier from the frequency modulation at the input to the amplitude modulation at the output. The virtual resonance circuit, supplied with the carrier of the frequency modulation as is the case with the resonance circuit, outputs the envelop of the carrier modulated in amplitude, being different from the resonance circuit. A virtual rectification circuit inputs the envelope, acts as a filter of first-order delay to the envelope, and realizes an output equivalent to the output of the rectification circuit.

The equivalent power supply includes the feedback circuit composed of the error amplifier and the VCO. The direct-current output voltage which is output of virtual rectification circuit is compared with the reference voltage by the error amplifier. The output of the error amplifier is supplied to the VCO and decides the frequency which the VCO outputs to the driver circuit. The VCO control the frequency of the carrier which the driver circuit generates. The direct-current output voltage is stabilized by feeding back the output voltage to the frequency of the carrier.

Operation of the equivalent power supply is described by a system of differential equations, stability of which can be analyzed mathematically. The system of differential equations is derived and then the sufficient conditions that the output voltage of the equivalent power supply is stable in the neighborhood of the reference voltage are shown. An actual circuit which realizes stable feedback based on the sufficient conditions is shown with circuit constants given explicitly.

**Stabilization of Output Voltage**

The resonance circuit of high Q value shows the resonance characteristic with sharp frequency response and large load dependence. The carrier which is modulated in frequency at the input of the resonance circuit is converted to the carrier modulated in amplitude at the output. An amplitude ratio, which is the ratio of the voltage at the input to the voltage at the output of the resonance circuit, shows resonance characteristics against the frequency of the carrier and a large amplitude ratio in the neighborhood of the resonance frequency. The power supply using the resonance circuit generates high voltage using the high amplitude ratio. The output voltage is stabilized by using the amplitude ratio being dependent on the frequency of the carrier.

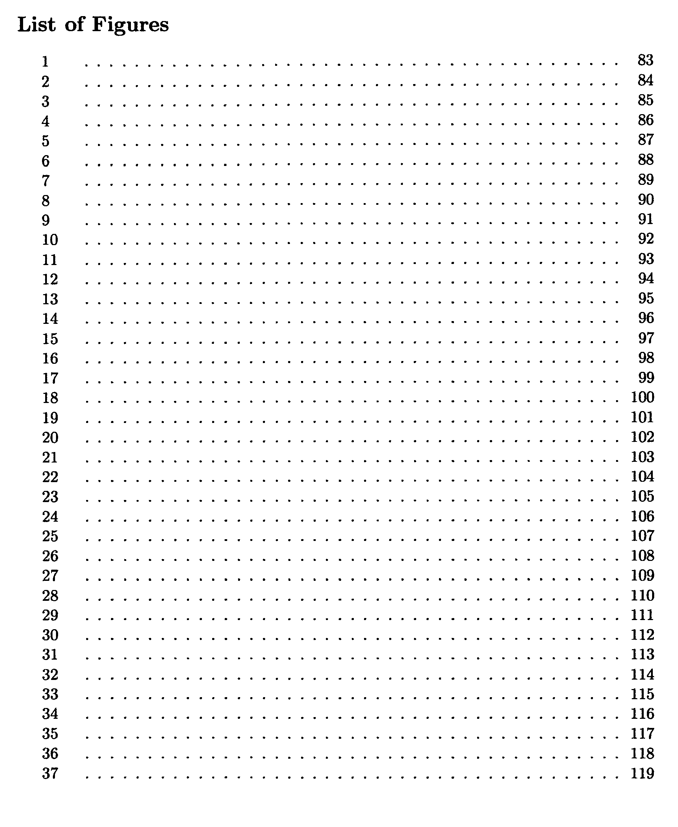

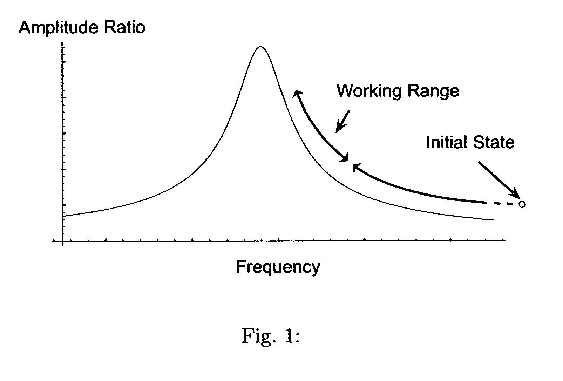

In the case that the frequency of the carrier, which drives the resonance circuit, is higher than the resonance frequency of the resonance circuit as shown in Fig. 1, the output voltage is raised by the decrease of the frequency or rather by moving the frequency close to the resonance frequency when the output voltage is lower than the reference voltage, and the output voltage is lowered by the increase of the frequency or by moving the frequency away from the resonance frequency when the output voltage is higher than the reference voltage

In the case where the range of the frequency of the carrier is selected to be lower than the resonance frequency, the output voltage is stabilized by increasing the frequency when the output voltage is lower than the reference voltage, and the output voltage is lowered by decreasing the frequency when the output voltage is higher than the reference voltage.

**Frequency Modulation**

The VCO outputs the frequency which is an function of the input voltage supplied to the VCO. Let u (t) be the carrier in frequency modulation and written as follows:

$$u(t) = w \, exp(i \, \omega_c \, t + i \, \psi). \qquad (1)$$

where the time-invariant amplitude of the carrier is expressed by w, and it is assumed that the carrier applied to the resonance circuit corresponds to the real part of expression 1.

Let $\phi$ be defined by

$$\phi = \frac{d}{dt} \psi. \qquad (2)$$

Letting v be the input to the VCO, then

$$\omega_c + \phi = 2 \, \pi \, f_{self} - k \, v \qquad (3)$$

holds, where $f_{self}$ denotes a self-running frequency of the VCO and $k$ is a proportional constant between $\phi$ and $v$. For later convenience of calculation, it is assumed that $\omega_c = \omega_0$ where $\omega_0$ is defined in expression 9. Let $\phi_C$ be defined by

$$\phi_C = 2 \, \pi \, f_{self} - \omega_c. \qquad (4)$$

Then expression 3 is rewritten as

$$\phi = -k \, v + \phi_C, \qquad (5)$$

and expression 3 leads to the following expression.

$$\frac{d}{dt} \phi = -k \, \frac{d}{dt} v. \qquad (6)$$

**Resonance Circuit**

A resonance circuit, where load resistance $R_L$ is connected to its output, shows resonance which is described in terms of Q-value, the resonance frequency and the amplitude ratio at the resonance as shown in the following

$$h(s) = \frac{cs}{s^2 + as + b} \qquad (7)$$

where $a$, $b$, and $c$ is defined as follows:

$$\gamma = Q^{-1}, \quad a = \gamma \omega_r, \quad b = \omega_r{}^2, \quad c = g_r \gamma \omega_r. \qquad (8)$$

where $Q$ is the Q-value of the resonance, $\gamma$ is the inverse of $Q$, $\omega_r$ is the angular velocity at the resonance frequency, and $g_r$ is the amplitude ratio at the resonance.

The transfer function defined in expression 7 has denominator $s^2 + as + b$. Let $\alpha$ and $\beta$ be roots of equation $s^2 + as + b = 0$. Then $\alpha$ and $\beta$ can be expressed in terms of a positive number $\delta$ and $\omega_0$ as follows:

$$\alpha = -\delta + i\omega_0, \quad \beta = -\delta - i\omega_0. \tag{9}$$

Expression 8 and expression 9 lead to

$$\delta \;=\; \frac{\omega_r}{2Q}, \tag{10}$$

$$\omega_0 \;=\; \omega_r \sqrt{1 - \frac{1}{4Q^2}}. \tag{11}$$

The resonance is sharp, the Q-value being a few tens. Therefore

$$\omega_0 \simeq \omega_r \tag{12}$$

holds.

The resonance, where the Q value is 30, the amplitude ratio is 100, and the resonance frequency is 120 kHz, is expressed by transfer function $h_0(s)$ defined by

$$h_0(s) = 800000.0 \, \frac{\pi s}{s^2 + 8000.0 \, \pi \, s + 57600000000.0 \, \pi^2}. \tag{13}$$

Let $\delta_0$ and $\omega_0$ be defined respectively by $\delta$ and $\omega$ associated with $h_0(s)$, then

$$\delta_0 \simeq 12566, \quad \omega_0 \simeq 753878. \tag{14}$$

In the argument hereafter, the conditions that the direct-current voltage is stably generated from the given resonance circuit expressed by transfer function $h(s)$ are searched for.

**Transfer Function Around Resonance**

It is shown that the transfer function of expression 7 can be approximated by a first-order delay with the pole located at a complex number. Let the input and the output of the resonance circuit be $u$ and $f$ respectively where $u$ is defined in expression 1, then $f$ can be obtained by operator calculus as follows:

$$f \quad = \quad h\,u \tag{15}$$

$$= \quad \frac{cs}{s^2 + as + b}\,u \tag{16}$$

$$= \quad \frac{cs}{(s-\alpha)(s-\beta)}\,u \tag{17}$$

$$= \quad \frac{c}{\alpha - \beta}\Big(\frac{\alpha}{s-\alpha} - \frac{\beta}{s-\beta}\Big)\,u \tag{18}$$

$$= \quad \frac{c}{\alpha - \beta}\Big(\frac{\alpha}{s+\delta - i\omega_0} - \frac{\beta}{s+\delta + i\omega_0}\Big)\,w\,exp(i\omega_0 t + i\psi) \tag{19}$$

$$= \quad \frac{c\,w}{\alpha - \beta}\Big[\alpha \int_0^t exp\{(-\delta + i\omega_0)\,(t-\tau)\}exp(i\omega_0\tau + i\psi)d\tau \tag{20}$$

$$-\beta \int_0^t exp\{(-\delta - i\omega_0)\,(t-\tau)\}exp(i\omega_0\tau + i\psi)d\tau\Big]$$

$$= \quad \frac{c\,w}{\alpha - \beta}(A - B) \tag{21}$$

where

$$A \quad = \quad \alpha\,exp\{(-\delta + i\omega_0)\,t\} \int_0^t exp(\delta\,\tau + i\psi)d\tau \tag{22}$$

$$B \quad = \quad \beta\,exp\{(-\delta - i\omega_0)\,t\} \int_0^t exp(\delta\,\tau + 2\,i\omega_0\tau + i\psi)d\tau. \tag{23}$$

Since the frequency of the carrier is in the neighborhood of the resonance frequency, there exists a positive number M such that the following condition holds for arbitrary time $t(>0)$.

$$|\psi(t)'| \le M. \tag{24}$$

Then the following estimation holds.

$$\left|\int_0^t exp(\delta\,\tau)i\psi'\,exp(i\psi)d\tau\right| \le \int_0^t exp(\delta\,\tau)\,|i\psi'|\,d\tau \tag{25}$$

$$\le M \int_0^t exp(\delta\,\tau)d\tau \le \frac{M\,exp(\delta\,t)}{\delta}. \tag{26}$$

Similarly,

$$\left|\int_0^t exp(\delta\,\tau + 2\,i\omega_0\tau)i\psi'\,exp(i\psi)d\tau\right| \le \frac{M\,exp(\delta\,t)}{\delta}. \tag{27}$$

Integration about $A$ is calculated as

$$\int_0^t exp(\delta\tau + i\psi)d\tau \tag{28}$$

$$= \int_0^t exp(\delta\tau)exp(i\psi)d\tau \tag{29}$$

$$= \frac{1}{\delta}\{exp(\delta t + i\psi) - exp\, i\psi(0) \tag{30}$$

$$- \int_0^t exp(\delta\tau)i\psi'\, exp(i\psi)d\tau\}. $$

Then $A$ is found as

$$
\begin{aligned}
A \;=\; & \frac{\alpha}{\delta}\{exp(i\omega_0 t + i\psi) \\
& -exp(i\psi(0))exp(-\delta + i\omega_0)t \\
& -exp(-\delta + i\omega_0)t \int_0^t expa(\delta\tau)i\psi'\, exp(i\psi)d\tau\}.
\end{aligned}
\tag{31}
$$

$A$ is estimated as follows:

$$|A| \sim |\alpha|\left(2 + \frac{M}{\delta}\right)\delta^{-1}. \tag{32}$$

Similarly, integration about $B$ is calculated as

$$\int_0^t exp((\delta + 2i\omega_0)\tau + i\psi)d\tau \tag{33}$$

$$= \frac{1}{\delta + 2i\omega_0}\{exp((\delta + 2i\omega_0)t + i\psi) - exp\, i\,\psi(0) \tag{34}$$

$$- \int_0^t exp((\delta + i\omega_0)\tau)i\psi'\, exp(i\psi)d\tau\}. $$

Following estimation holds about $B$.

$$|B| \sim |\beta|\left(2 + \frac{M}{\delta}\right)|\delta + 2i\omega_0|^{-1}. \tag{35}$$

An upper limit of the bandwidth where the VCO modulates the frequency for the carrier is $M$. Bandwidth $M$ ranges from $\delta$ to 10 times $\delta$ at most in magnitude. On the other hand, the resonance frequency $\omega_0$ is more than 100 times $\delta$ in magnitude. Moreover $|\alpha| = |\beta|$. Therefore the error caused by eliminating $B$ can be estimated less than 10 % of $|f|$ Transfer function $h^T(s)$ disregarding $B$ is defined by

$$h^T = \frac{c}{\alpha - \beta}\frac{\alpha}{s - \alpha}. \tag{36}$$

The output $g$ of the resonance circuit is defined as follows:

$$g = h^T u. \tag{37}$$

Difference between *f* and *g*, which are both the output of the resonance circuit, is at most 10 % in magnitude. Then it can seen that transfer function *g* is a good approximation of *f* in the vicinity of the resonance frequency.

**Comparison of Transfer Function h(s) With Approximation $h^T(s)$**

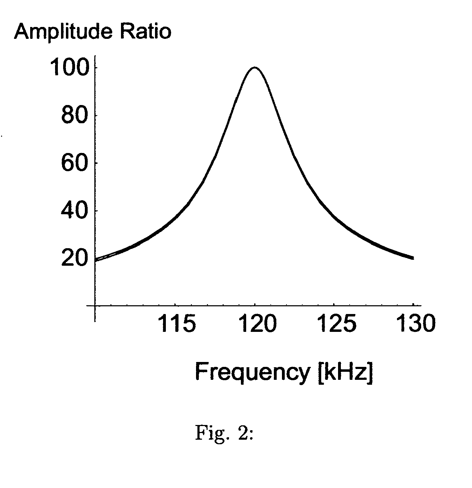

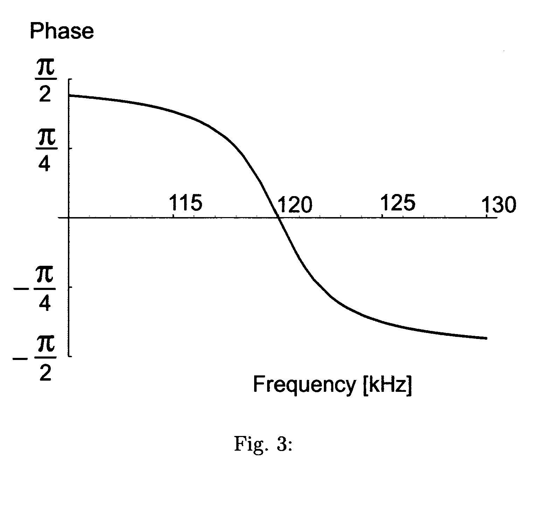

Transfer function $h_0^T(s)$ which approximates $h_0(s)$ defined in expression 13 is compared with $h_0(s)$. Both of $h_0(s)$ and $h_0^T(s)$ are simultaneously plotted about amplitude ratio in Fig. 2 and about phase in Fig. 3. As is seen from the figures, $h_0^T(s)$ is a good approximation of $h_0(s)$.

**A System of Differential Equations for Envelope of Output From Resonance Circuit**

From expression 37, *g* satisfies the following differential equations.

$$\frac{d}{dt}g - (-\delta + i\omega_0)g = \frac{c\alpha}{\alpha - \beta}u, \tag{38}$$

$$u = w\,exp(i\,\theta), \tag{39}$$

$$\theta = \omega_0\,t + \psi. \tag{40}$$

Real variables *p* and *q* are introduced in expression 41. Real constants $r_r$ and $r_i$ are defined by expression 42.

$$g = (p + i\,q)\,exp(i\,\theta), \tag{41}$$

$$\frac{c\alpha}{\alpha - \beta}\,w = r_r + i\,r_i. \tag{42}$$

Since ω, the fixed amplitude of the carrier, is real, $r_r$ and $r_i$ are expressed by

$$r_r = \frac{1}{2}c\,w, \quad r_i = \frac{\delta}{2\,\omega_0}\,c\,w. \tag{43}$$

Then *p* and *q* satisfy the following differential equations.

$$\frac{d}{dt}p - q\frac{d}{dt}\theta + \delta\,p + q\omega_0 = r_r, \tag{44}$$

$$\frac{d}{dt}q + p\frac{d}{dt}\theta + q\delta - p\omega_0 = r_i. \qquad (45)$$

where $\theta$, defined in expression 40, is the phase of the carrier outputted by the VCO. Expressions 40 and 2 lead to

$$\frac{d}{dt}\theta = \omega_0 + \phi, \qquad (46)$$

which, simplifying expressions 44 and 45, leads to the following system of regular differential equations.

$$\frac{d}{dt}p = q\phi - p\delta + r_r, \qquad (47)$$

$$\frac{d}{dt}q = -p\phi - q\delta + r_i. \qquad (48)$$

The output of the resonance circuit is enveloped by $|g|$, which is denoted by $y$. Then

$$y = \sqrt{p^2 + q^2}. \qquad (49)$$

**Amplitude of Stationary Output from Resonance Circuit**

It is assumed here that $\phi$ is invariant in time, and that $p(t)$ and $q(t)$ are solutions of expression 47 and expression 48. Then

$$\lim_{t \to \infty} p(t) = \frac{\delta r_r + r_i \phi}{\phi^2 + \delta^2}, \qquad (50)$$

$$\lim_{t \to \infty} q(t) = \frac{-\phi r_r + \delta r_i}{\phi^2 + \delta^2}. \qquad (51)$$

The stationary amplitude of the carrier outputted by the resonance circuit is given by

$$\frac{r}{\sqrt{\phi^2 + \delta^2}} \qquad (52)$$

where r is defined by

$$r = \sqrt{r_r^2 + r_i^2}. \qquad (53)$$

From the above, the stationary amplitude becomes maximum at $\phi = 0$, and the maximum amplitude is given by

$$\frac{r}{\delta}. \tag{54}$$

**Dependence of Stationary Amplitude on** $\phi$

The stationary amplitude of the carrier outputted by the resonance circuit is

$$\frac{r}{\sqrt{\phi^2 + \delta^2}}. \tag{55}$$

A shift of $\phi$ by $\Delta\phi$ causes the change of the stationary amplitude as

$$-\frac{r\phi}{(\phi^2 + \delta^2)^{3/2}}\Delta\phi. \tag{56}$$

**Estimation of Constant** $r$

From expression 42

$$r = \sqrt{r_r{}^2 + r_i{}^2} = \left|\frac{c\alpha}{\alpha - \beta}\right||w|. \tag{57}$$

Namely, $r$ is dependent of the amplitude $|w|$ of the carrier defined in expression 1. When the dependence is emphasized, $r$ is expressed as $r_{|w|}$. Then, for an arbitrary $a$,

$$|a|\, r_{|w|} = r_{|a||w|} \tag{58}$$

holds.
Estimation of $r$ associated with $h_0{}^T(s)$ which is derived from $h_0(s)$ defined in expression 13 is

$$r_1 \quad = \quad \left|\frac{c\alpha}{\alpha - \beta}\right| \simeq 1256811.630, \tag{59}$$

$$r_9 \quad \simeq \quad 11311304.67, \tag{60}$$

The above estimation leads to

$$\frac{r_1}{\delta_0} \sim 100. \tag{61}$$

**Q-Value of Resonance Circuit**

Q-value of a resonance circuit changes according the loads connected to the output of the resonance circuit. Q-value will become large if load becomes light. In many resonance circuits, the amplitude of the output at the resonance frequency is proportional to the Q-value approximately. That is, the amplitude ratio at the resonance frequency is proportional to the Q-value in crude approximation. The resonance frequency also changes in response to loads in many resonance circuits too. That is, the resonance frequency depends on Q value. However, the dependence is small in many resonance circuits.

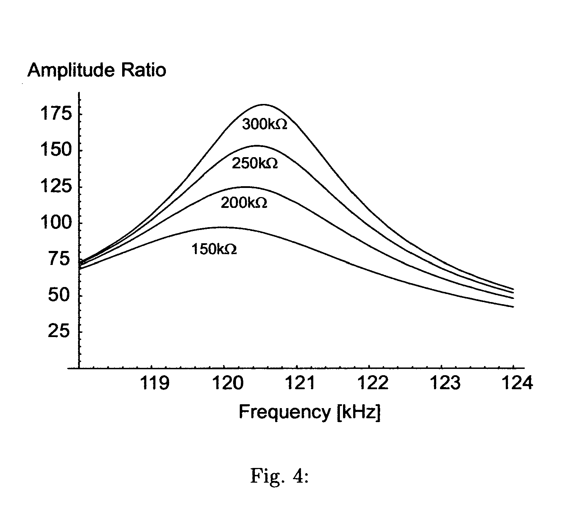

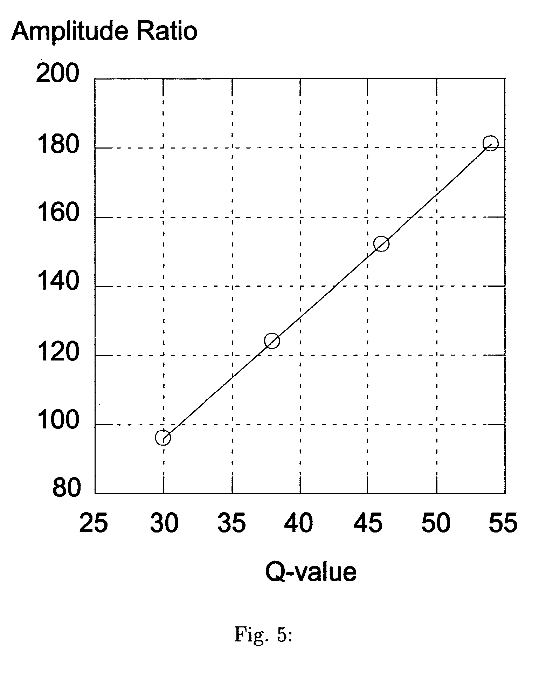

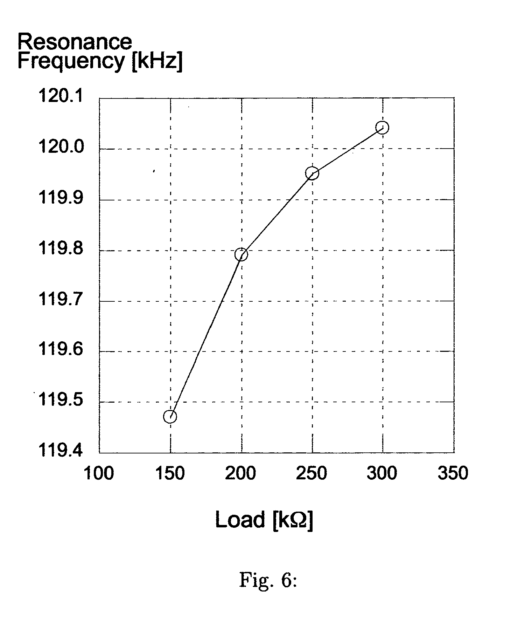

About the piezo-electric transformer providing the frequency dependence of the amplitude ratio shown in Fig. 4, the dependence on the Q-value of the amplitude ratio at the resonance frequency is investigated. The Q-value dependence of the amplitude ratio is shown in Fig. 5, and the load dependence of the resonance frequency is shown in Fig. 6. Fig. 5 shows that the amplitude ratio at the resonance frequency is approximately proportional to the Q-value. It can be seen from Fig. 6 that the change of the load from 150 kS2 to 300 kΩ causes the shift of about 600 Hz in frequency about the resonance frequency. The shift is enough small compared with the resonance frequency around 120 kHz.

The transfer function of the resonance circuit to which load was connected is expressed as $h(s)$ in expression 7, and coefficient c is given from expression 8 as follows:

$$c = g_r \frac{1}{Q} \omega_r. \qquad (62)$$

Here, $g_r$ expresses the amplitude ratio of the resonance circuit at resonance frequency, and is approximately proportional to Q-value. Moreover $\omega_r$, the angular velocity of the resonance frequency, is considered to be nearly independent of the load and then approximately constant. Then it will be understood that coefficient $c$ is approximately independent of the Q value. Namely coefficient $c$, being independent of the load and approximately fixed, can be considered to be inherent in the resonance circuit.

**Measurement of $\delta$ and $r$ of Resonance Circuit**

Expressions 57 and 43 lead to

$$r = \sqrt{r_r{}^2 + r_i{}^2} \qquad (63)$$

$$= \frac{1}{2} c w \sqrt{1 + \frac{1}{4Q^2}}. \qquad (64)$$

Since Q is a few tens, then

$$r \simeq \frac{1}{2} c w. \qquad (65)$$

Coefficient $c$ is inherent in the resonance circuit and $w$ is the amplitude of the carrier, it turns out that $r$ is independent of $Q$ and $\delta$. Then $r$ can be obtained directly by measuring the output from the resonance circuit.

Q value of the resonance is widely measured. Let $Q$ be the $Q$-value of the resonance circuit driven by the carrier of the fixed amplitude. Then $\delta$ can be expressed from expression 10 as

$$\delta = \frac{\omega_r}{2Q} \qquad (66)$$

where $\omega_r$ is the angular velocity at the resonance frequency. Let $R$ be the maximum of the amplitude outputted by the resonance circuit, then expression 54 shown in the following gives $r$ for the known $\delta$ and $R$.

$$R = \frac{r}{\delta}. \qquad (67)$$

From expression 65, r thus obtained is hardly dependent on $\delta$.

**Charging and Discharging Rectification Circuit**

The output voltage of the power supply is generated by the rectification circuit. The rectification circuit includes a capacitor, and the output voltage is buffered by the capacitor. The buffering reduces ripples superimposed on the output voltage. In the case that the output voltage is positive, pumping up the charge to the capacitor raises the output voltage, while it is impossible to pumping out the charge from the capacitor so as to lower the output voltage. So the output voltage of the rectification circuit cannot fall faster than the time constant decided mainly by the output capacitor and the load resistance. When the voltage supplied to the output capacitor falls faster than the time constant, then the output capacitor is left not to be charged, that is, the current does not flow into the rectification circuit.

**Conducting State**

Conducting and disconnecting states are introduced to the rectification circuit. The current flows into the rectification circuit in the conducting state, while the current does not flow into the rectification circuit in the disconnecting state. The output voltage falls in the disconnecting state. The rectification circuit maintaining a fixed voltage to a fixed load is in the conducting state. While the output voltage maintains the fixed voltage against the load varying in magnitude slightly, increase of the current to the rectification circuit raising the output voltage and decrease of the current lowering the output voltage are the shifts of the current and the voltage in the neighborhood of the equilibrium maintaining the output voltage specified by the reference voltage to a fixed load, and the feedback works effectively in the neighborhood of the equilibrium. The rectification circuit is in the conducting state in the neighborhood of the equilibrium, and then both of the time constants for the rise and for the fall of the output voltage agrees in the first approximation with $\mu$.
A system of differential equations is introduced later to describe the power supply in the conduction state. If the feedback works stably in the conducting state, then the voltage difference between the output voltage and the reference voltage is kept extremely small. The stability of the system of differential equations is equivalent to the stability of the power supply in the conducting state. Then the condition that the power supply is stable is expressed in terms of the stability of the system of differential equations as that all the roots of a characteristic polynomial have a negative real part and that the real part of a dominant root is large enough compared with its imaginary part, where letting a characteristic polynomial be $m(h)$, the roots of the characteristic polynomial are defined to be the roots of equation $m(h) = 0$.

**Disconnecting State**

The output voltage becomes higher than the reference voltage and keeps higher than the reference voltage even though the current flowing into the rectification circuit becomes zero, then the rectification circuit is brought to the disconnecting state. The feedback does not work effectively in the disconnecting state, and the voltage difference between the output voltage and the reference voltage becomes finite. As the charge stored in the capacitor is discharged through the load, the output voltage is lowered. The time constant for the fall of the output voltage through the discharge is not smaller than the time constant decided with the capacitor and the load. The disconnecting state is switched to the conducting state when the output voltage becomes lower than the reference voltage.

**Switching to Conducting State**

Once the conducting state comes to be switched to, the output voltage begins to increase. In order to increase the output voltage, the resonance circuit is required generally to charge the capacitor and to supply the current to the load. The time constant for the rise of the output voltage becomes smaller as the load becomes lighter, depending on the load. Yet in the conducting state, the feedback works effective, and then the time constant is under the control of the feedback and depends on the dominant root of the characteristic polynomial corresponding to the system of differential equations,.

**Overshoot of Output Voltage**

If the overshoot of the output voltage is accompanied by the rise of the output voltage, the output voltage becomes higher than the reference voltage, and then disconnecting state comes to be switched to. As a result, an intermittent oscillation between the conducting and the disconnecting states is initiated.

In order not to initiate the intermittent oscillation, it is necessary that the overshoot is not accompanied by the rise of the output voltage caused by switching from the disconnecting state to the conducting state. If the overshoot does not emerge, the feedback works to raise the output voltage, and the stability of the feedback is attributed to the stability of the system of differential equations.

If the dominant root of the characteristic polynomial is not a real root, the rise of the output voltage accompanies the overshoot, and the intermittent oscillation may be initiated. In the case that the dominant root is a real root, the system of differential equations is stable and so is the power supply.

In the case that the output voltage becomes higher than the reference voltage accidentally with a subtle noise, the output voltage can be thought to be lowered either by the feedback or in the disconnecting state, both of which can not be distinguished substantially so far as the intermittent oscillation is not initiated.

**Equivalent Power Supply Based on Envelope**

The power supply, the stability of which is analyzed by the system of differential equations, is composed of a voltage generation circuit and a feedback circuit. The voltage generation circuit includes a driver circuit, a resonance circuit and a rectification circuit. The driver circuit generates a carrier of a locally fixed amplitude, and the carrier drives the resonance circuit. The carrier outputted by the resonance circuit is modulated in amplitude, and is supplied to the rectification circuit where the carrier is rectified and smoothed. The carrier is converted to a direct-current voltage at the rectification circuit. The direct-current voltage thus generated is the output voltage of the power supply.

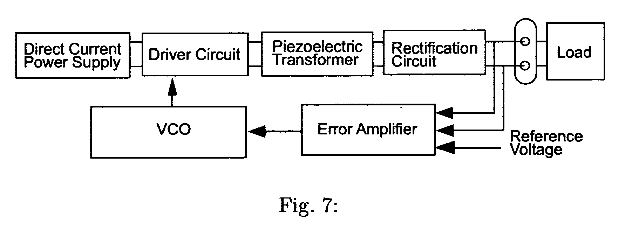

The feedback circuit contains a error amplifier and a voltage controlled oscillator(VCO). The error amplifier compares the output voltage with a reference voltage and detects voltage difference between them. The VCO generates the frequency and control the driver circuit. The output of the error amplifier is supplied to the VCO and decides the frequency. The VCO makes the driver circuit generate the carrier of the frequency supplied by the VCO. Thus the output voltage is fed back to the frequency of the carrier, which stabilizes the output voltage of the power supply. The block diagram of the power supply is shown in Fig. 7.

**Virtual Resonance Circuit and Virtual Rectification Circuit**

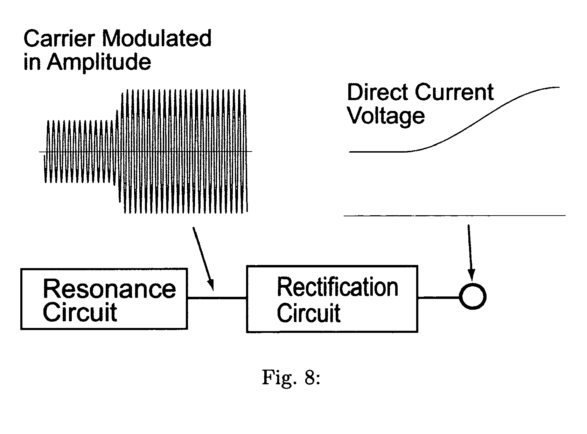

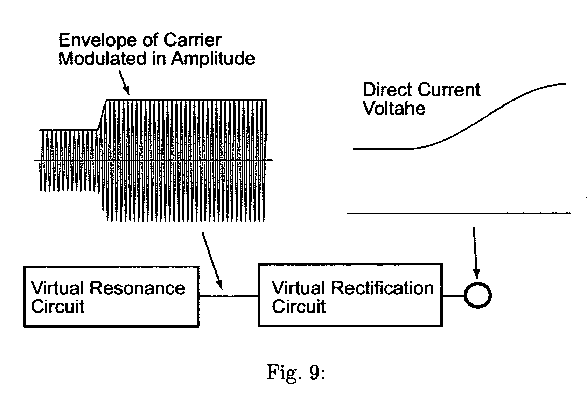

The output of the resonance circuit as is shown in Fig. 8 is the carrier modulated in amplitude, and is converted to the direct-current voltage by the rectification circuit. For the ease of analysis, A virtual resonance circuit and a virtual rectification circuit are introduced, by which the resonance circuit and the rectification circuit are approximated respectively. The carrier inputted to the virtual resonance circuit is identical with the carrier supplied to the resonance circuit, being modulated in frequency. Yet the output of the virtual resonance circuit is not the carrier modulated in amplitude but the envelope of such the carrier as shown in Fig. 9. The envelope outputted by the virtual resonance circuit is inputted to the virtual rectification circuit. The virtual rectification circuit is provided with such the transfer function that produces the output equivalent with the output of the rectification circuit. The envelope inputted to the virtual rectification circuit is converted by the transfer function to the output equivalent to output of the rectification circuit.

**Transfer Function of Virtual Rectification Circuit**

The rectification circuit converts the carrier modulated in amplitude to the direct-current voltage by rectification and smoothing. The conversion to the direct-current voltage accompanies a large delay. Namely the change of the carrier in amplitude shifts the direct-current voltage with a large delay. A first order delay is a good approximation of the transfer function with a large delay. Then, a first order delay is assumed to be the transfer function of the virtual rectification circuit.

Let $\mu$ be the time constant of the first order delay, and $\nu$ be a multiplier by which the direct-current voltage is multiplied at the output, the transfer function of the virtual rectification circuit is

$$\frac{\nu}{\mu s + 1}. \tag{68}$$

If the output of the rectification circuit is differentiated by a differential circuit so that the pole due to the first-order delay can be cancelled, then the output from the differential circuit is equivalent to the envelop which is inputted to the virtual rectification circuit.

Multiplier $\mu$, introduced for the multiplicative rectification, is related to the output voltage of the power supply. The output voltage depends on the output impedance of the power supply and the load resistance. In this sense, multiplier $\nu$ varies in dependence on the output impedance and the load resistance.

**Time Constants $\mu$ And $\nu$**

Time constant $\mu$ is introduced to the first-order delay of the virtual rectification circuit so that the output of the virtual rectification circuit can simulate the output of the rectification circuit. The resonance circuit is described with the parameters of the resonance frequency, the gain at the resonance frequency and the Q-value of the resonance. New parameters $\mu$ and $\nu$ are introduced to describe the process in which the rectification circuit is charged by the resonance circuit and discharged by the load, where $\mu$ is the time constant of charging and discharging the rectification circuit, and $\nu$ is a multiplier at the multiplicative rectification. Both of $\mu$ and $\nu$, which are dependent on the output voltage and current of the power supply, vary slowly against the change of the output voltage and current. So $\mu$ and $\nu$ can be approximated by constants around a fixed output voltage and current.

**Delays Caused by Resonance Circuit and by Rectification Circuit**

Here the delays caused by the resonance circuit and by the rectification circuit are investigated. Let $f$ sec be the delay of the resonance circuit and $\mu$ be the delay of the rectification circuit, then

$$f \ll \mu \qquad\qquad (69)$$

holds. The delay of the resonance circuit is estimated in terms of $\delta$ to be

$$f \sim \frac{1}{\delta}. \qquad\qquad (70)$$

Then, the above two expressions lead to

$$\mu\,\delta \gg 1, \qquad\qquad (71)$$

**Equivalent Power Supply**

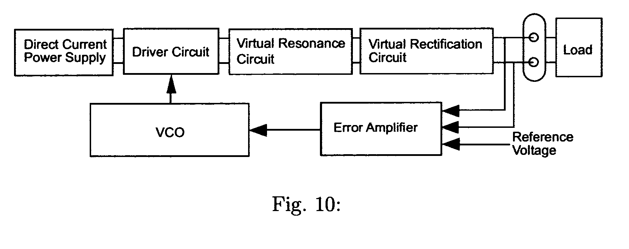

The equivalent power supply is composed of a virtual voltage generation circuit and the feedback circuit, where the virtual voltage generation circuit includes the driver circuit, the virtual resonance circuit and the virtual rectification circuit. The feedback circuit contains the error amplifier and the VCO. The direct-current voltage outputted by the virtual rectification circuit is the output voltage of the equivalent power supply, which is fed back to the frequency of the carrier. The error amplifier is composed of a subtraction circuit and a phase-compensation circuit. The output of the subtraction circuit which detects the voltage difference between the output voltage and the reference voltage is supplied to the phase-compensation circuit. The output of the phase-compensation circuit is the output of the error amplifier. The VCO generates the frequency that is decided by the output of the error amplifier. The VCO makes the driver circuit produce the carrier of the frequency that is generated by the VCO. Block diagram of the equivalent power supply is shown in Fig. 10.

**Crude Estimation of Loop Gain of Equivalent Power Supply**

Let $y$ be the output voltage of the virtual resonance circuit and $z$ be the output of the virtual rectification circuit in voltage, then the following estimation holds at a direct-current level.

$$z = \nu y = \nu \sqrt{p^2 + q^2}. \tag{72}$$

Voltage $d\,z$, which is division of $z$ by a divide resistor, and reference voltage n are supplied to the subtraction circuit, where $d$ is the division ratio of divider resistors $R_1$ and $R_2$ as follows:

$$d \; = \; \frac{R_2}{R_1 + R_2}, \tag{73}$$

$$v \; = \; (d\,z - n), \tag{74}$$

where $v$ is the voltage difference at the input of the subtraction circuit..

Suppose the output voltage of the virtual rectification circuit shifts from $z$ to $z + \Delta z$, then the input voltage to the error amplifier changes by $\Delta\upsilon$, where $\Delta\upsilon$ are given by

$$\Delta v = d\,\Delta z. \tag{75}$$

Let $L$ be the gain of the error amplifier, then the output voltage of the error amplifier varies by $-L\Delta\upsilon$ ($= -Ld\Delta z$). Consequently, the frequency outputted by the VCO changes by $\Delta\phi$, where $\Delta\phi$ is expressed by

$$\Delta \phi = k\,L\,d\,\Delta z. \tag{76}$$

Then, from the expression 56, the virtual resonance circuit shifts the output in amplitude by

$$-\frac{r\,\phi}{(\phi^2 + \delta^2)^{3/2}}\,\Delta \phi = -\frac{r\,\phi\,k\,L\,d\,\Delta z}{(\phi^2 + \delta^2)^{3/2}}. \tag{77}$$

As a result, the virtual rectification circuit changes the output by

$$-\frac{r\,\phi\,\nu\,k\,L\,d\,\Delta z}{(\phi^2 + \delta^2)^{3/2}}. \tag{78}$$

Therefore, the loop gain is given by

$$\frac{r\,\phi\,\nu\,k\,L\,d}{(\phi^2 + \delta^2)^{3/2}}. \tag{79}$$

Suppose that $A$ is the gain of the error amplifier at a direct-current level. Let $N$ be defined by

$$N = r\,\nu\,k\,A\,d. \tag{80}$$

Then the loop gain can be expressed by

$$\frac{N\,\phi}{(\phi^2 + \delta^2)^{3/2}}. \tag{81}$$

The stabilized direct-current voltage power supply implements a large loop gain from the viewpoint that the large loop gain contributes improving stability of the output voltage.

**Neighborhood of δ**

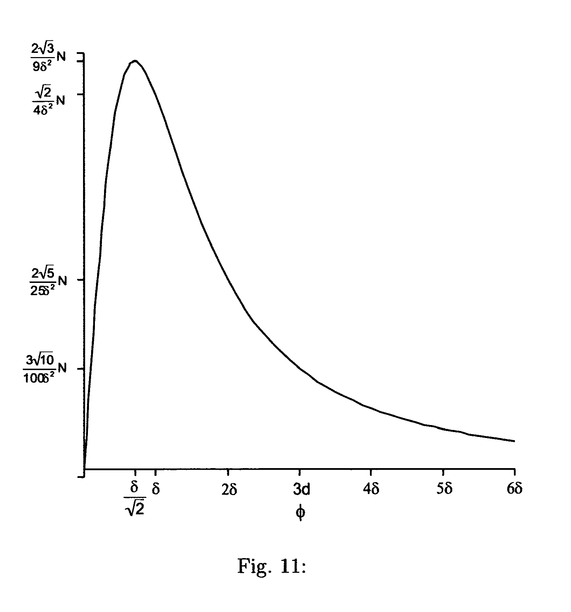

Fig.11 shows the plot of the loop gain against $\phi$. The loop gain attains the maximum at $\phi = \delta/\sqrt{2}$ and reduces to one third of the maximum at $\phi = 3\delta$. For later convenience, the neighborhood of δ is defined in the domain of $\phi$ by the interval of $\phi$ between $[\delta/\sqrt{2},\ 3\,\delta]$. Then, from the definition, the following expression holds in the neighborhood of δ.

$$\frac{N\,\phi}{(\phi^2 + \delta^2)^{3/2}} \gg 1. \tag{82}$$

**Load of Equivalent Power Supply**

At the resonance, δ depends on the load. The load of the equivalent power supply is reflected in δ of the resonance shown by the virtual resonance circuit. When the load becomes heavier, the Q-value of the resonance circuit reduces and then δ increases. Contrarily the load becomes lighter, the Q-value increases and then δ decreases. Load $L$ is identified with $\delta_L$ of the resonance shown by the virtual resonance circuit. Stability of the power supply connected to load $L$ is analyzed in terms of the equivalent power supply where δ of the virtual resonance circuit corresponds to load $L$.

**Stability of Smart Power Supply**

A smart error amplifier is the error amplifier the transfer function of which is defined with positive numbers $E$, $A$, and $B$ by

$$\frac{E + A\,s + B\,s^2}{s}. \tag{83}$$

The smart error amplifier is provided with a pole located at the origin. The equivalent power supply with the smart error amplifier is a smart power supply. Hereafter the stability of the smart power supply is investigated. In the smart power supply, the output voltage is fed back to the frequency of the carrier driving the virtual resonance circuit. In order to investigate the stability, it is examined how the feedback develops an imaginary change of the output voltage in process of time. The feedback is stable if the change reduces with the progress of time, and the feedback is unstable if the change grows with the passage of time. Since the imaginary change is so subtle, it can be safely assumed that $\mu$ and $\nu$ are considered to be constant during the change.

**Example of Smart Power Supply And System of Differential Equations**

The error amplifier is composed of the subtraction circuit and the phase compensation circuit. The subtraction circuit is comprised of the divider resistors and an amplifier, where the amplifier outputs the voltage difference to the phase compensation circuit. The phase compensation circuit ,consisting of an amplifier and its branch circuit, generates the output of the error amplifier.

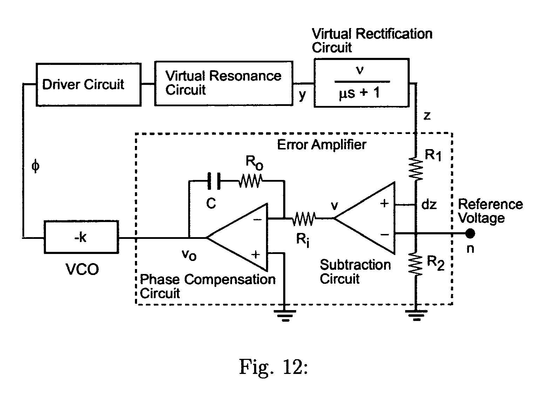

Since the amplifiers operate fast enough compared with the virtual resonance and the virtual rectification circuits, the delay of the error amplifier is safely assumed to be caused by the phase-compensation circuit. Fig. 12 shows an example of the smart power supply. Let $y$ be the output of the virtual resonance circuit and $z$ be output of the virtual rectification circuit of the power supply as shown in Fig. 12, then

$$y = \sqrt{p^2 + q^2}, \tag{84}$$

$$\mu \frac{d}{dt} z + z = \nu \sqrt{p^2 + q^2}. \tag{85}$$

Voltage $dz$, the division of $z$ by the divider resistors, and the reference voltage $n$ are supplied to the subtraction circuit, where d is the ratio of the divider resistors. Then

$$d = \frac{R_2}{R_1 + R_2}, \tag{86}$$

$$v = (d\,z - n), \tag{87}$$

where $v$ is the input to the phase-compensation circuit. Let $v_0$ be the output of the phase-compensation circuit, then $v$ and $v_0$ are related with

$$-v_o = \frac{1 + R_o\,C\,s}{R_i\,C\,s}\,v, \tag{88}$$

which can be rewritten as

$$-\frac{d}{dt} v_o = E\,v + A \frac{d}{dt} v \tag{89}$$

where $A$ and $E$ are defined by

$$E = \frac{1}{R_i C}, \tag{90}$$

$$A = \frac{R_o}{R_i}, \tag{91}$$

From expression 85,

$$\frac{d}{dt}z = \frac{-z + \nu\sqrt{p^2 + q^2}}{\mu} \tag{92}$$

then

$$-\frac{d}{dt}v_o = E(dz - n) + \frac{Ad\left(-z + \nu\sqrt{p^2 + q^2}\right)}{\mu} \tag{93}$$

$$= Ed\left(z - \frac{n}{d}\right) + \frac{Ad\left(-z + \nu\sqrt{p^2 + q^2}\right)}{\mu}. \tag{94}$$

Applying expression 94 to expression 6 leads to

$$\frac{d}{dt}\phi = kEd(z - \lambda) + \frac{kAd\left(-z + \nu\sqrt{p^2 + q^2}\right)}{\mu}, \tag{95}$$

$$\lambda = \frac{n}{d}. \tag{96}$$

The smart power supply can be described by the following system of differential equations.

$$\frac{d}{dt}p = q\phi - p\delta + r_r, \tag{97}$$

$$\frac{d}{dt}q = -p\phi - q\delta + r_i, \tag{98}$$

$$\frac{d}{dt}z = \frac{-z + \nu\sqrt{p^2 + q^2}}{\mu}, \tag{99}$$

$$\frac{d}{dt}\phi = kEd(z - \lambda) + \frac{kAd\left(-z + \nu\sqrt{p^2 + q^2}\right)}{\mu}. \tag{100}$$

**Smart Power Supply And System of Differential Equations**

The transfer function of the virtual rectification circuit is defined by

$$\frac{\nu}{\mu s + 1}. \tag{101}$$

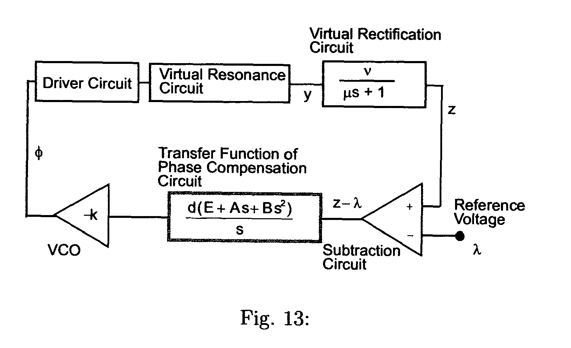

Then Fig. 13 shows the block diagram of the smart power supply where the feedback circuit is provided with zeros compensating the delay caused by the virtual resonance and the virtual rectification circuits. The stability of feedback is investigated about the smart power supply. The error amplifier consists of the subtraction circuit and the phase-compensation circuit as is shown in Fig. 13.

**Driving Frequency is Higher Than Resonance Frequency**

Let frequency of the carrier driving the virtual resonance circuit be higher than the resonance frequency, that is $\phi > 0$, then the transfer function of the phase-compensation circuit is written as

$$\phi = k \, d \frac{(E + A \, s + B \, s^2)}{s} (z - \lambda). \tag{102}$$

where $E$, $A$ and $B$ are positive constants. From expression 92,

$$\frac{d}{dt} z = \frac{-z + \nu \sqrt{p^2 + q^2}}{\mu}. \tag{103}$$

Then the second derivative of $z$ is calculated by using expression 47 and expression 48 as follows:

$$\frac{d^2}{dt^2} z = \frac{1}{\mu} \left( -\frac{d}{dt} z + 1/2 \frac{\nu \left( 2 p(t) \frac{d}{dt} p + 2 q(t) \frac{d}{dt} q \right)}{\sqrt{(p(t))^2 + (q(t))^2}} \right) \tag{104}$$

$$= -\frac{\sqrt{p^2 + q^2} (\nu + \nu \mu \delta)}{\mu^2} + \frac{z}{\mu^2} + \frac{\nu (q \, r_i + p \, r_r)}{\mu \sqrt{p^2 + q^2}}. \tag{105}$$

As a result, the smart power supply can be described by the following system of differential equations.

$$\frac{d}{dt} p = q\phi - p\delta + r_r, \tag{106}$$

$$\frac{d}{dt} q = -p\phi - q\delta + r_i, \tag{107}$$

$$\frac{d}{dt} z = \frac{-z + \nu \sqrt{p^2 + q^2}}{\mu} \tag{108}$$

$$\frac{d}{dt}\phi = kEd(z-\lambda) + \frac{kAd\left(-z + \nu \sqrt{p^2 + q^2}\right)}{\mu}$$

$$+ kBd\left(-\frac{\sqrt{p^2 + q^2}(\nu + \nu \mu \delta)}{\mu^2} + \frac{z}{\mu^2} + \frac{\nu(q r_i + p r_r)}{\sqrt{p^2 + q^2}\mu}\right), \tag{109}$$

## Stability Around Equilibrium Point

As for the system of differential equations composed of expressions from 106 to 109, an equilibrium point is defined by the solution of the following system of equations concerning $p$, $q$, $z$, $\lambda$ and $\phi$.

$$0 = q\phi - p\delta + r_r, \tag{110}$$

$$0 = -p\phi - q\delta + r_i, \tag{111}$$

$$0 = \frac{-z + \nu \sqrt{p^2 + q^2}}{\mu}, \tag{112}$$

$$0 = kEd(z-\lambda) + \frac{kAd\left(-z + \nu \sqrt{p^2 + q^2}\right)}{\mu}$$

$$+ kBd\left(-\frac{\sqrt{p^2 + q^2}(\nu + \nu \mu \delta)}{\mu^2} + \frac{z}{\mu^2} + \frac{\nu(q r_i + p r_r)}{\sqrt{p^2 + q^2}\mu}\right). \tag{113}$$

At the equilibrium point, the following equations hold.

$$\frac{d}{dt}p = 0. \quad \frac{d}{dt}q = 0, \quad \frac{d}{dt}z = 0, \quad \frac{d}{dt}\phi = 0. \tag{114}$$

Then the equilibrium point is defined by the following system of linear equations.

$$q\phi - p\delta + r_r = 0, \tag{115}$$

$$-p\phi - q\delta + r_i = 0, \tag{116}$$

$$\nu \sqrt{p^2 + q^2} - z = 0, \tag{117}$$

$$z - \lambda = 0. \tag{118}$$

Simultaneous equations of expressions from 115 to 117 are solved to $p$, q, and $z$ expressed in terms of $\phi$, which

are substituted in expression 113 to lead to expression 118. Let the equilibrium point of the solution be $p_e$, $q_e$, $z_e$, then $p_e$, $q_e$, $z_e$ and $\lambda_e$ is expressed by $\phi_e$ as follows:

$$p_e \;=\; \frac{\phi_e r_i + \delta r_r}{\phi_e{}^2 + \delta^2}, \tag{119}$$

$$q_e \;=\; -\frac{-\delta r_i + r_r \phi_e}{\phi_e{}^2 + \delta^2}, \tag{120}$$

$$z_e \;=\; \nu \sqrt{\frac{r_i{}^2 + r_r{}^2}{\phi_e{}^2 + \delta^2}}, \tag{121}$$

$$\lambda \;=\; \nu \sqrt{\frac{r_i{}^2 + r_r{}^2}{\phi_e{}^2 + \delta^2}}. \tag{122}$$

The stability of the system of differential equations around the equilibrium point is analyzed with a Lyapunov method. Let $p$, $q$, $z$ and $\phi$ be developed around the equilibrium point as follows:

$$p \;=\; p_e + \Delta p, \tag{123}$$

$$q \;=\; q_e + \Delta q, \tag{124}$$

$$z \;=\; z_e + \Delta z, \tag{125}$$

$$\phi \;=\; \phi_e + \Delta \phi. \tag{126}$$

The above equations are substituted in expressions from 106 to 109 and terms of higher order about $\Delta$ are ignored, which leads to a differential equation system concerning $\Delta p$, $\Delta q$, $\Delta z$ and $\Delta \phi$ as is shown in a matrix form in the following.

$$\frac{d}{dt} \begin{bmatrix} \Delta p \\ \Delta q \\ \Delta z \\ \Delta \phi \end{bmatrix} = M \begin{bmatrix} \Delta p \\ \Delta q \\ \Delta z \\ \Delta \phi \end{bmatrix} \tag{127}$$

Matrix $M$ is given by

$$M = \begin{bmatrix} -\delta & \phi_e & 0 & q_e \\ -\phi_e & -\delta & 0 & -p_e \\ \dfrac{\nu\, p_e}{\sqrt{p_e{}^2 + q_e{}^2}\mu} & \dfrac{\nu\, q_e}{\sqrt{p_e{}^2 + q_e{}^2}\mu} & -\mu^{-1} & 0 \\ M_{41} & M_{42} & kEd - \dfrac{kAd}{\mu} + \dfrac{kBd}{\mu^2} & 0 \end{bmatrix} \qquad (128)$$

where

$$M_{41} = \frac{kAd\nu\, p_e}{\sqrt{p_e{}^2 + q_e{}^2}\mu} + kBd\left(-\frac{(\nu + \nu\mu\delta)\, p_e}{\sqrt{p_e{}^2 + q_e{}^2}\mu^2} + \frac{\nu\, r_r}{\sqrt{p_e{}^2 + q_e{}^2}\mu} - \frac{\nu\,(q_e r_i + p_e r_r)\, p_e}{\mu\,(p_e{}^2 + q_e{}^2)^{3/2}}\right) \qquad (129)$$

$$M_{42} = \frac{kAd\nu\, q_e}{\sqrt{p_e{}^2 + q_e{}^2}\mu} + kBd\left(-\frac{(\nu + \nu\mu\delta)\, q_e}{\sqrt{p_e{}^2 + q_e{}^2}\mu^2} + \frac{\nu\, r_i}{\sqrt{p_e{}^2 + q_e{}^2}\mu} - \frac{\nu\,(q_e r_i + p_e r_r)\, q_e}{\mu\,(p_e{}^2 + q_e{}^2)^{3/2}}\right) \qquad (130)$$

Here elements of matrix $M$ are functions of $p_e$, $q_e$, $z_e$, and $\phi_e$, each of which is a function of $\phi_e$ as shown by expressions from 119 to 122. Therefore elements of $M$ are considered to be functions of $\phi_e$. Let $m(h)$ be a characteristic polynomial of matrix $M$ with coefficient $a_0$, $a_1$, $a_2$, $a_3$ as is shown in the following,

$$m(h) = a_0 h^4 + a_1 h^3 + a_2 h^2 + a_3 h + a_4. \qquad (131)$$

Coefficients $a_0$, $a_1$, $a_2$, $a_3$ and $a_4$ are functions of $\phi_e$ as follows:

$$a_0 = 1, \qquad (132)$$

$$a_1 = \frac{2\mu\delta + 1}{\mu}, \qquad (133)$$

$$a_2 = \frac{2\sqrt{\phi_e{}^2 + \delta^2}\,\delta + kd\nu B\phi_e r + \mu\left(\phi_e{}^2 + \delta^2\right)^{3/2}}{\sqrt{\phi_e{}^2 + \delta^2}\,\mu}, \qquad (134)$$

$$a_3 = \frac{\phi_e kd\nu Ar + \left(\phi_e{}^2 + \delta^2\right)^{3/2}}{\sqrt{\phi_e{}^2 + \delta^2}\,\mu}, \qquad (135)$$

$$a_4 = \frac{\phi_e kd\nu\, Er}{\sqrt{\phi_e{}^2 + \delta^2 \mu}}. \tag{136}$$

where r is defined by

$$r = \sqrt{r_r{}^2 + r_i{}^2}. \tag{137}$$

**Driving Frequency is Lower Than Resonance Frequency**

Let the frequency of the carrier driving the virtual resonance circuit be lower than the resonance frequency, that is $\phi < 0$, then, by replacing $\phi$ with $-\phi$, the transfer function of the phase-compensation circuit is given in the following, where the driving frequency moves away from the resonance frequency while the output voltage is higher than the reference voltage.

$$\phi = k\,d\frac{(E + A\,s + B\,s^2)}{s}(z - \lambda) \tag{138}$$

which is same with expression 102. Replacing $\phi$ with $-\phi$ modify expressions 106 and 107 to

$$\frac{d}{dt}p = -q\phi - p\delta + r_r, \tag{139}$$

$$\frac{d}{dt}q = p\phi - q\delta + r_i. \tag{140}$$

The second derivative of $z$ is obtained by differentiating expression 103 with substitution of expression 139 and expression 140. Then the second derivative of $z$ does not include $\phi$ as

$$\frac{d^2}{dt^2}z = -\frac{\sqrt{p^2 + q^2}\,(\nu + \nu\,\mu\,\delta)}{\mu^2} + \frac{z}{\mu^2} + \frac{\nu\,(q\,r_i + p\,r_r)}{\mu\,\sqrt{p^2 + q^2}} \tag{141}$$

which is same with expression 105.

The driving frequency being lower than the resonance frequency, the smart power supply assuming $\phi > 0$ is found to be described by

$$\frac{d}{dt}p = -q\phi - p\delta + r_r, \tag{142}$$

$$\frac{d}{dt}q = p\phi - q\delta + r_i, \tag{143}$$

$$\frac{d}{dt}z = \frac{-z + \nu \sqrt{p^2 + q^2}}{\mu}, \tag{144}$$

$$\frac{d}{dt}\phi = kEd(z - \lambda) + \frac{kAd\left(-z + \nu \sqrt{p^2 + q^2}\right)}{\mu}$$
$$+ kBd\left(-\frac{\sqrt{p^2 + q^2}(\nu + \nu\mu\delta)}{\mu^2} + \frac{z}{\mu^2} + \frac{\nu(qr_i + pr_r)}{\sqrt{p^2 + q^2}\mu}\right), \tag{145}$$

The equilibrium point is identified with $p_e$, $q_e$, $z_e$, $\phi_e$ which are expressed as functions of $\phi_e$ by

$$p_e = \frac{-\phi_e r_i + \delta r_r}{\phi_e^2 + \delta^2}, \tag{146}$$

$$q_e = \frac{\delta r_i + r_r \phi_e}{\phi_e^2 + \delta^2}, \tag{147}$$

$$z_e = \nu \sqrt{\frac{r_i^2 + r_r^2}{\phi_e^2 + \delta^2}}, \tag{148}$$

$$\lambda = \nu \sqrt{\frac{r_i^2 + r_r^2}{\phi_e^2 + \delta^2}}. \tag{149}$$

Let $m(h)$ be a characteristic polynomial of the differential equation system derived by linearization from the system of differential equations around the equilibrium point, then $m(h)$ is expressed by

$$m(h) = a_0 h^4 + a_1 h^3 + a_2 h^2 + a_3 h + a_4 \tag{150}$$

with coefficients $a_0$, $a_1$, $a_2$ $a_3$ and $a_4$. Then, with $r$ defined by

$$r = \sqrt{r_r^2 + r_i^2}, \tag{151}$$

coefficients $a_0$, $a_1$, $a_2$ $a_3$ and $a_4$ are given again by expressions from 132 to 136. Then regardless of whether the driving frequency is higher or lower than the resonance frequency, coefficients $a_0$, $a_1$, $a_2$ $a_3$ and $a_4$ are given on the assumption that $\phi > 0$ by expressions from 132 to 136.

**Redefinition of Characteristic Polynomial**

Since $k$, $d$, $\nu$, and $r$ are included simultaneously in a single term together with $A$, $B$, or $E$ in expressions from 132 to 136, $N$, $B'$ and $E'$ are introduced with

$$k\,d\,\nu\,r\,A = N \tag{152}$$

and

$$k \, dv \, r \, B = B' N, \tag{153}$$

$$k \, dv \, r \, E = E' N. \tag{154}$$

Namely $B'$ and $E'$ are defined with $A$ by

$$B' = \frac{B}{A}, \tag{155}$$

$$E' = \frac{E}{A}. \tag{156}$$

Furthermore $E'$ and $B'$ are replaced again with $E$ and $B$, then coefficients $a_0$, $a_1$, $a_2$ $a_3$ and $a_4$ are functions of $\phi_e$ as given by

$$a_0 = 1, \tag{157}$$

$$a_1 = \frac{2\mu\delta + 1}{\mu}, \tag{158}$$

$$a_2 = \frac{2\sqrt{\phi_e^2 + \delta^2}\,\delta + B\phi_e N + \mu\left(\phi_e^2 + \delta^2\right)^{3/2}}{\sqrt{\phi_e^2 + \delta^2}\,\mu}, \tag{159}$$

$$a_3 = \frac{\phi_e N + \left(\phi_e^2 + \delta^2\right)^{3/2}}{\sqrt{\phi_e^2 + \delta^2}\,\mu}, \tag{160}$$

$$a_4 = \frac{E\phi_e N}{\sqrt{\phi_e^2 + \delta^2}\,\mu}. \tag{161}$$

The characteristic polynomial $m(h)$ defined in expression 131 is redefined in terms of coefficient $a_0$, $a_1$, $a_2$, $a_3$ and $a_4$, given by expressions from 157 to 161, by

$$m(h) = a_0 h^4 + a_1 h^3 + a_2 h^2 + a_3 h + a_4 \tag{162}$$

**Roots of Characteristic Polynomial**

In the system of differential equations that describes the smart power supply, the output voltage near the reference voltage, that is, the behavior of the output voltage near the equilibrium point is given by the pole of the system of differential equations. Poles of the system of differential equations defined by expressions from 142 to 144 are given by roots of the characteristic polynomial defined by expression 162.

The stability of the feedback is decided with the root of a characteristic polynomial. That all the roots of the characteristic polynomial have negative real parts is necessary and sufficient condition that the system of differential equations is stabilized in the sense of Lyapunov. It is necessary condition to be satisfied by a power supply that the system of differential equations describing the power supply is stable in the sense of Lyapunov. Yet stability in the sense of Lyapunov is not enough for the stability of the power supply. For instance, there exists the case where the power supply stable in the sense of Lyapunov oscillates the output voltage. There are also the cases where the output voltage oscillates in the neighborhood of the voltage set by the reference voltage and the case where the oscillation decays in a long time

Preferable characteristics of the power supply are achieved by arranging roots of the characteristic polynomial appropriately. The desired characteristics are achieved by choosing the value of $E$, $B$, and $N$ according to the value of $\delta$, $\mu$, and $\nu$ of the power supply, and realizing the appropriate arrangement of roots. The root whose real part is least in absolute value among the roots of the characteristic polynomial is called a dominant root. The real part of the dominant root is nearest to the origin among the roots. The output voltage of the power supply stabilized by feedback strongly depends on the dominant root in characteristics. That the dominant root is a real root separated from imaginary roots provides the desired characteristics of the power supply. The condition that the dominant root is the real root separated from imaginary roots is searched for under practical assumption in the following.

### Resolution of Characteristic Function $m(h)$

Characteristic polynomial $m(h)$ can be written as

$$m(h) = \frac{\left((h+\delta)^2 + \phi^2\right) h \left(\mu h + 1\right)}{\mu} + \frac{\phi \left(h^2 B + h + E\right) N}{\sqrt{\phi^2 + \delta^2}\,\mu}.\qquad(163)$$

The second term in the right of expression 163 is corresponding to the numerator of the transfer function provided by the feedback circuit. Then it can be seen that the second term is the contribution of the feedback circuit. The first term, which is independent of the transfer function of the feedback circuit, is understood to be the contribution of the voltage generation circuit. The pole of the transfer function located at the origin is corresponding to $h$ in the numerator of the first term. Expression $(\mu h + 1)$ in the first term shows the time constant of the delay is $1/\mu$, corresponding to the virtual rectification circuit. Expression $((x+\delta)^2 + \phi^2)$ in the first term is the contribution of the virtual resonance circuit.

It is assumed that $F_w$ is the transfer function of the virtual voltage generation circuit and that $B_w$ is the transfer function of the feedback circuit. Without discriminating $F_w$ and $B_w$ from $C F_w$ and $1/C B_w$ for common constant $C$, $F_w$ is given from expression 163 by

$$F_w = \frac{N\phi}{\sqrt{\phi^2 + \delta^2}\,(\mu h + 1)\left((h+\delta)^2 + \phi^2\right)}\qquad(164)$$

Similarly, $B_w$ is

$$B_w = \frac{B h^2 + h + E}{h}\qquad(165)$$

Then closed loop transfer function $F_w/(1 + F_w B_w)$ is given by

$$\frac{F_w}{1 + F_w\, B_w} = \frac{N\,\phi}{\mu\,\sqrt{\phi^2 + \delta^2}} \tag{166}$$

$$\times \left( \frac{(\mu\, h + 1)\left((h + \delta)^2 + \phi^2\right)}{\mu} + \frac{N\,\phi\,(B h^2 + h + E)}{h\,\mu\,\sqrt{\phi^2 + \delta^2}} \right)^{-1}$$

Then characteristic polynomial $m(h)$ coincides with the denominator of closed loop transfer function $F_w/(1 + F_w B_w)$ except for multiplication by a constant.

From expression 163, $m(h)$ at $\phi = 0$ is

$$m(h) = \frac{h\,(h + \delta)^2\,(\mu\, h + 1)}{\mu} \tag{167}$$

Similarly, $m(h)$ at $h = -1/\mu$ is

$$m(-\frac{1}{\mu}) = \frac{\phi\, N\,(E\mu^2 - \mu + B)}{\sqrt{\phi^2 + \delta^2}\,\mu^3} \tag{168}$$

**Introduction of Pole Located Near Origin by Feedback**

A smart power supply is described by a system of differential equations, and a characteristic polynomial is derived from the system of differential equations. A smart power supply is composed of the virtual voltage generation circuit and the feedback circuit. In a word, the characteristic polynomial depends on the transfer function of the virtual voltage generation circuit and the transfer function of the feedback circuit. The virtual voltage generation circuit contains the pole that is created by the virtual rectification circuit. The pole corresponds to the delay of the virtual rectification circuit is located in a low frequency.

In the smart power supply, introducing the pole located at the origin appropriately into the feedback circuit creates the real roots locating in the neighborhood of the origin, moving other real roots of the characteristic polynomial to a higher frequency at the same time. As a result, response that can be approximated by a first order delay can be extended in the frequency range from the pole created near the origin to the pole moved to the higher frequency.

The root corresponding to the delay of the virtual rectification circuit can be moved to a higher frequency by increasing $N$, where $N$ corresponds to the loop gain. The movement tends to move roots to a lower frequency except for both of the root near the origin and the root corresponding to the delay of the virtual rectification circuit. It is necessary to choose $E$, $B$, and $N$ appropriately according to parameters of the power supply to extend the range of frequency where response can be approximated by a first order delay.

**Two Functions**

Functions $f_1(h)$ and $f_2(h)$ are defined from the representation of $h(s)$ given at expression 163 as follows:

$$f_1(h) = \frac{\left((h + \delta)^2 + \phi^2\right) h\,(\mu\, h + 1)}{\mu} \tag{169}$$

$$f_2(h) = -\frac{\phi\,(h^2 B + h + E)\,N}{\sqrt{\phi^2 + \delta^2}\,\mu}. \tag{170}$$

Then characteristic polynomial $h(s)$ is written as

$$m(h) = f_1(h) - f_2(h). \tag{171}$$

**Function $f_1(h)$**

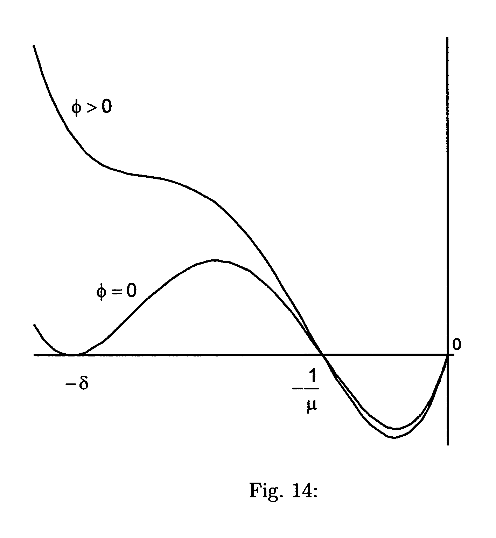

The graph of the function $y = f_1(h)$ intersects from expression 163 with the h axis at the origin and $-1/\mu$. Since $-\delta \ll -1/\mu$, $y$ is positive in $h < -1/\mu$. Fig. 14 shows the graph of $y = f_1(h)$

**Graph of Function $y = f_2(h)$**

The graph of the function $y = f_2(h)$ is a convex curve in an upward direction of secondary degree and depends on $\phi$ and $N$. Here it is investigated that equation $m(h) = 0$ includes the root close to the origin regardless of $\phi$ and $N$. In the case that the graph $y = f_2(h)$ does not intersect with the h axis, it becomes impossible that graph $y = f_1(h)$ and graph $y = f_2(h)$ have intersection near origin as $\phi$ or $N$ increase, because graph $y = f_2(h)$ moves in the direction of $-y$ with the increase of $\phi$ or $N$.

In the case that graph $y = f_2(h)$ intersects with the h-axis, roots of $f_2(h) = 0$ are real and negative from the definition of $f_2(h)$. Let a real root with the smaller absolute value be $h_a$ and the other root be $h_b$. Graph $y = f_2(h)$ passes the h axis at $h_a$ and $h_b$ independently of $\phi$ and $N$. Let $h_a$ satisfy $-1/\mu < h_a$, then $m(h) = 0$ has a real root near the origin regardless of $\phi$ and $N$. In addition in the case that $h_b$ satisfies $h_b < -1/\mu$, then root $-1/\mu$, corresponding to the delay of the virtual rectification circuit, is moved to a higher frequency.

In the case that real roots $h_a$ and $h_b$ are both in the range of $-1/\mu \leq h < 0$, $m(h) = 0$ has two real roots within the range of $-1/\mu \leq h < 0$, $m(h) = 0$.

In the case that neither real root $h_a$ nor $h_b$ is in the range of $-1/\mu \leq h < 0$ on the h axis, $m(h) = 0$ cannot have a real root near the origin.

In the case that $h_a$ satisfies $-1/\mu \leq h_a < 0$ and that $h_b$ satisfies $h_b < -1/\mu$, root $-1/\mu$ corresponding to the delay of the virtual rectification circuit is moved to a higher frequency. Necessary and sufficient condition that graph $y = f_2(h)$ has one intersection within $-1/\mu \leq h < 0$ on the h axis is to satisfy the following expressions at the same time.

$$f_2\left(-\frac{1}{\mu}\right) > 0, \tag{172}$$

$$f_2(0) < 0. \tag{173}$$

Then expression 173 is automatically satisfied by $E > 0$. Expression 172 leads to

$$E\mu^2 - \mu + B < 0 \tag{174}$$

which gives

$$m\left(-\frac{1}{\mu}\right) < 0. \tag{175}$$

From the above expression and $m(0) > 0$, it can be seen that $m(h) = 0$ has a real root within $-1/\mu \leq h < 0$. That graph $y = f_2(h)$ has one real root within $-1/\mu < h < 0$ on the h axis requires from expression 174 the following expression to be satisfied.

$$E < \frac{1}{\mu}. \qquad (176)$$

From that equation $f_2(h) = 0$ has two different real roots, it is necessary to satisfy

$$1 - 4BE > 0. \qquad (177)$$

**Intersection Between Graphs** $y = f_1(h)$ and $y = f_2(h)$

For the stability of feedback in the sense of Lyapunov, it is necessary and sufficient that a real part of all the roots of the characteristic polynomial is negative. On the assumption that expression 174 holds and that $m(h) = 0$ has a real root within $-1/\mu \leq h < 0$, the condition that a real part of all the roots of the characteristic polynomial becomes negative is studied.

Since the characteristic polynomial has a real root, there are two cases; the polynomial has four real roots in one case, and two real roots and two imaginary roots in the other case. Since the characteristic polynomial satisfies $m(h) > 0$ for h > 0, all the roots are negative in the case that $m(h) = 0$ has four real roots, and then stability in the sense of Lyapunov is attained.

In the case that the characteristic polynomial has two imaginary roots $h_3$ and $h_4$ besides two real roots $h_1$ and $h_2$, imaginary roots $h_3$ and $h_4$ have a common real part $h_r$. Then real roots $h_1$ and $h_2$ are related with $h_a$ and $h_b$, which are defined previously to be the intersections of graph $y = f_2(h)$ with the h axis, as follows:

$$h_b < h_2 < h_a < h_1 < 0. \qquad (178)$$

The relation between roots and coefficients of the polynomial shows

$$h_1 + h_2 + h_3 + h_4 \;\; = \;\; -a_1 \sim -2\delta \qquad (179)$$

$$, h_3 + h_4 \;\; = \;\; 2h_r, \qquad (180)$$

which lead to

$$h_1 + h_2 + 2h_r = -a_1 \sim -2\delta. \qquad (181)$$

Then it becomes possible to make a rough valuation of a real part about the imaginary roots from the estimation of the real roots.

From expression 181, necessary and sufficient condition that $h_r$ is negative is to satisfy

$$-a_1 < h_1 + h_2. \qquad (182)$$

Sufficient condition of expression 182 can be written in various expressions.

For instance, in the case that

$$f_2(-\delta) < 0 \qquad (183)$$

holds then

$$-\delta < h_b < h_2. \qquad (184)$$

Since $h_1$ is located near the origin, then

$$h_r \sim -\frac{\delta}{2} \qquad (185)$$

hold, from which it can be understood that $h_1$ stands closest to the origin following $h_2$ and $h_r$ back and forth in sequence on the h axis.

Similarly, in the case that

$$f_2(-\frac{\delta}{2}) < 0 \qquad (186)$$

holds, then

$$h_r \sim -\frac{3}{4}\delta. \qquad (187)$$

It can be understood that $h_1$ stands closest to the origin, following $h_2$ second and $h_r$ third on the h axis.

Since expression 183 can be rewritten to

$$B\delta^2 - \delta + E > 0, \qquad (188)$$

then

$$B > \frac{1}{\delta} \qquad (189)$$

is sufficient condition for expression 183.

**Restriction on _N_ by _B_**

As is seen from expression 181, in the case that $h_2$ is in the neighborhood of $-2\delta$, satisfying expression

$$-2\delta \le h_2, \qquad (190)$$

then

$$-2\delta - \frac{1}{\mu} \leq h_2 + h_1 \qquad (191)$$

holds. Hence the real part of the imaginary is in the neighborhood of the origin, satisfying

$$h_r \leq 0. \qquad (192)$$

Namely, as $h_2$ decreases toward $-2\delta$ on the h axis, $h_r$ moves from a negative side toward the origin. When $h_2$ reduces further beyond $-2\delta$, $h_r$ becomes positive exceeding the origin, and the feedback becomes unstable in the sense of Lyapunov.

In the case that $h_b$ is larger than $-2\delta$, then $h_2$ is larger than $-2\delta$ for an arbitrarily large $N$, and then $h_r$ does not becomes positive.

In the case that $h_b$ is enough smaller than $-2\delta$, $h_2$ may decrease beyond $-2\delta$ as $N$ grows enough large. In a word, it is understood that there is an upper bound in $N$ to achieve stable feedback when $h_b$ is smaller enough than $-2\delta$.

Function $f_2(h)$ is expressed as a function of h by

$$f_2(h) = \frac{\phi N}{\sqrt{\phi^2 + \delta^2}\mu} \left\{ -B\left(h + \frac{1}{2B}\right)^2 + \frac{1}{4B} - E \right\}. \qquad (193)$$

Since $h_a$ is located in the neighborhood of the origin, $h_b$ can be estimated to be

$$h_b \simeq -\frac{1}{B}. \qquad (194)$$

Then, as $B$ decreases, $h_b$ reduces beyond $-2\delta$. As a result, $N$ is confined by an upper bound for the feedback stable in the sense of Lyapunov if $B$ is smaller than $1/2\delta$

As a result, in the case that expression 174 or rather expression

$$E\mu^2 - \mu + B \leq 0 \qquad (195)$$

holds, if $B$ is enough large than $1/2\,\delta$ then feedback is stable regardless of $N$, while if $B$ is smaller than $1/2\delta$, $N$ is upper bounded for stable feedback.

**Characteristic Polynomial as Function of $\phi$**

From expression 163, the characteristic polynomial is expressed by

$$m(h) = \frac{\left((h+\delta)^2 + \phi^2\right)h(\mu h + 1)}{\mu} + \frac{(h^2 B + h + E)N\phi}{\sqrt{\phi^2 + \delta^2}\mu}. \qquad (196)$$

**Case of** $h \leq -1/\mu$ **and** $Bh^2 + h + E \geq 0$

As is seen from expression 196, the first term is positive for such $h$ that

$$h < -\frac{1}{\mu} \qquad (197)$$

and the second term is positive for such $h$ that satisfies

$$Bh^2 + h + E \geq 0. \qquad (198)$$

Then

$$m(h) > 0 \qquad (199)$$

holds regardless of $\phi$ in the case.
For instance, If $B < \mu$, then $Bh^2 + h + E = E$ holds at $h = -1/B$. Then

$$m(-\frac{1}{B}) > 0 \qquad (200)$$

holds independent of $\phi$.

**Case of** $h \leq -1/\mu$ **and** $Bh^2 + h + E < 0$

Characteristic polynomial m(h) depends on not only h but also $\phi$ as understood from expression 196. Let $E_h$ ($\phi$) represent $m(h)$ as a function of $\phi$ for a fixed $h$. In a word,

$$E_h(\phi) = m(h) \qquad (201)$$

Here $E_h(\phi)$ is differentiated with $\phi$ as follows:

$$\frac{d}{dx} E_h(x) = 2\frac{xh(\mu h + 1)}{\mu} + \frac{\delta^2 (h^2 B + h + E) N}{(x^2 + \delta^2)^{3/2} \mu}. \qquad (202)$$

It is assumed that

$$\left(\delta^2 \left(Bh^2 + h + E\right)\right) N < 0. \qquad (203)$$

Then the first order derivative of $E_h(x)$ at $x = 0$ is evaluated to be negative as

$$\left(\frac{d}{dx} E_h\right)(0) < 0. \tag{204}$$

It is clear for a large $x$ that

$$\left(\frac{d}{dx} E_h\right)(x) > 0. \tag{205}$$

Then there exits such $x$ that satisfies

$$\left(\frac{d}{dx} E_h\right)(x) = 0. \tag{206}$$

Here the second order derivative of $E_h(x)$ relative to $x$ is calculated as

$$\frac{d^2}{dx^2} E_\eta(x) = 2\frac{h(\mu h + 1)}{\mu} - 3\frac{\delta^2 x (h^2 B + h + E) N}{(x^2 + \delta^2)^{5/2}\mu}. \tag{207}$$

From the above expression and the assumption,

$$\left(\frac{d^2}{dx^2} E_h\right)(x) > 0 \tag{208}$$

for $x > 0$. Therefore, $E_h(x)$ is convex in a downward direction as a function of $x$. From expression 204 and expression 205, there exists an unique $x$ such as to satisfy expression 206. Let $\phi_h$ be such $x$ that satisfies expression 206, then function $E_h(x)$ becomes minimum at $x = \phi_h$. Therefore the derivative of $E_h(x)$ is zero at $x = \phi_h$. Then

$$0 = 2\phi_h\left(\phi_h^2 + \delta^2\right)^{3/2} h(\mu h + 1) + \delta^2\left(h^2 B + h + E\right) N. \tag{209}$$

Hence $N$ can be expressed in terms of $\phi h$ as

$$N = -2\frac{h(\mu h + 1)\phi_h\left(\phi_h^2 + \delta^2\right)^{3/2}}{\delta^2(h^2 B + h + E)}. \tag{210}$$

The minimum $E_h(\phi h)$ is calculated with expression 210 as

$$E_h(\phi_h) \;=\; \frac{\left(\delta^2\,(h+\delta)^2 - \phi_h{}^2\left(\delta^2 + 2\,\phi_h{}^2\right)\right)h\,(\mu\,h + 1)}{\delta^2\mu}. \tag{211}$$

Then in the case that $Bh^2 + h + E < 0$ at $h = -\delta$ or rather

$$B\,\delta^2 - \delta + E < 0 \tag{212}$$

holds, then due to $-\delta < -1/\mu$, it can be seen that

$$E_h(\phi_h) \le 0 \tag{213}$$

is true.

From expression 211, for such $h$ that satisfies

$$h + \delta \neq 0, \tag{214}$$

there exists $\phi_h$ satisfying $\phi_h > 0$ by which $E_h(\phi_h)$ becomes positive. For given $h$, the domain of $\phi_h$ where minimum $E_h(\phi_h)$ is positive can be shown in the following. Let $G_h$ be defined by

$$G_h = \{\, x \mid g_h(x) > 0 \,\}, \tag{215}$$

where $g_h(\phi)$ is defined by

$$g_h(\phi) \;\equiv\; \delta^2\,(h+\delta)^2 - \phi^2\left(\delta^2 + 2\,\phi^2\right). \tag{216}$$

The left-hand side of expression 216 is the term included by expression 211.

Let G be defined by

$$G = \left\{\, x \mid 0 \le x \le \frac{\delta}{\sqrt{2}} \,\right\}. \tag{217}$$

Function $g_h(x)$ is decreasing for $x$ such as $x > 0$. The value of $g_h(x)$ at $x = \delta/\sqrt{2}$ is calculated as

$$g_h\!\left(\frac{\delta}{\sqrt{2}}\right) = h\delta^2\,(2\,\delta + h). \tag{218}$$

Then, it is understood that in the case of $-2\delta \le h,$

$$G_h \subset G \qquad\qquad (219)$$

holds and that in the case of $h < -2\delta$,

$$G \subset G_h \qquad\qquad (220)$$

is true.

**Dependence of $\phi_h$ and $E_h(\phi_h)$ on $N$**

For given $\delta (> 0)$, function $ml(x)$ is defined in the domain of $x$ such as $x > 0$ by

$$ml(x) = x \left( x^2 + \delta^2 \right)^{3/2} . \qquad\qquad (221)$$

From the definition, $ml(0) = 0$ and $ml(x))$ increases to infinity monotonously as $x$ moves to infinity. Therefore, for any give $T$, there exists an unique $x$ satisfying

$$ml(x) = T. \qquad\qquad (222)$$

$N$ is a constant by definition and then independent of $h$. expression 210 is rewritten as

$$\phi_h \left( \phi_h{}^2 + \delta^2 \right)^{3/2} = -\frac{1}{2} \frac{\delta^2 \left( h^2 B + h + E \right) N}{h \left( \mu h + 1 \right)} \qquad\qquad (223)$$

Since $\delta$, $\mu$ are constants and $N$, $E$, $B$ are thought to be constants given beforehand at the right-hand side of expression 223, then the right-hand side of expression 223 is a function of h.
Expression 223 shows that there exists an unique $\phi_n$ for an arbitrary $h$ such as $h < -1/\mu$. Hence $\phi_h$ determined uniquely for an arbitrary $h$ in $h < -1/\mu$, makes correspondence between $h$ and $E_h(\phi_h)$. Let $F(h)$ be a function making $h$ correspond to $E_h(\phi_h)$ where $h$ is in $h < -1/\mu$. That is, $F(h)$ is defined in the domain satisfying

$$h \leq -\frac{1}{\mu}, \qquad\qquad (224)$$

$$B h^2 + h + E \leq 0, \qquad\qquad (225)$$

or rather

.

$$h_b < h \leq -\frac{1}{\mu} \qquad\qquad (226)$$

by correspondence

$$F : h \rightarrow E_h(\phi_h). \tag{227}$$

Function $F(h)$ is dependent on $N, E$, and $B$. Since the domain of $h$ such as $F(h) < 0$ expands as $N$ increases, and narrows as $N$ decreases, the domain satisfying $F(h) < 0$ can be controlled by $N$.

Since $h$ such as $F(h) > 0$ satisfies $m(h) > 0$ for arbitrary $\phi$, the characteristic polynomial $m(h)$ does not have roots regardless of $\phi$ in the domain of $h$ such as $F(h) > 0$.

**Estimation of Real Roots Near Origin**

From expression 174 and expression 177, That the feedback is stabilized necessitates following expressions to be satisfied simultaneously.

$$E\mu^2 - \mu + B \quad < \quad 0, \tag{228}$$

$$EB \quad < \quad \frac{1}{4}. \tag{229}$$

Moreover the feedback is stable regardless of $N$ in the case that

$$B > \frac{1}{\delta} \tag{230}$$

holds.

Ripples are superimposed in a practical circuit on the output voltage of the power supply. $N$ concerns the amplification of the ripples, and $B$ is related to the differentiation of the ripples. Since the ripples grows as the increase of $N$, $N$ is confined by the ripples in practical circuits. As a result, $B$ can be chosen without degrading the stability to be

$$B < \frac{1}{\delta} \tag{231}$$

Considering the ripples in practical circuits, it will be practical to select $E$ and $B$ to satisfy

$$E \quad < \quad \frac{1}{\mu}, \tag{232}$$

$$B \quad \sim \quad \frac{1}{\delta}. \tag{233}$$

In the case of $E$ and $B$ satisfying expression 232 and expression 233, it can be understood that the characteristic polynomial $m(h)$ defined by expression 233 has a dominant real root near $-E$.

In other words, the smart power supply, the block diagram of which is shown in Fig 13, is provided with a enough loop gain and is implemented with a such phase compensation circuit defined by $E$ and $B$ satisfying expression 232 and expression 233 as

$$\frac{d\left(E + s + B\,s^2\right)}{s}, \qquad (234)$$

then the characteristic polynomial has a dominant real root near -$E$.

**Realization of Stable Feedback**

**Dominant Roots of Characteristic Polynomial**

Let $e_0$ be a real root near the origin, then $e_0$ is the dominant root, and then the rising curve of the output voltage is approximated in the course of time by

$$1 - exp(-e_0\,t) \qquad (235)$$

In a word, the time constant for the rise is $1/e_0$. Since $e_0$ is in the neighborhood of -$E$ in practical circuits, then the time constant for the rise is approximately $1/E$. As $E$ decrease, then -$e_0$ becomes smaller and similarly the increase of $E$ augments the -$e_0$ accordingly. As $E$ is made larger, then the rise of the output voltage becomes faster.
As $E$ is made larger further, then $E$ comes not to satisfy expression 174 or expression 177, which accompanies overshoots at the output voltage. The overshoots correspond to such dominant roots that come imaginary.

**Valuation of $B$**

For the stable feedback, $E$ and $B$ is required to satisfy both of expression 174 namely

$$E\,\mu^2 - \mu + B < 0, \qquad (236)$$

and expression 177 namely

$$E\,B < \frac{1}{4}. \qquad (237)$$

For instance, in the case that $E$ is selected to satisfy

$$E < \frac{1}{\mu}, \qquad (238)$$

it is understood that there is degree of freedom in how to select $B$. Since $B$ is related with $h_b$, satisfying expression 194 equivalently

$$h_b \simeq -\frac{1}{B}, \qquad (239)$$

then, $B$ confines the location of $h_2$ and consequently restricts $N$ from expression 178 namely

$$h_b < h_2 < h_a < h_1 < 0. \qquad (240)$$

Dependence of $h_b$ on $E$ and $B$ is described by function $F(h)$ defined by expression 227. That is, for such $h$ that satisfies both of

$$h_b < h \leq -\frac{1}{\mu}, \qquad (241)$$

and

$$F(h) > 0, \qquad (242)$$

then

$$m(h) > 0 \qquad (243)$$

holds for any $\phi$.

$F(h)$ depends on $E$, $B$, and $N$. The domain of $h$ such that $F(h) < 0$ is controlled by $N$. It becomes possible to evaluate the range of $h_2$ precisely by $F(h)$ plotted against $E$, $B$, and $N$.

**Ripples at Rectification Circuit**

$B$ and $N$ are restricted in practical circuits by the ripples superimposed on the output voltage of the power supply. The ripples are not superimposed to the output of the virtual rectification circuit in the equivalent power supply described by the differential equation system. However, high-frequency periodic ripples are superimposes to the output of an actual rectification circuit.

In the system of differential equations defined by expressions from 106 to 109, the ripples artificially superimposed on $z$, corresponding to the output voltage, causes oscillation on the output voltage around $z_e$ decided by equilibrium point $\phi_e$.

In an actual power supply, the rise of the output voltage is described by the system of differential equations defined by expressions from 106 to 109, while the output voltage falls independently of the system of differential equations. Therefore how the ripples superimposed on the output voltage effects the output voltage becomes complicate. In a word, periodic ripples cause oscillation of the output voltage, and it is difficult to go further.

Periodic ripples make the output voltage oscillate around voltage set by the reference voltage. The oscillation tends to increase in amplitude as the increase of the amplitude of the ripples and the augment of $N$. A large ripple superimposed on the output of the error amplifier may cause so-called breakdown of feedback where the driving frequency is lowered, moving beyond the resonance frequency. The breakdown of feedback caused by the ripple is not desirable for the power supply.

For a given $E$, the time constant of rising the output voltage can be approximated by $1/E$. By reducing the ripples outside the bandwidth where the feedback is effective, it becomes possible to implement a large direct-current loop gain. An effective circuit for reducing periodic ripples superimposed on the output voltage is proposed in patent document 2.

**Selection of Circuit Constants**

The stability of the output voltage against the change of load or the input voltage is improved in the case that the stabilization can be achieved with introducing the pole located at the origin. On the assumption of the following transfer function of the feedback circuit

$$\frac{E}{s} + 1 + B\,s, \qquad\qquad (244)$$

the practical sufficient condition that the feedback comes to stabilize was shown. As for the parameters describing the resonance circuit, there are the resonance frequency, the gain at the resonance frequency, and the half-value width of the resonance. To describe the process that the resonance circuit charged the rectification circuit, the time constant $\mu$ was introduced by approximating the rectification circuit to be a first order delay, and the multiplier $\nu$, which is dependent of both of the output impedance of the resonance circuit and the load connected to the output of the power supply, was brought in to specify multiplication of the output voltage at the rectification circuit.

Once the resonance circuit is fixed, $\delta$ can be roughly estimated from the amplitude ratio shown by the resonance circuit connected to the load. It is possible to estimate the time constant $\mu$ for charging the capacitance of the rectification circuit from the output impedance of the resonance circuit. The time constant $\mu$ charging the capacitance changes largely depending on the load. Let the maximum of $\mu$ be $\mu_{max}$, then select $E$ to be

$$E < \frac{1}{\mu_{max}}. \qquad\qquad (245)$$

High-frequency ripples are superimposed on output of the actual rectification circuit. The magnitude of $N$ is confined because $N$ is concerned with amplification of the ripples. It is preferable to select $B$ to be small in magnitude because $B$ is concerned with differentiation of the ripples, and then $B = 0$ is one of the alternatives. Selecting $B$ to be small confines $N$ from a viewpoint of stability. $N$ is limited in an actual circuit because of the amplification of the ripple, and $B$ is practically selected to satisfy

$$B \sim \frac{1}{\delta} \qquad\qquad (246)$$

In a word, a practical range for $B$ is roughly from one tenth to ten times $1/\delta$

Then the time constant for the rise of the output voltage is approximately $1/E$. The loop gain can be enlarged by filtering the ripples outside of the frequency bandwidth where the feedback works effective.

**Stability of Simple Power Supply**

The error amplifier is called simple if the transfer function of the error amplifier is given with positive $A$ and $B$ by

$$A + B\,s \qquad\qquad (247)$$

The transfer function of the simple error amplifier is not provided with the pole located at the origin. The equivalent power supply with the simple error amplifier is the simple power supply. Here the stability of the simple power supply is investigated. The output voltage of the virtual rectification circuit is fed back to the frequency of the carrier driving the virtual resonance circuit. In order to investigate the stability, how a subtle shift of the output voltage is developed by the feedback is examined.

**Example of Simple Power Supply and System of Differential Equations**

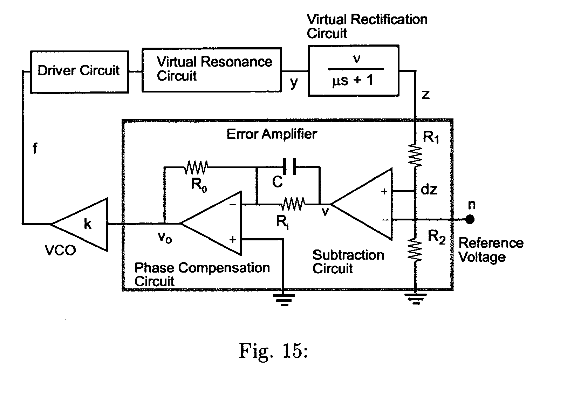

The error amplifier is composed of a subtraction circuit and a phase compensation circuit. The subtraction circuit consists of divider resistors and an amplifier, and the amplifier outputs the voltage difference between the input. The phase compensation is comprised of an amplifier and its branch circuit, and generates the output of the error amplifier. Since the amplifiers operate fast enough compared with the virtual resonance and the virtual rectification circuits, the delay of the error amplifier is safely assumed to be caused by the phase-compensation circuit. An example of the simple power supply is shown in Fig. 15. As for the power supply shown in Fig. 15, let $y$ be the output of the virtual resonance circuit and $z$ be the output of the virtual resonance circuit, then

$$y = \sqrt{p^2 + q^2}, \tag{248}$$

$$\mu \frac{d}{dt} z + z = \nu \sqrt{p^2 + q^2}. \tag{249}$$

Voltage $dz$, the division of $z$ by the divider resistors, and the reference voltage $n$ are supplied to the subtraction circuit, where $d$ is the ratio of the divider resistors. Let $v$ be the input to the phase compensation circuit, then

$$d = \frac{R_2}{R_1 + R_2}, \tag{250}$$

$$v = (dz - n). \tag{251}$$

Let $v_0$ be the output of the phase compensation circuit shown in Fig. 15, then $v$ is related to $v_0$, where $v$ is the input to the phase compensation circuit.

$$-v_o = \frac{1 + R_i C s}{R_i} R_o v. \tag{252}$$

The above expression can be rewritten to

$$-v_o = A v + B \frac{d}{dt} v \tag{253}$$

where

$$A = \frac{R_o}{R_i}, \tag{254}$$

$$B = R_o C. \tag{255}$$

Expression 85 leads to

$$\frac{d}{dt} z = \frac{-z + \nu \sqrt{p^2 + q^2}}{\mu}. \tag{256}$$

Then,

$$-v_o \;=\; A\,(dz - n) + \frac{B\,d\left(-z + \nu\,\sqrt{p^2 + q^2}\right)}{\mu} \tag{257}$$

$$\;=\; A\,d\left(z - \frac{n}{d}\right) + \frac{B\,d\left(-z + \nu\,\sqrt{p^2 + q^2}\right)}{\mu}. \tag{258}$$

Applying expression 5 to expression 258, then

$$\phi \;=\; k\,d\,A\,(z - \lambda) + \frac{k\,d\,B\left(-z + \nu\,\sqrt{p^2 + q^2}\right)}{\mu} + \phi_C, \tag{259}$$

$$\lambda \;=\; \frac{n}{d}. \tag{260}$$

Then $\phi$ in expression 259 is substituted in expressions 47 and 48, it is found that the simple power supply is described by the following system of differential equations.

$$\frac{d}{dt}p \;=\; \left\{ kdA\,(z - \lambda) + \frac{kdB\left(-z + \nu\,\sqrt{p^2 + q^2}\right)}{\mu} + \phi_C \right\} q - \delta\,p + r_r, \tag{261}$$

$$\frac{d}{dt}q \;=\; -\left\{ kdA\,(z - \lambda) + \frac{kdB\left(-z + \nu\,\sqrt{p^2 + q^2}\right)}{\mu} + \phi_C \right\} p - \delta\,q + r_i, \tag{262}$$

$$\frac{d}{dt}z \;=\; \frac{-z + \nu\,\sqrt{p^2 + q^2}}{\mu}. \tag{263}$$

**Simple Power Supply and System of Differential Equations**

The transfer function of the virtual rectification circuit is given with

$$\frac{\nu}{\mu\,s + 1} \tag{264}$$

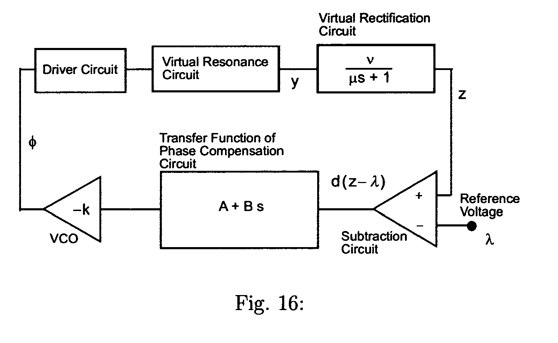

Then Fig. 16 shows the block diagram of the simple power supply where the zeros are considered so as to cancel the delay caused by the rectification circuit. The stability of the feedback is considered about the simple power supply. The error amplifier is composed of the subtraction circuit and the phase compensation circuit as shown in Fig. 16.

**Driving Frequency is Higher Than Resonance Frequency**

In the case that the frequency of the carrier driving the virtual resonance circuit is higher than the resonance frequency, that is $\phi > 0$, then the transfer function from the input of the phase compensation circuit to the output of the VCO can be written as follow:

$$\phi = k\,d\,(A + B\,s)(z - \lambda) + \phi_C \qquad (265)$$

where $A$ and $B$ are positive constants. Expression 265, being substituted by

$$\frac{d}{dt}z = \frac{-z + \nu\,\sqrt{p^2 + q^2}}{\mu}, \qquad (266)$$

leads to expression 259. Then the simple power supply is described by expressions 261, 262, and 263.

**Stability Near Equilibrium**

The system of differential equations composed of expressions from 261 to 263 satisfies at the equilibrium point expressions as

$$\frac{d}{dt}p = 0. \quad \frac{d}{dt}q = 0, \quad \frac{d}{dt}z = 0 \qquad (267)$$

Then the equilibrium point is the solution of the following system of linear equations.

$$0 \;=\; \left( kdA\,(z - \lambda) + \frac{kdB\left(-z + \nu\,\sqrt{p^2 + q^2}\right)}{\mu} + \phi_C \right) q - \delta p + r_r, \qquad (268)$$

$$0 \;=\; -\left( kdA\,(z - \lambda) + \frac{kdB\left(-z + \nu\,\sqrt{p^2 + q^2}\right)}{\mu} + \phi_C \right) p - \delta q + r_i, \qquad (269)$$

$$0 \;=\; \frac{-z + \nu\,\sqrt{p^2 + q^2}}{\mu}. \qquad (270)$$

The above system is simplified to the following system of liner equations.

$$(kdA\,(z - \lambda) + \phi_C)\,q - \delta p + r_r \;=\; 0, \qquad (271)$$

$$-(kdA\,(z - \lambda) + \phi_C)\,p - \delta q + r_i \;=\; 0, \qquad (272)$$

$$\nu\sqrt{p^2 + q^2} - z \;=\; 0, \qquad (273)$$

Then letting $\phi_e$ be defined by

$$\phi_e = kdA\,(z - \lambda) + \phi_C \qquad\qquad (274)$$

and solving the following system of linear equations, the equilibrium point composed of $p_e$, $q_e$, $z_e$ and $\lambda_e$ is given as functions of $\phi_e$.

$$\phi_e q - \delta\,p + r_r \;=\; 0, \qquad\qquad (275)$$

$$-\phi_e p - \delta\,q + r_i \;=\; 0, \qquad\qquad (276)$$

$$\nu\sqrt{p^2 + q^2} - z \;=\; 0, \qquad\qquad (277)$$

$$kdA\,(z - \lambda) + \phi_C \;=\; \phi_e. \qquad\qquad (278)$$

Then, $p_e$, $q_e$, $z_e$ and $\lambda_e$ are given in the following as the functions of $\phi_e$

$$p_e \;=\; \frac{\phi_e r_i + \delta\,r_r}{\phi_e^{\,2} + \delta^2}, \qquad\qquad (279)$$

$$q_e \;=\; -\frac{-\delta\,r_i + r_r\phi_e}{\phi_e^{\,2} + \delta^2}, \qquad\qquad (280)$$

$$z_e \;=\; \nu\sqrt{\frac{r_i^{\,2} + r_r^{\,2}}{\phi_e^{\,2} + \delta^2}}, \qquad\qquad (281)$$

$$\lambda \;=\; \frac{1}{k\,d\,A}\left(-\phi_e + kdA\nu\sqrt{\frac{r_i^{\,2} + r_r^{\,2}}{\phi_e^{\,2} + \delta^2}} + \phi_C\right). \qquad\qquad (282)$$

Here by the method of Lyapunov, the stability of the system of differential equations are investigated. Let $p$, $q$, $z$ be developed around $p_e$, $q_e$, and $z_e$ as

$$p \;=\; p_e + \Delta p, \qquad\qquad (283)$$

$$q \;=\; q_e + \Delta q, \qquad\qquad (284)$$

$$z = z_e + \Delta z, \qquad (285)$$

The above expressions substitute *p, q, z* in expressions from 261 to 263 of the system of differential equations, then ignoring higher order terms of $\Delta$ leads to following differential equation system concerning $\Delta p$, $\Delta q$, and $\Delta z$

$$\frac{d}{dt} \begin{bmatrix} \Delta p \\ \Delta q \\ \Delta z \end{bmatrix} = M \begin{bmatrix} \Delta p \\ \Delta q \\ \Delta z \end{bmatrix} \qquad (286)$$

and

$$M = \begin{bmatrix} \dfrac{kdB\nu\, p_e q_e}{\sqrt{p_e^2+q_e^2}\,\mu} - \delta & M_{12} & \left(kdA - \dfrac{kdB}{\mu}\right) q_e \\[3mm] M_{21} & -\dfrac{kdB\nu\, p_e q_e}{\sqrt{p_e^2+q_e^2}\,\mu} - \delta & -\left(kdA - \dfrac{kdB}{\mu}\right) p_e \\[3mm] \dfrac{\nu\, p_e}{\sqrt{p_e^2+q_e^2}\,\mu} & \dfrac{\nu\, q_e}{\sqrt{p_e^2+q_e^2}\,\mu} & -\dfrac{1}{\mu} \end{bmatrix} \qquad (287)$$

where

$$\qquad (288)$$

$$M_{12} = \frac{kdB\nu\, q_e^2}{\sqrt{p_e^2+q_e^2}\,\mu} + kdA\,(z-\lambda) + \frac{kdB\left(-z + \nu\sqrt{p_e^2+q_e^2}\right)}{\mu} + \phi_C,$$

$$\qquad (289)$$

$$M_{21} = -\frac{kdB\nu\, p_e^2}{\sqrt{p_e^2+q_e^2}\,\mu} - kdA\,(z-\lambda) - \frac{kdB\left(-z + \nu\sqrt{p_e^2+q_e^2}\right)}{\mu} - \phi_C.$$

Let *m(h)* be the characteristic polynomial of matrix *M* defined by

$$m(h) = a_0 h^4 + a_1 h^3 + a_2 h^2 + a_3 h + a_4. \qquad (290)$$

Coefficients $a_0$, $a_1$, $a_2$, and $a_3$ are functions of $\phi_e$ as shown in the following.

$$a_0 = 1, \qquad (291)$$

$$a_1 = \frac{2\mu\delta + 1}{\mu}, \tag{292}$$

$$a_2 = \frac{2\sqrt{\phi_e{}^2 + \delta^2}\,\delta + kd\nu\,B\phi_e r + \mu\left(\phi_e{}^2 + \delta^2\right)^{3/2}}{\sqrt{\phi_e{}^2 + \delta^2}\,\mu}, \tag{293}$$

$$a_3 = \frac{\phi_e kd\nu\,Ar + \left(\phi_e{}^2 + \delta^2\right)^{3/2}}{\sqrt{\phi_e{}^2 + \delta^2}\,\mu}, \tag{294}$$

where r is defined by

$$r = \sqrt{r_r{}^2 + r_i{}^2}. \tag{295}$$

### Driving Frequency is Lower Than Resonance Frequency

In the case that the frequency of the carrier driving the virtual resonance circuit is lower than the resonance frequency, namely $\phi < 0$, then by replacing $\phi$ with $-\phi$, the transfer function from the input of the phase compensation circuit to the output of the VCO is as follows:

$$\phi = k\,d\,(A + B\,s)(z - \lambda) + \phi_C. \tag{296}$$

Replacing $\phi$ with $-\phi$ in expressions 47 and 48 leads to

$$\frac{d}{dt}p = -q\phi - p\delta + r_r \tag{297}$$

$$\frac{d}{dt}q = p\phi - q\delta + r_i \tag{298}$$

Substituting $\phi$ in expression 296 for $\phi$ in expressions 297, and 298 and eliminating $\phi$ reduces to expressions 299, 300, and 301 defined in the following.

$$\frac{d}{dt}p = -\left\{ kdA\,(z - \lambda) + \frac{kdB\left(-z + \nu\sqrt{p^2 + q^2}\right)}{\mu} + \phi_C \right\} q - \delta p + r_r, \tag{299}$$

$$\frac{d}{dt}q = \left\{ kdA\,(z - \lambda) + \frac{kdB\left(-z + \nu\sqrt{p^2 + q^2}\right)}{\mu} + \phi_C \right\} p - \delta q + r_i. \tag{300}$$

$$\frac{d}{dt}z = \frac{-z + \nu \sqrt{p^2 + q^2}}{\mu}. \tag{301}$$

Let M be the matrix of the differential equation system derived by lineraization around equilibrium point from the system of differential equations defined by expressions 299, 300, and 301 and $m(h)$ be the characteristic polynomial of $M$ where $m(h)$ is given as

$$m(h) = a_0 h^3 + a_1 h^2 + a_2 h + a_3 \tag{302}$$

then, letting r be defined by

$$r = \sqrt{r_r{}^2 + r_i{}^2}, \tag{303}$$

coefficients $a_0$, $a_1$, $a_2$ and $a_3$ are given again by expressions from 291 to 294. Then it is found that coefficients $a_0$, $a_1$, $a_2$ and $a_3$ are given by expressions from 291 to 294 regardless of whether driving frequency is higher or lower than the resonance frequency.

**Redefinition of Characteristic Polynomial**

Since $k, d, \nu,$ and $r$ are included simultaneously in a single term together with $A$ or $B$ in expressions from 291 to 294, $N$ is introduced by

$$k\,d\,\nu\,r\,A = N \tag{304}$$

and

$$k\,d\,\nu\,r\,B = B'\,N. \tag{305}$$

Furthermore $B'$ is replaced again with $B$, then expressions from 291 to 294 are redefined as follows:

$$a_0 = 1, \tag{306}$$

$$a_1 = \frac{2\mu\delta + 1}{\mu}, \tag{307}$$

$$a_2 = \frac{2\sqrt{\phi_e{}^2 + \delta^2}\delta + N B\phi_e + \mu\left(\phi_e{}^2 + \delta^2\right)^{3/2}}{\sqrt{\phi_e{}^2 + \delta^2}\mu}, \tag{308}$$

$$a_3 = \frac{\phi_e N + \left(\phi_e{}^2 + \delta^2\right)^{3/2}}{\sqrt{\phi_e{}^2 + \delta^2}\mu}. \tag{309}$$

The characteristic polynomial defined by expression 290 is redefined with coefficients $a_0$, $a_1$, $a_2$ and $a_3$ given by expressions from 306 to 309 as

$$m(h) = a_0 h^3 + a_1 h^2 + a_2 h + a_3. \qquad (310)$$

Then the characteristic polynomial $m(h)$ leads to

$$m(h) = \frac{\left((h+\delta)^2 + \phi^2\right)(\mu h + 1)}{\mu} + \frac{\phi\,(hB + 1)\,N}{\sqrt{\phi^2 + \delta^2}\,\mu}. \qquad (311)$$

It is assumed that $F_w$ is the transfer function of the virtual voltage generation circuit and that $B_w$ is the transfer function of the feedback circuit. Without discriminating $F_w$ and $B_w$ from $C\,F_w$ and $1/C\,B_w$ for the common constant $C$, $F_w$ is found from expression 311 to be

$$F_w = \frac{N\,\phi}{\sqrt{\phi^2 + \delta^2}\,(\mu\,h + 1)\left((h+\delta)^2 + \phi^2\right)} \qquad (312)$$

and then $B_w$ is

$$B_k = B\,h + 1. \qquad (313)$$

Then the closed loop transfer function $F_w/(1 + F_w B_w)$ is given by calculation as

$$\frac{F_w}{1 + F_w\,B_k} = \frac{N\,\phi}{\mu\,\sqrt{\phi^2 + \delta^2}}$$
$$\times \left(\frac{(\mu\,h + 1)\left((h+\delta)^2 + \phi^2\right)}{\mu} + \frac{N\,\phi\,(Bh + 1)}{\mu\,\sqrt{\phi^2 + \delta^2}}\right)^{-1}. \qquad (314)$$

Then it is found that the characteristic polynomial $m(h)$ coincides with the denominator of the closed loop transfer function $F_w/(1 + F_w B_w)$ except for constant multiplication. Therefore by selecting $B$ and $N$ so that the real part of all the roots of the characteristic polynomial is made negative, the stable feedback can be realized in the sense that the real part of roots of the denominator of the closed loop transfer function is negative.

**Negative Real Part of Root**

The characteristic polynomial is third order polynomial, and the characteristic equation $m(h) = 0$ has at least one real root $h_0$. In the case that the equation $m(h) = 0$ has three real roots, the coefficients of the equation $a_0$, $a_1$, $a_2$ and $a_3$ are positive, then all the real roots are negative. The dominant root $h_0$, having the real part closest to the origin, is a real root and is estimated that $-a_1/3 \leq h_0 < 0$

In the case that equation $m(h) = 0$ has one real root $h_0$ and two imaginary roots $h_1$ and $h_2$, the relation between the coefficients and roots of the equation shows

$$h_1 + h_2 + h_0 = -a_1. \tag{315}$$

Imaginary roots $h_1$ and $h_2$ satisfy

$$\Re h_1 = \Re h_2, \tag{316}$$

$$\Im h_1 = -\Im h_2, \tag{317}$$

then, letting $h_r$ be defined by

$$h_r = \Re h_1 = \Re h_2, \tag{318}$$

expression 315 is rewritten to

$$2 h_r + h_0 = -a_1. \tag{319}$$

Hence the necessary and sufficient condition that the real part of the imaginary roots is negative is found to satisfy

$$h_0 \geq -a_1. \tag{320}$$

Namely,

$$m(-a_1) \leq 0 \tag{321}$$

**Real Dominant Root**

The characteristic equation is of third degree, and then has a real root $h_0$ at least. In the case that the characteristic equation $m(h) = 0$ has three real roots, coefficients of the equation $a_0$, $a_1$, $a_2$, and $a_3$ are all positive, and then the roots are real and negative. Let $h_0$ be such a root that has the minimum absolute value among the roots, then $h_0$ can be estimated to be

$$-\frac{a_1}{3} \leq h_0 < 0. \tag{322}$$

Suppose that the characteristic equation $m(h) = 0$ has a real root $h_0$ and two imaginary roots $h_1$ and $h_2$. Let the real part of the two imaginary root $h_1$ and $h_2$ be $h_r$, then the expression 315 is rewritten to

$$2 h_r + h_0 = -a_1. \tag{323}$$

From the above, it can be seen that real root $h_0$ is the dominant root if and only if the following expression holds,

$$h_0 \geq -\frac{a_1}{3} \tag{324}$$

which is equivalent to

$$m(-\frac{a_1}{3}) \leq 0. \tag{325}$$

**Characteristic Polynomial m(h)**

Characteristic polynomial is by definition as follows:

$$m(h) \;=\; h^3 + \frac{(2\,\mu\,\delta + 1)\,h^2}{\mu} \tag{326}$$
$$+ \frac{\left(\mu\left(\phi_e^2 + \delta^2\right)^{3/2} + \phi_e BN + 2\delta\sqrt{\phi_e^2 + \delta^2}\right)h}{\mu\sqrt{\phi_e^2 + \delta^2}} + \frac{\phi_e N + \left(\phi_e^2 + \delta^2\right)^{3/2}}{\mu\sqrt{\phi_e^2 + \delta^2}}.$$

From expression 311, $m(h)$ is also rewritten to

$$m(h) = \frac{\left((h+\delta)^2 + \phi_e^2\right)(\mu\,h + 1)}{\mu} + \frac{\phi_e\,N\,(hB + 1)}{\mu\sqrt{\phi_e^2 + \delta^2}}. \tag{327}$$

In the case that $\phi_e = 0$, then $m(h)$ is given as

$$m(h) = \frac{(h+\delta)^2(\mu\,h + 1)}{\mu}. \tag{328}$$

Polynomial $-m(h)$ is valued at $h = -\delta$ as

$$-m(-\delta) = \frac{\phi_e\left((B\delta - 1)\,N + \phi_e\sqrt{\phi_e^2 + \delta^2}\,(\mu\delta - 1)\right)}{\sqrt{\phi_e^2 + \delta^2}\,\mu}. \tag{329}$$

Similarly $-m(h)$ is valued at $h = -1/\mu$ as

$$-m\left(-\frac{1}{\mu}\right) = \frac{\phi_e N\,(B - \mu)}{\mu^2\sqrt{\phi_e^2 + \delta^2}}. \tag{330}$$

**Characteristic Polynomial** $m(h)$ **as Function of** $\phi$

From expression 327, $m(h)$ is

$$m(h) = \frac{\left((h+\delta)^2 + \phi_e^2\right)(\mu h + 1)}{\mu} + \frac{\phi_e N (hB + 1)}{\mu \sqrt{\phi_e^2 + \delta^2}}. \qquad (331)$$

Since there is no possibility of confusion, $\phi_e$ is safely replaced with $\phi$ hereafter. Then characteristic polynomial $m(h)$ is the function of $\phi$ instead of $\phi_e$.

**Case of** $h \leq -1/\mu$ **and** $Bh + 1 \leq 0$

From expression 327, the first term becomes negative if the following expression holds.

$$h < -\frac{1}{\mu} \qquad (332)$$

and the second term becomes negative if the following expression holds.

$$Bh + 1 \leq 0. \qquad (333)$$

Both of expressions 332 and 333 hold, then

$$-m(h) > 0. \qquad (334)$$

holds regardless of $\phi$. In the case that $B < \mu$, then $Bh + 1 = 0$ holds at $h = -1/B$, therefore

$$-m(-\frac{1}{B}) > 0 \qquad (335)$$

holds regardless of $\phi$

**Case of** $h \leq -1/\mu$ **and** $Bh + 1 > 0$

Necessary and sufficient condition that the set of $h$ satisfying both of $h \leq -1/\mu$ and $Bh + 1 > 0$ is not empty is $B < \mu$. If $B \geq \mu$, then $-m(h) > 0$ holds for such $h$ that $h \leq -1/\mu$. It is assumed hereafter that $B < \mu$,
**[0273]** As is seen from expression 327, characteristic polynomial $m(h)$ depends on $h$ and $\phi$ as well. Let $E_h(\phi)$ be equated with $m(h)$ as a function of $\phi$. That is,

$$E_h(\phi) = -m(h). \qquad (336)$$

The first order derivative of $E_h(x)$ relative to $x$ is

$$\frac{d}{dx}E_h(x) \;=\; -\frac{(hB+1)\,\delta^2 N}{\mu\,(x^2+\delta^2)^{3/2}} - 2\,\frac{x\,(\mu\,h+1)}{\mu}. \tag{337}$$

The derivative of $E_h(x)$ at $x = 0$ satisfies, from the assumption,

$$-\left(\delta^2\,(Bh+1)\right)N < 0 \tag{338}$$

That is,

$$\left(\frac{d}{dx}E_h\right)(0) < 0 \tag{339}$$

holds. It is clear at a large $x$ that

$$\left(\frac{d}{dx}E_h\right)(x) > 0. \tag{340}$$

The there exists such x that

$$\left(\frac{d}{dx}E_h\right)(x) = 0. \tag{341}$$

The second derivative of $E_h(x)$ relative to $x$ is given by calculation as

$$\frac{d^2}{dx^2}E_h(x) \;=\; 3\,\frac{(hB+1)\,x\delta^2 N}{\mu\,(x^2+\delta^2)^{5/2}} - 2\,\frac{\mu\,h+1}{\mu}. \tag{342}$$

The above expression together with the assumption leads to

$$\left(\frac{d^2}{dx^2}E_h\right)(x) > 0 \tag{343}$$

for $x \ge 0$. Then $E_h(x)$ is convex in a downward direction as a function of $x$. From expressions 339 and 340, there exists such an unique $x$ that satisfies expression 341. Let $x_h$ be such $x$ that satisfies expression 341, then $E_h(x)$ has the minimum at $x = x_h$. Since the derivative of $E_h(x)$ becomes zero at $x = x_h$, then

$$0 \;=\; \frac{(hB+1)\,\delta^2 N}{\mu\,(x^2+\delta^2)^{3/2}} + 2\,\frac{x\,(\mu\,h+1)}{\mu}. \tag{344}$$

Then $N$ can be represented by using $x_h$ as

$$N = -2\,\frac{x\,(\mu\,h+1)\,(x^2+\delta^2)^{3/2}}{(hB+1)\,\delta^2}. \tag{345}$$

By using expression 345, the minimum $E_h(\phi_h)$ is given as

$$E_h(\phi_h) \;=\; -\frac{\left(\delta^2\,(h+\delta)^2 - \phi_h^{\,2}\left(2\,\phi_h^{\,2}+\delta^2\right)\right)(\mu\,h+1)}{\delta^2\mu}. \tag{346}$$

Hence, in the case that $Bh + 1 > 0$ is satisfied at $h = -\delta$, equivalently

$$B\,\delta - 1 < 0, \tag{347}$$

then

$$E_h(\phi_h) \leq 0 \tag{348}$$

holds because of $-\delta < -1/\mu$.

From expression 346, in the case that the following expression holds,

$$h + \delta \neq 0 \tag{349}$$

then there exists such $\phi_h$ that satisfies both $E\_h(\phi_h) > 0$ and $\phi_h > 0$. The domain of $\phi$ such that the minimum $E_h(\phi_h)$ becomes positive can be given as follows: Let $G_h$ be defined by

$$G_h = \{\,x \mid g_h(x) > 0\,\} \tag{350}$$

where $g_h(\phi)$ is defined as

$$g_h(\phi) \;\equiv\; \delta^2\,(h+\delta)^2 - \phi^2\left(\delta^2 + 2\,\phi^2\right) \tag{351}$$

and expression 351 is contained in expression 346 as a term.

Let *G* be defined by

$$G = \left\{ x \mid 0 \le x \le \frac{\delta}{\sqrt{2}} \right\} \qquad (352)$$

Function $g_h(x)$ is decreasing for *x* in $x \ge 0$. Calculation of $g_h(x)$ at $x = \delta/\sqrt{2}$ shows

$$g_h(\frac{\delta}{\sqrt{2}}) = h\delta^2 \left(2\delta + h\right) \qquad (353)$$

Then, in the case that *h* in -2δ≤h≤ - 1/μ

$$G_h \subset G \qquad (354)$$

holds, and in the case that *h* in *h*≤ - 2δ, then

$$G \subset G_h \qquad (355)$$

holds.

$\phi_h$ **And** $E_h(\phi_h)$ **Defined by** *N*

By definition, *N* is a constant and independent of *h*. Expression 345 can be modified to

$$\phi_h \left(\phi_h{}^2 + \delta^2\right)^{3/2} = -\frac{1}{2} \frac{\delta^2 \left(hB + 1\right) N}{\left(\mu h + 1\right)}. \qquad (356)$$

The left-hand side of expression 356is defined by expression 356. In the right side of expression 356, the expression is a function of *h* because δ and μ are constants, and because *N* and *B* can be thought to be constants given beforehand. Expression 356 shows that $\phi_h$ is uniquely defined for an arbitrary *h* in -1/*B* < *h* < -1/μ. For an arbitrary *h* in -1/*B* < *h* < -1/$\mu$, $\phi_h$ is uniquely defined and therefore $E_h(\phi_h)$ is evaluated. Let *F*(*h*) be a function making *h* in -1/*B* < *h* < -1/μ correspond to $E_h(\phi_h)$. That is, *F*(*h*) is defined in the domain of *h* satisfying both of

$$h \le -\frac{1}{\mu}, \qquad (357)$$

$$B\,h + 1 > 0, \qquad (358)$$

or rather

$$-\frac{1}{B} < h \le -\frac{1}{\mu} \tag{359}$$

as

$$F : h \to E_h(\phi_h) \tag{360}$$

with dependence on $N$ and $B$. As $N$ becomes larger, the $\phi_h$ also becomes larger for a given $h$ and then $F(h)$ becomes negative in due course. The domain of such $h$ as $F(h) < 0$ extends or shrinks according to the magnitude of $N$. Therefore the domain can be controlled by $N$.

For such $h$ as $F(h) > 0$, then $-m(h)$ satisfies $-m(h) > 0$ and then characteristic polynomial $m(h)$ has not real roots in $h$ such as $F(h) > 0$. Thus, by confining a real root of $m(h) = 0$, the real root is made to be the dominant root separated from imaginary roots.

**Graph of Function** $y = -m(h)$

As for the graph of $y = -m(h)$, $m(h)$ is a third order polynomial, and then the graph is symmetric relative to a inflection point. It is found the inflection does not depend on $\phi$ as is shown in the following.

$$\frac{d}{dh} y = \frac{-\sqrt{\phi^2 + \delta^2} \left( \delta^2 \mu + 2\delta + \phi^2 \mu + 3 h^2 \mu + 4 h\mu \delta + 2 h \right) - \phi B N}{\mu \sqrt{\phi^2 + \delta^2}}, \tag{361}$$

$$\frac{d^2}{dh^2} y = -2 \frac{3\mu h + 2\mu \delta + 1}{\mu}. \tag{362}$$

Then the inflection point being denoted by $h_\tau$, $h_\tau$ is given as

$$h_\tau = -\frac{1}{3} \frac{2\mu \delta + 1}{\mu} = -\frac{a_1}{3} \tag{363}$$

As for the intersection of graph $y = -m(h)$ with the h axis, in the case that $-m(h_\tau) > 0$, then there is a real root in $[h_\tau, 0]$ and then the real part of the imaginary root is less than $h_\tau$. Namely if $-m(h_\tau) > 0$ holds, then the dominant root is a real root separated from imaginary root.

As for $F$ defined in expression 360, if $F(h_\tau) > 0$, there is a real root in $[h_\tau, 0]$ regardless of $\phi$, and then the real part of the imaginary root is less than $h_\tau$. Then the dominant root of the characteristic polynomial is a real root separated from imaginary root.

In an actual power supply, $\phi_e$ is confined within an upper and a lower bounds. Moreover $\delta$, $\mu$ and $\nu$ varies according to the load. Then numerical calculation is needed to see the condition that the dominant roots is a real root separated from imaginary roots.

**Ripples From Rectification Circuit**

The ripple is not superimposed on the output of the virtual rectification circuit in the power supply described in the system of differential equations of expressions from 261 to 263. However, a periodic ripples of the high frequency caused by the rectification are superimposed on the output of an actual rectification circuit. For instance, when the dominant root $\xi$ is a real root separated from the imaginary root, the time process of the output voltage is approximated by $1 - \exp(-\xi t)$. The signals stabilizing the output voltage rises at the time constant of $1/\xi$, and is low enough in frequency compared with the frequency of a periodic ripple of the high frequency caused by the rectification. Attenuating with a filter ripples outside the bandwidth where feedback is effective makes it possible to prevent breakdown of the feedback caused by ripples and to achieve a large closed loop gain.

**Zeros at Right Half Plane**

In the case that the piezoelectric transformer is driven by a range of frequency higher than the resonance frequency, the frequency needs to be lowered so as raise the output voltage, moving closer to the resonance frequency. As a result the high-frequency carrier outputted by the piezoelectric transformer decreases in frequency and then the output voltage generated by rectifying the carrier may decrease in voltage temporarily. As the carrier shifts in frequency, the change of the output voltage caused directly by the shift of the frequency becomes large as the increase of the load.
As the frequency of the high-frequency carrier driving the piezoelectric transformer shifts, the amplitude of the carrier begins to change as the stationary vibration is built up in the transformer. So, at the output of the transformer, the frequency of the high-frequency carrier changes first and then the amplitude begins to change. In the case that the driving frequency is higher than the resonance frequency, shifting the driving frequency downward may decrease the output voltage generated by rectifying the high-frequency carrier temporarily before the output voltage begins to increase as the buildup of the amplitude. An amount of the voltage that decreases temporarily depends on the load connected to the output of the transformer.
In such a power supply that the output voltage is fed back to the driving frequency of the piezoelectric transformer and that a range of the driving frequency is selected to be higher than the resonance frequency, it may be possible that the control which makes the output voltage increase is accompanied with the temporal decrease of the output voltage, which is characteristic of the control system provided with zeros located at the right half plane.

**Confirming Zeros at Right Half Plane**

Zeros at the right half plane can be confirmed not by scrutinizing the change of the output voltage caused by shift of the driving frequency, but by comparing stability of an ideal power supply between two ranges of driving frequency higher and lower than the resonance frequency, where the ideal power supply feeds back the output voltage to the driving frequency. It is necessary to choose parameters carefully so as to stabilize by feedback the control system with zeros at the right half plane. So enlarging the loop gain clarifies the existence of the zeros spontaneously especially in the case that the load is heavy.
The simulation shows obvious difference about the stability between the two ranges of the driving frequency. The feedback is more stable in the case that the driving frequency is lower than the resonance frequency. In an actual power supply using the piezoelectric transformer, the range of parameters for stable feedback seems wider in the case that the driving frequency is lower than the resonance frequency, which is probably because implementation details of the voltage generation circuit may cover zeros at the right half plane or move their locations.

**Resonance Circuit**

Compared between the ranges of the driving frequency, diving at the lower frequency is more stable than driving at the higher frequency in the case of a piezoelectric transformer, which will be also the case with a resonance circuit, because mechanism to create zeros at the right half plane is common between the piezoelectric transformer and a resonance circuit.

**Slowly Changing Frequency of Carrier**

The system of differential equations describing the power supply is given by expressions from 106 to 109 or by expressions from 261 to 263, independent of whether the riving frequency is higher or lower than the resonance frequency. Therefore, the condition for stable feedback led by the system of differential equations does not depend on whether the frequency of the carrier is higher or lower than the resonance frequency. On the other hand, the stabilization of the output voltage where the output voltage is fed back to the frequency of the carrier is more stable when the driving frequency is lower than the resonance frequency. So the system of differential equations given by expressions from 106 to 109 or by expressions from 261 to 263 does not formulate the condition that the feedback is more stable when the driving frequency is lower than the resonance frequency.
The system of differential equations describes the change of the output voltage which the shift of the driving frequency causes through frequency dependence of the resonance circuit and does not describe the change of the output voltage caused directly by the change of the driving frequency. The direct change of the output voltage by the frequency shift is proportional to the shift of the frequency and becomes larger as the load becomes heavier. Therefore instability which comes out with heavy load may be attributed to the direct change of the output voltage by the frequency shift.

While the frequency of the carrier shifts slowly, the direct change of the output voltage by the shift becomes small, and then the stability of feedback comes independent of whether the driving frequency is higher or lower than the resonance frequency. Feeding back the output of the error amplifier or its derivative to the amplitude of the carrier makes the frequency of the carrier shift slowly, which is effective to stabilize the feedback of the output voltage to the frequency of the carrier.

Stabilization of the output voltage by feeding the output voltage of a buffer circuit to the voltage offsetting the ground of the buffer circuit shown in patent document 2 is implemented by introducing a fast power amplifier driving the ground of the rectification circuit. The output of the error amplifier is fed back to the voltage offsetting the ground of the rectification circuit. The output voltage of the rectification circuit being fed back locally to the voltage offsetting the ground of the rectification circuit is faster than the feedback of the output voltage to the driving frequency, and then the local feedback to the offset voltage smoothes the output of the error amplifier as a low-pass filter, making the driving frequency change slowly. Feeding back the output voltage of the buffer circuit to its offset voltage is an example of the feedback which makes the frequency of the carrier change slowly.

**[Advantageous Effect of Invention]**

The invention gives the composition of a feedback circuit and its circuit constants that stabilize the direct-current output voltage generated by rectifying the high-frequency carrier supplied by the resonance circuit. As a result, it becomes realized that the power supply using a resonance circuit such as a piezoelectric transformer stabilizes the output voltage precisely and that a range of the stabilized output voltage can be supplied to the wide range of load.

Let the transfer function of the error amplifier be defined by

$$\frac{E}{s} + 1 + B\,s \qquad\qquad (364)$$

where $E$ is a zero or a positive constant and $B$ is a positive constant, it is shown how to select the constants to make the feedback stable.

Based on parameters of the voltage generation circuit given beforehand, the above transfer function is designed to satisfy the sufficient condition, and the error amplifier implementing the sufficient condition realizes stable feedback. Moreover characteristics of the power supply thus implemented can be estimated beforehand.

**[Brief Description of Drawings]**

[Fig. 1] Fig. 1 is an explanation chart where resonance frequency and the range of the driving frequency were shown.

[Fig. 2] Fig. 2 is an explanation chart where the amplitude ratio was compared between the transfer function $h_0(s)$ and its approximation $h_0^T(s)$.

[Fig. 3] Fig. 3 is an explanation chart where phase was compared between the transfer function $h_0(s)$ and its approximation $h_0^T(s)$.

[Fig. 4] Fig. 4 is an explanation chart where frequency dependence of the amplitude was shown.

[Fig. 5] Fig. 5 is an explanation chart where Q-value dependence of the amplitude ratio was shown.

[Fig. 6] Fig. 6 is an explanation chart where the load dependence of the resonance frequency was shown.

[Fig. 7] [Fig. 7 is an explanation chart where a block diagram of the power supply is shown.

[Fig. 8 Fig. 8 is an explanation chart where the resonance circuit and the rectification circuit were shown.

[Fig. 9] Fig. 9 is a explanation chart where the virtual resonance circuit and the virtual rectification circuit were shown.

[Fig. 10] Fig. 10 is an explanation chart where the equivalent power supply was shown.

[Fig. 11] Fig. 11 is an explanation chart where $\phi$ dependence of the loop gain was shown.

[Fig. 12] Fig. 12 is an explanation chart where an example of the smart power supply was shown.

[Fig. 13] [Fig. 13 is an explanation chart where an block diagram of the smart power supply was shown.

[Fig. 14] Fig. 14 is an explanation chart where the graph of $y = f_1(h)$ was shown.

[Fig. 15] Fig. 15 is an explanation chart where an example of the simple power supply was shown.

[Fig. 16] Fig. 16 is an explanation chart where a block diagram of the simple power supply is shown.

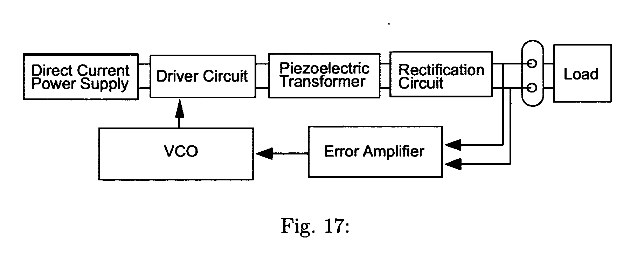

[Fig. 17] Fig. 17 is an explanation chart where a block diagram of the direct-current stabilized high-voltage power supply was shown.

[Fig. 18] Fig. 18 is an explanation chart where resonance characteristics of the piezoelectric transformer and the range of the driving frequency were shown.

[Fig. 19] Fig. 19 is an explanation chart where the direct-current stabilized high-voltage power supply using the piezoelectric transformer was shown.

[Fig. 20] [Fig. 20 is an explanation circuit where measured frequency dependence of the amplitude ratio was shown.

[Fig. 21] Fig. 21 is an explanation chart where the circuit for simulation was shown.

[Fig. 22] Fig. 22 is an explanation circuit where the equivalent circuit of the piezoelectric transformer was shown.

[Fig. 23] Fig. 23 is an explanation chart where the ideal transformer was shown.

[Fig. 24] Fig. 24 is an explanation chart where the circuit for simulating the ideal transformer was shown.

[Fig. 25] Fig. 25is an explanation chart where the circuit simulating the VCO was shown.

[Fig. 26] Fig. 26 is an explanation chart where the circuit for simulating the error amplifier was shown.

[Fig. 27] Fig. 27 is an explanation chart where the simulation circuit to measure resonance characteristics was shown.

[Fig. 28] Fig. 28 is an explanation chart where resonance characteristics with the load of 20 MΩ was shown.

[Fig. 29] Fig. 29is an explanation chart where resonance characteristics with the load of 30 MΩ was shown.

[Fig. 30] Fig. 30is an explanation chart where resonance characteristics with the load of 40 MΩ was shown.

[Fig. 31] Fig. 31 is an explanation chart where resonance characteristics with the load of 50 MΩ was shown.

[Fig. 32] Fig. 32 is an explanation chart where the output voltage of 4 kV being supplied to the load of 20 MΩ was shown .

[Fig. 33] Fig. 33is an explanation chart where the output voltage of 2 kV being supplied to the load of 200 MΩ was shown,

[Fig. 34] Fig. 34 is an explanation chart where the circuit for simulation was shown.

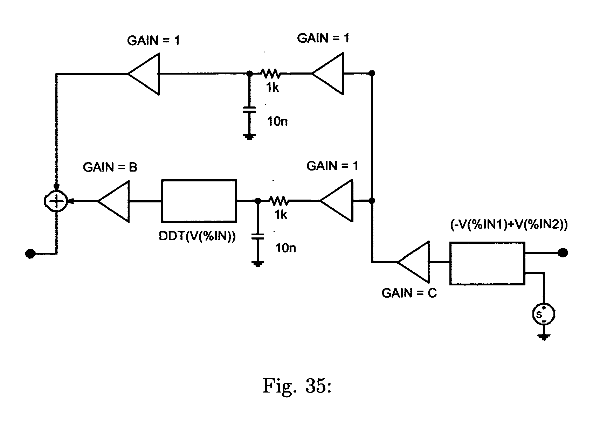

[Fig. 35] Fig. 35 is an explanation circuit where the circuit to simulate the error amplifier was shown .

[Fig. 36] Fig. 36 is an explanation chart where the output voltage of 3.5 kV being supplied to the load of 20 MΩ was shown.

[Fig. 37] Fig. 37 is an explanation chart where the output voltage of 3.5 kV being supplied to the load of 200 MΩ was shown.

**[Best Mode for Carrying Out the Invention]**

The transfer function of the phase compensation circuit in the direct-current stabilized high-voltage power supply, consisting of the high-voltage generation circuit including the piezoelectric transformer as a resonance circuit and the feedback circuit, was derived from the parameters of the high-voltage generation circuit according to the method given in the invention to show that the feedback is stable.

**[Mode for Invention 1]**

**Smart Power Supply**

**Direct-Current Stabilized High Voltage Power Supply**

The direct-current stabilized high-voltage power supply which employs the piezoelectric transformer as a resonance circuit is composed of the high-voltage generation circuit and the feedback circuit. The high-voltage generation circuit is composed of the piezoelectric transformer used as a resonance circuit and the rectification circuit.

The feedback circuit is composed of an error amplifier and the voltage controlled oscillator(VCO). The driver circuit converts the direct-current voltage supplied externally to the driver circuit into a high-frequency carrier with the same frequency as the square wave supplied by the VCO, and drives the piezoelectric transformer with the high-frequency carrier. The piezoelectric transformer boosts the amplitude of the high-frequency carrier. The rectification circuit converts the output of the piezoelectric transformer into the direct-current high voltage, which is supplied to load as an output of the high voltage power supply and inputted to the feedback circuit simultaneously.

The error amplifier detects the error by comparing the output voltage with a reference voltage, and supplies the error to the VCO. The VCO generates the square wave of the frequency decided by the output of the error amplifier and provides the pulse wave with the driver circuit. Thus the output voltage is fed back to the frequency of the high-frequency carrier driving the piezoelectric transformer so as to be stabilized.

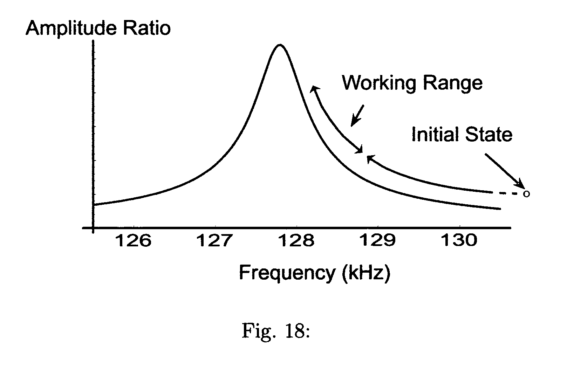

As is shown in Fig. 18, the frequency of the high-frequency carrier driving the piezoelectric transformer is chosen to be higher than the resonance frequency of the piezoelectric transformer. Therefore, the frequency is raised when the output voltage is higher than the reference voltage, moving away from the resonance frequency. The frequency is lowered in the opposite case, approaching the resonance frequency.

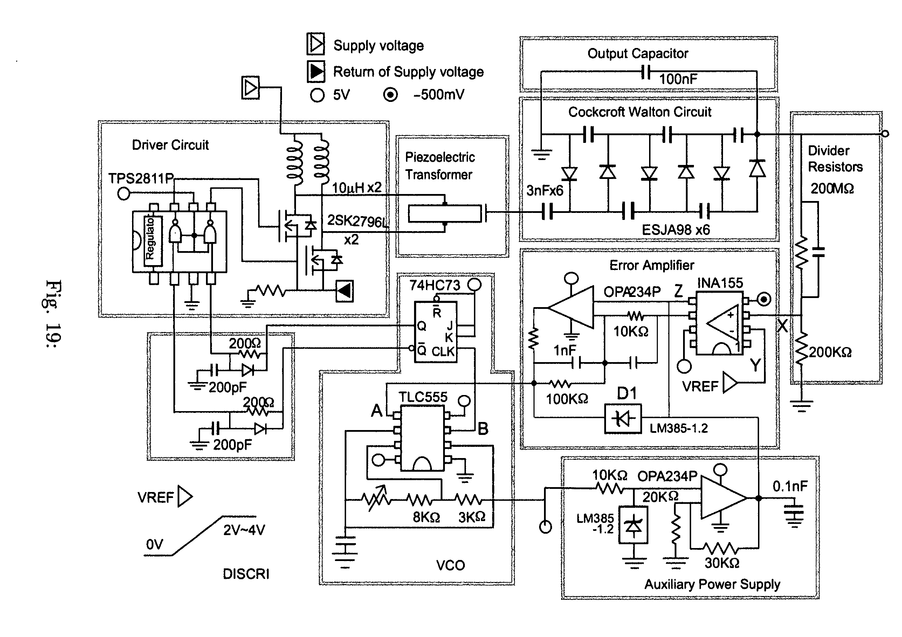

This direct-current stabilized high-voltage power supply can supply the direct-current voltage from 2 kV to 4 kV to the load from 20 MΩ to 200 MΩ. Referring to Fig. 19, direct-current stabilized high-voltage power supply is explained. Next, a simulation circuit for the high-voltage power supply is composed. The high-voltage generation circuit is simulated to measure the parameters, and circuit constants that achieve stable operation of the high-voltage power supply are calculated by the method of the invention. Finally, the power supply with the circuit constants is simulated to show the stable operation against a wide range of load and output voltage.

**Piezoelectric Transformer**

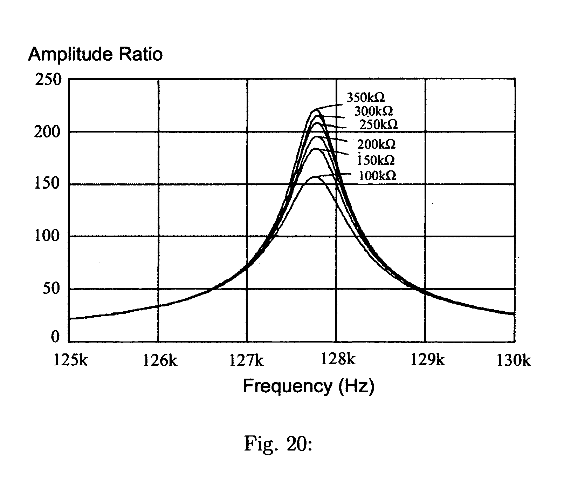

The piezoelectric transformer includes the resonance circuit. Therefore, the piezoelectric transformer shows sharp frequency characteristic and large load dependency, being different from the usual electromagnetic transformer. The piezoelectric transformer is used in the high-voltage generation circuit. Let amplitude ratio be defined by the ratio of the input to the output in voltage of the piezoelectric transformer which connected to the load resistance. The graph of the amplitude ratio actually measured for individual load resistances is shown as a function of the frequency in Fig. 20. It is understood from the graph that the piezoelectric transformer shows a large amplitude ratio near the resonance frequency.

**Rectification Circuit**

The rectification circuit shown in Fig. 19 is composed of the multiplicatively rectifying Cockcroft Walton circuit where the diodes and capacitors are connected in cascade of three stages and the output capacitor for the reduction of the ripples. The output high voltage is generated by the Cockcroft Walton circuit. When the load connected to the output of the rectification is large, the ideal Cockcroft Walton circuit of n stages genera rates the direct-current voltage of $2\,n\,E$ where $E$ is the amplitude in voltage of alternating current applied across the input of the Cockcroft Walton circuit. The multiplier at the multiplicative rectification depends on the load. The load of the Cockcroft Walton circuit viewed from its input is inversely proportional to the power of the multiplier. The Cockcroft Walton circuit works to multiply the voltage and to convert the impedance.

The output of the Cockcroft Walton circuit is buffered by the output capacitor, which reduces the ripples superimposed on the output voltage. The Cockcroft Walton circuit can generate the high voltage by pumping up the charge into the capacitance, but cannot lower the high voltage by pumping the charge out of the capacitance. The charge stored in the piezoelectric transformer is pumped up into the capacitance in one cycle of the carrier. The capacitance storing the charge is estimated at the secondary side of the transformer to be

$$\frac{4.6nF}{136.3^2} + 16.8pF \sim 17pF, \qquad (365)$$

Then the sum of the capacitance in the Cockcroft Walton circuit and in the output capacitor being evaluated to be $100nF$, 6000 cycles of the carrier will be necessary to attain the equilibrium. The number of the cycles necessary to attain the equilibrium is decided by the ratio of the capacitance between the piezoelectric transformer and the rectification circuit and is independent of the load at the first approximation.

Considering that the frequency of the carrier is around 120 kHz, it takes at least 50 msec to attain the equilibrium. Namely the time constant of the rise of the output voltage is not shorter than 50 msec. Therefore

$$\frac{1}{\mu} \leq 20. \qquad (366)$$

Considering the change of the output voltage in the case of the positive output voltage, it is necessary for piezoelectric transformer to drive the load and to charge up the capacitance while the output voltage is increased. The output voltage is lowered while the capacitance is discharged through the load. Then the time constant for the rise become shorter as the load becomes lighter. the time constant for the fall is dependent of the capacitance and the load.

### Driver Circuit

Viewed from the input, the piezoelectric transformer looks capacitive. The sinusoidal carrier is indispensable to drive the capacitance efficiently, and the approximate sinusoidal carrier is generated by resonating with inductance.

The driver circuit is composed of a pair of inductance circuits $L_1$ and $L_2$ and a FET circuit including FETs $Q_1$ and $Q_2$. The output of the VCO is supplied to the FET circuit. The FET circuit turns on and off $Q_1$ and $Q_2$ alternatively synchronized with the output of the VCO. The inductance is selected so as to roughly equate the resonance frequency decided by the inductance and the input capacitance of the transformer with the resonance frequency of the piezoelectric transformer. As a result, the FETs are turned on and off while voltage spanned across the FET is nearly zero volt, thus so-called zero-voltage switching being realized.

### Error Amplifier

The error amplifier is composed of divider resistors, the subtraction circuit and the phase compensation circuit. The subtraction circuit outputs voltage difference between the divided output voltage at terminal X and the reference voltage externally supplied at terminal Y. An auxiliary voltage supplied at terminal Z is added to the voltage difference to be supplied to the VCO. The division ratio of the divider resistors is defined at 86. So the division ratio do is

$$d_0 = \frac{1}{1001} \qquad (367)$$

The phase compensation circuit is an inverting amplifier in which the auxiliary voltage is assumed to be a grounding potential. The transfer function of the phase compensation circuit is provided with a pole located at the origin and two zeros. The transfer function converts the input to the output of the phase compensation circuit. The output is clamped by diodes within a fixed voltage from the auxiliary voltage.

### VCO

The VCO is composed of a voltage controlled oscillator and a frequency divider. Timer TLC555 is used as the voltage controlled oscillator. The square wave with the frequency decided by the voltage supplied at terminal A is outputted from terminal B. The square wave is inputted to terminal CLK of the frequency divider composed of flip-flop 74HC73, and the square wave the frequency of which is halved with a duty ratio of 50 % is outputted from terminals $Q$ and $\overline{Q}$. The square wave, ranging from 85 kHz to 139 lkHz in frequency, is the output of the VCO and supplied to the driver circuit.

When the voltage supplied to terminal A changes by 1V, the square wave from terminals $Q$ and $Q$ shifts in frequency by 40 kHz. Expression 3 defines $k$. Let $k_0$ be $k$ of the above VCO, then

$$k_0 = 2\pi \times 40 \times 10^3 \qquad (368)$$

### Auxiliary Power Supply

the auxiliary power supply provides the auxiliary voltage of 2.5 V.

### Circuit For Simulation

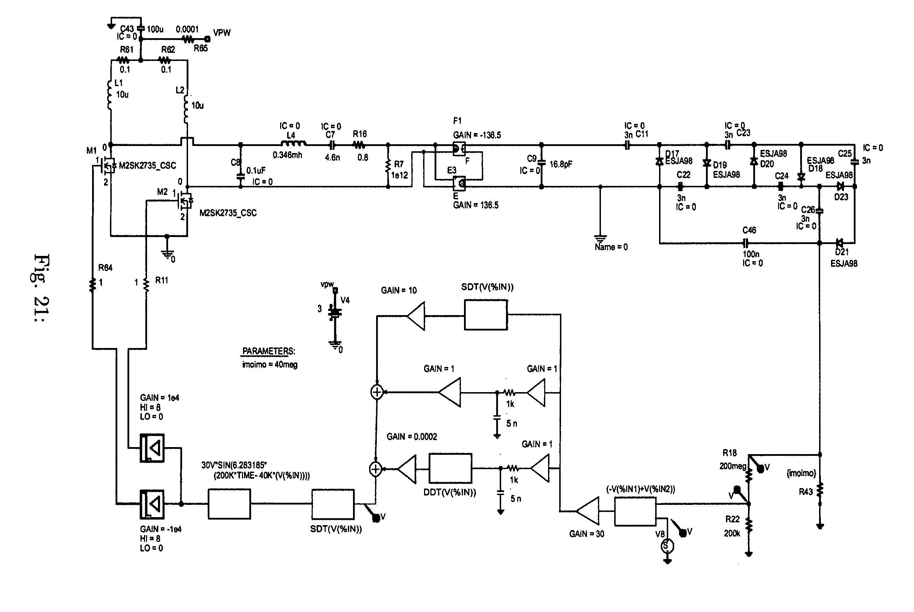

Fig. 21 shows the circuit simulating the direct-current stabilized high voltage power supply. The parameters of the high-voltage generation circuit is measured by simulation, and then $N$, $E$, and $B$ are chosen for the transfer function, with which the feedback is shown by simulation to be stabilized.

The circuit simulating the high-voltage generation circuit is faithful reproduction of the actual circuit except that the piezoelectric transformer is replaced with its equivalent circuit. Fundamentally the feedback circuit in the power supply is linearly related between its input and output. So in the circuit for simulation, the feedback circuit is replaced with a simple circuit reproducing the relation between the input and the output.

## Equivalent Circuit for Piezoelectric Transformer

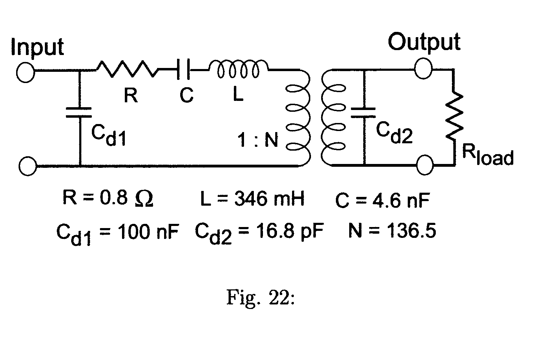

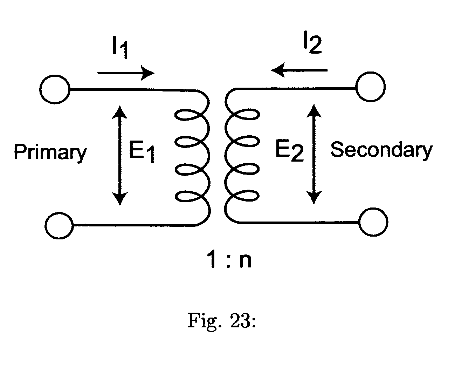

As for the piezoelectric transformer used in the power supply, the equivalent circuit and its parameters are shown in Fig. 22. The equivalent circuit includes an ideal transformer. Let *n* be the winding ratio between primary and secondary coils of the ideal transformer shown in Fig. 23. Let the primary voltage and current, and the secondary voltage and current be denoted by $E_1$, $I_1$, $E_2$ and $I_2$ respectively, then

$$\frac{E_1}{E_2} = \frac{I_2}{I_1} = n \tag{369}$$

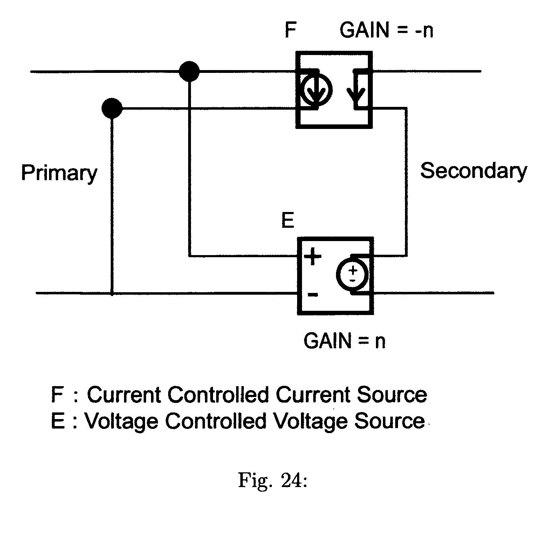

The ideal transformer is simulated by the circuit including the voltage-controlled voltage source and the current-controlled current source as shown in Fig. 24.

## Model for VCO

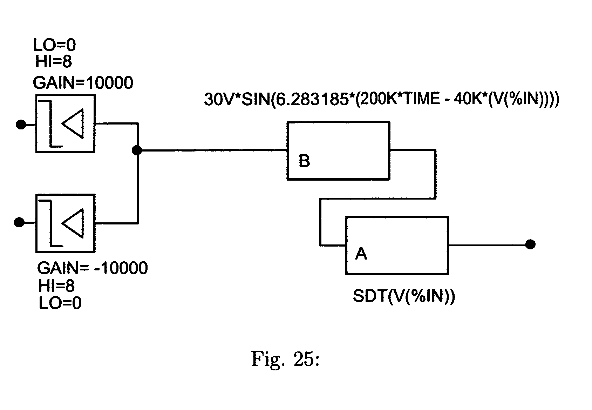

It is possible to use a circuit element called a behavior model in simulation where relation between the input and the output can be defined by mathematical equations. The circuit simulating the VCO is composed of two behavior models A, B and an amplitude limiter as shown in Fig. 25. Upper bound HI, lower bound LO and gain GAIN can be specified for the amplitude limiter. Behavior model A outputs the integration of the input. Behavior model B is provided with the mathematical equation corresponding to expression 1. As a result, behavior model B outputs the sinusoidal wave the frequency of which is proportional to the input voltage of behavior model A, namely the output of the error amplifier. The amplitude limiter, amplifying the sinusoidal wave, clips the wave at a fixed amplitude. Thus the VCO outputs the square wave having the frequency proportional to the input voltage and provided with a duty ratio of 50 %.

## Circuit Simulating Error Amplifier

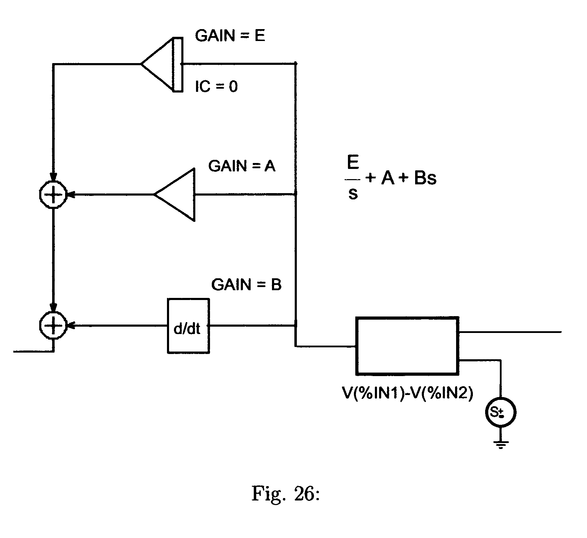

The circuit simulating the error amplifier is shown in Fig. 26. The error amplifier is composed of the subtraction circuit and the phase compensation circuit. The circuit simulating the subtraction circuit is composed of a behavior model and an gain block. The behavior model is provided with two input and an output terminals, and outputs the voltage difference between the input. The output of the behavior model is amplified by the gain block and supplied to the circuit simulating the phase compensation circuit. Let C be the gain of the gain block, the gain of the subtraction circuit is C.
The circuit simulating the phase compensation circuit is composed of an integral part, a proportional part, a differential part, and two adders. The proportional part is composed of a gain block of unity gain. The integral part consists of a gain block and a behavior model. The behavior model provided with function SDT(X) outputs the integration of the input. The output of the behavior model is amplified by the gain block. Let E be the gain of the gain block, then the gain of the integral part is E.
The differential part is composed of a behavior model and a gain block. The behavior model provided with function DDT(x) outputs the differentiation of the input relative to time. The output of the behavior model is amplified by the gain block. Let B be the gain of the gain block, then the gain of the differential part is E.
Integration circuits are placed at the input of both the gain block of the proportional part and the differential part so as to filter out noises of high frequency. The output of the integral, the proportional and the differential parts are summed by two adders. Then the transfer function of the error amplifier is given by

$$\frac{E}{s} + 1 + B\,s \tag{370}$$

In Fig. 26, element S is the voltage source generating the reference voltage. It is possible to control the loop gain by C. In Fig. 21, E = 10 and B = 0.0002 in the circuit for simulation.

## Approximation of Resonance Characteristics

Since the resonance circuit and the amplitude of the carrier are given in the circuit for simulation, the various elements on which characteristics of the resonance circuit depends are fixed, and then parameter r of resonance circuit can be calculated. Parameter δ depends on the load. The output voltage of the resonance circuit at the resonance frequency is

$$\frac{r}{\delta}. \tag{371}$$

When the load corresponds to $\delta$, the output voltage is a function of $\phi$, and the output voltage at $\phi_e$ is expressed by

$$\frac{r}{\sqrt{\phi_e{}^2 + \delta^2}}. \tag{372}$$

Then the output voltage becomes large as $\phi_e$ reduces and becomes small as $\phi_e$ grows,

While the feedback is effective, characteristics of the circuit is defined by the feedback. So characteristics of the direct-current stabilized high-voltage power supply do not depend on characteristics of the high-voltage generation circuit or the rectification circuit largely while the feedback works effectively. In the sense, the characteristics of the power supply are not so sensitive to r and $\delta$. So $r$ is estimated roughly in the following.

As for the rectification circuit connected to the load, let the transfer function from the input to the output be approximated by

$$\frac{\nu}{\mu s + 1} \tag{373}$$

then $\nu$ depends on the load and the output voltage. The change of the load is reflected by that of $\delta$, and the change of the output voltage is caused by that of $\phi$. In the sense, both of $\nu$ and $\mu$ are functions of $\delta$ and $\phi$. Yet it is difficult to express the functions explicitly.

The high-voltage generation circuit is composed of the piezoelectric transformer and the rectification circuit, In the case that the load is connected to the high-voltage generation circuit, the output voltage is a function of the frequency supplied to high-voltage generation circuit. The plot of the output voltage against the frequency shows resonance characteristics, which can be approximated from expression 52 by

$$\frac{r}{\sqrt{\phi^2 + \delta^2}}. \tag{374}$$

The above approximation gives the half value width concerning the resonance characteristics. The half value width in terms of angular velocity is $\delta$. Let $v_{max}$ be the maximum output voltage, then $v_{max}$ is rewritten as

$$v_{max} = \frac{r}{\delta} \tag{375}$$

from which $r$ can be obtained. it is clear that $\nu = 1$ in the above calculation of $r$.

**Crude Estimation of $\mu$**

Time constant $\mu$ is derived from approximating the rectification circuit by a first-order delay and upper bounded by expression 366. The delay of the rectification circuit is larger than that of the resonance circuit. Namely

$$\frac{1}{\mu} \ll \delta \qquad\qquad (376)$$

The dominant root of the characteristic polynomial around -$E$ does not depends on $\mu$ largely, and the circuit constants for the stable feedback does not depends on $\mu$ closely.

**Measuring Parameters of Resonance Characteristics**

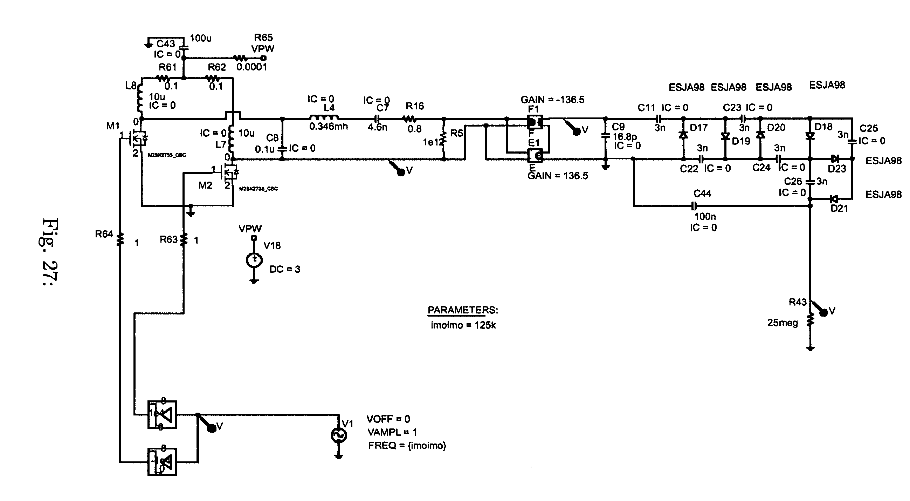

Fig.27 shows the circuit to measure the resonance characteristic by simulation. The resonance characteristic obtained from the measurement is that of the high-voltage generation circuit composed of the driver circuit, the piezo-electric transformer, and the rectification circuit. The resonance characteristic measured in 1 kHz step is shown below for several load resistance. Then $r$ is calculated according to expression 375 for individual load resistance. So $r$ is dependent on load resistance. The reason that values of $r$ thus obtained for each load resistance are roughly estimated to be in an narrow interval independently of the load resistance may be that expression 374 is the first approximation of the resonance characteristic.

**Resonance Characteristics for Load 20 M$\Omega$**

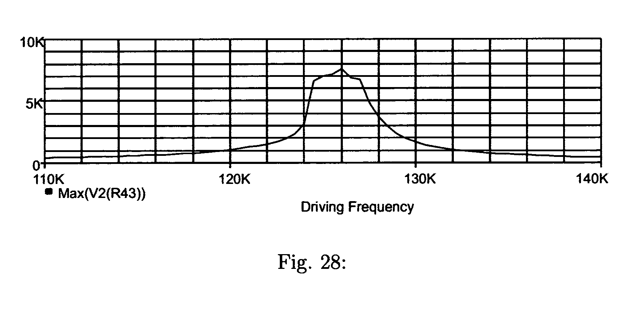

From Fig. 28, the output voltage at the resonance frequency is about 7.5 kV and the half width value is about 980 Hz in frequency, $\delta$ being 6158 in terms of angular velocity. Then $r_{20}$ is estimated to be $0.46\times10^8$.

**Resonance Characteristics for Load 30 M$\Omega$**

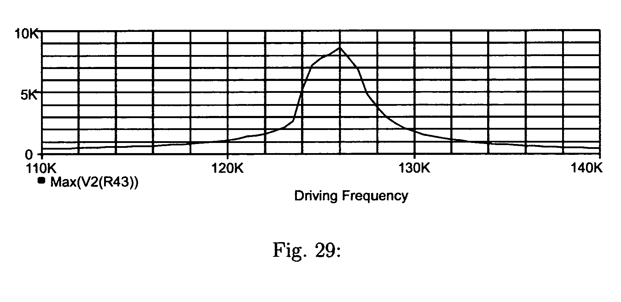

From Fig. 29, the output voltage at the resonance frequency is about 8.5 kV and the half width value is about 930 Hz in frequency, $\delta$ being 5843 in terms of angular velocity. Then $r_{30}$ is estimated to be $0.49\times10^8$.

**Resonance Characteristics for Load 40 M$\Omega$**

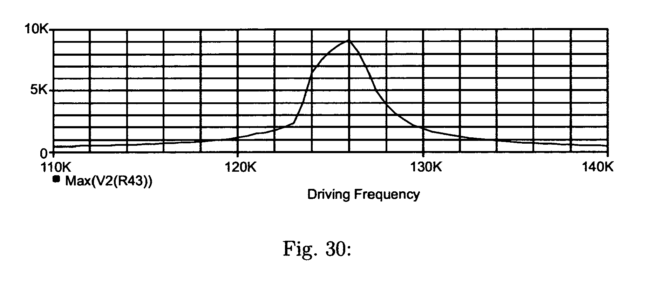

From Fig. 30, the output voltage at the resonance frequency is about 9.1 kV and the half width value is about 910 Hz in frequency, $\delta$ being 5718 in terms of angular velocity. Then $r_{40}$ is estimated to be $0.52\times10^8$.

**Resonance Characteristics for Load 50 M$\Omega$**

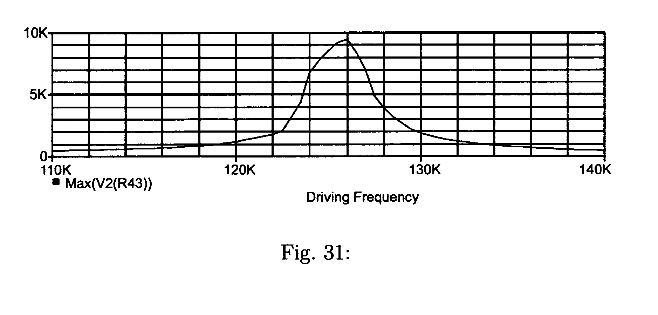

From Fig. 31, the output voltage at the resonance frequency is about 9.4 kV and the half width value is about 900 Hz in frequency, $\delta$ being 5655 in terms of angular velocity. Then $r_{50}$ is estimated to be $0.51\times10^8$.

**Direct Current Loop Gain**

Let $C$ be the gain of the error amplifier, $N$ is given by expression 80 as

$$N = r\,\nu\,k\,C\,d. \qquad\qquad (377)$$

Then $\nu$ = 1, and substituting $r$, $k$, and $d$ with $r_0$, $k_0$, and do leads to

$$N = 0.5 \times 10^8 \times 2\pi \times 40 \times 10^3 \times \frac{1}{1001}. \qquad\qquad (378)$$

As is seen from Fig. 11, the maximum of the direct-current loop gain is given by

$$\frac{2\sqrt{3}}{9\,\delta^2}\,N \tag{379}$$

which is 134 in the case that $C = 1$ and $\delta = 6000$.

**Evaluation of $E$**

As for the rise of the output voltage, E is estimated in expression 366 to be

$$E \leq 20 \tag{380}$$

So $E$ is evaluated as $E = 10$ in the circuit for simulation. For a practical range of $\phi$, $\delta$, and $\mu$, $B = 0.0002$ is sufficient for stability. So $B$ is so evaluated in the circuit.

**Example of Simulation for Stable Feedback**

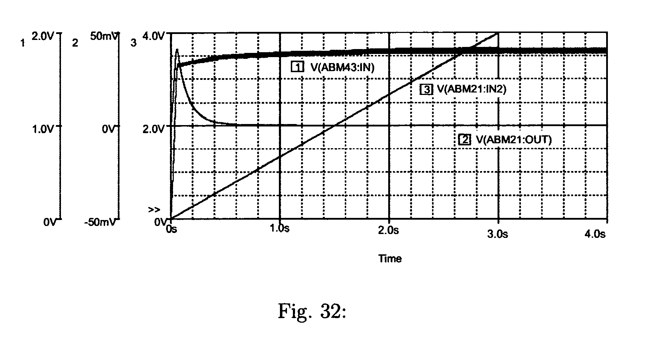

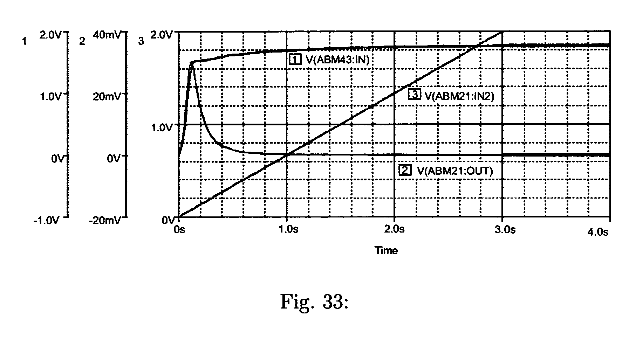

The feedback composed so far is shown to be stable by the circuit for simulation shown in Fig. 21. Results of the simulation are shown in the cases that the output voltage is 4 kV to the load of 20 M$\Omega$ in Fig. 32 and that the output voltage is 2 kV to the load of 200 M$\Omega$ in Fig. 33. The output of the error amplifier, the output of the subtraction circuit, and the reference voltage are shown in each figure relative to vertical axes 1, 2, and 3 respectively with the horizontal axis of time.

**[Mode for Invention 2]**

**Simple Power Supply**

**Simple Direct Current High Voltage Power Supply**

A simple direct-current stabilized high-voltage power supply is composed of the high-voltage generation circuit and the feedback circuit. The high-voltage generation circuit is the same as the high-voltage generation circuit of the smart direct-current stabilized high-voltage power supply. The feedback circuit is the same as the feedback circuit of the smart power supply except that the error amplifier is simple. Being different from the smart power supply, the error amplifier is not provided with the pole located at the origin.

**Circuit for Simulation**

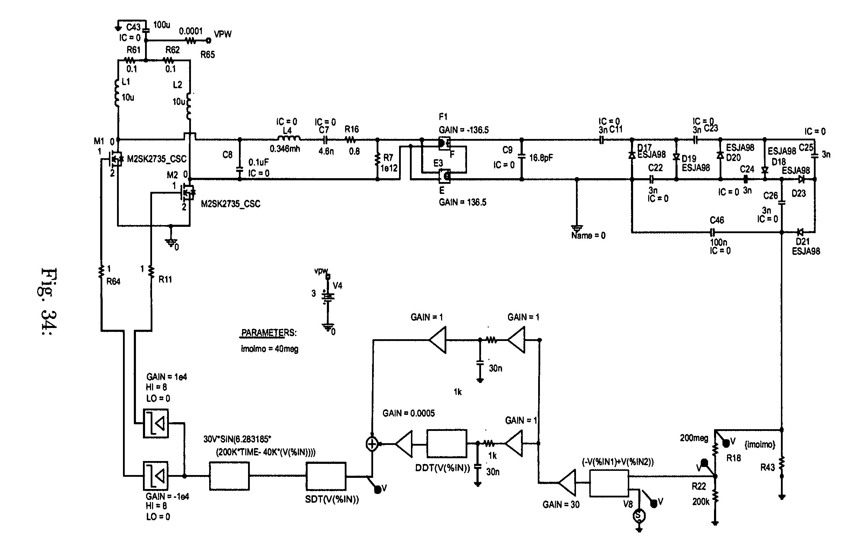

The circuit simulating the simple power supply is shown in Fig. 34. Based on the parameters obtained by simulating the high-voltage generation circuit, $N$ and $B$ is evaluated to show that the simulation is stable.

**Circuit Simulating Error Amplifier**

The circuit simulating the error amplifier is shown in Fig. 26. The error amplifier is composed of the subtraction circuit and the phase compensation circuit. The circuit simulating the subtraction circuit is composed of a behavior model and a gain block. The behavior model is provided two input and one output. The behavior model outputs the voltage difference between the input. The output of the behavior model is amplified by the gain block and supplied to the circuit simulating the phase compensation circuit. Let C be the gain of the gain block, the gain of the subtraction circuit is C.

The circuit simulating the phase compensation circuit is composed of a proportional part, a differential part, and an adder. The proportional part is a gain block of unity gain. The differential part is composed of a gain block and a behavior model. The behavior model provided with function DDT(x) outputs the differentiation of the input relative to time. The output of the behavior model is amplified by the gain block. Let the gain of the gain block be B, then the gain of the differential part is B.

Integration circuits are placed at the input of both the proportional part and the differential part so as to filter out noises of high frequency. The output of the proportional part and the differential part are summed by the adder. Therefore the transfer function of the error amplifier is given by

$$1 + B s \qquad\qquad (381)$$

It is possible to control the loop gain by C. In Fig. 34, B = 0.0005 and C = 30 in the circuit for simulation.

**Example of Simulation for Stable Feedback**

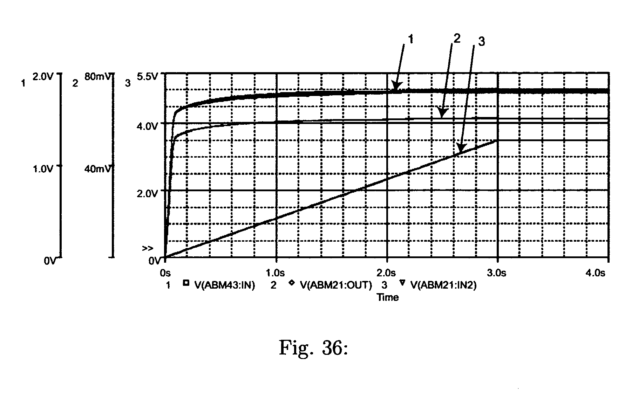

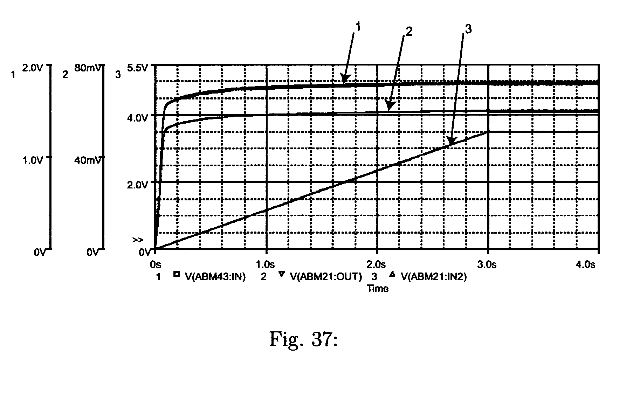

The feedback composed so far is shown to be stable by the simulation of the circuit given in Fig. 34. Results of the simulation are shown in the cases that the output voltage is 3.5 kV to the load of 20 MΩ in Fig. 36 and that the output voltage is 3.5 kV to the load of 200 MΩ in Fig. 37. In each figure, the output of the error amplifier, the output of the subtraction circuit, and the reference voltage are plotted against vertical axes 1, 2, and 3 respectively with the horizontal axis of time.

**Claims**

1.  Feedback for stabilizing DC voltage produced from a resonance circuit, where letting $\omega_r$, $Q$, and $g_r$ be the angular velocity of the resonance frequency, the Q-value, and the amplitude ratio at the resonance frequency respectively of resonance at the resonance circuit, then $\delta$, $\omega_0$, and $c$ are defined by

$$\delta \;=\; \frac{\omega_r}{2Q}, \qquad\qquad (1)$$

$$\omega_0 \;=\; \omega_r \sqrt{1 - \frac{1}{4Q^2}}, \qquad\qquad (2)$$

$$c \;=\; \frac{g_r\,\omega_r}{Q}, \qquad\qquad (3)$$

    and the resonance circuit is driven by such a carrier of fixed amplitude modulated in frequency that is defined by

$$w\,exp\,(i\,\omega_0\,t + i\,\psi), \qquad\qquad (4)$$

    where $w$ is the amplitude of the carrier and $\psi$ is a function of time representing a shift of phase, comprising:

    (a) approximating the transfer function of the resonance circuit on the condition that the bandwidth for frequency modulation is narrow enough compared with the resonance frequency by

$$\frac{1}{2\,i\,\omega_0}\,\frac{c\,(-\dot{\delta} + i\,\omega_0)}{s + \delta - i\,\omega_0}; \qquad\qquad (5)$$

    (b) a map from $\psi$ in expression 4 to $\phi$ defined by

$$\phi = \frac{d}{dt}\,\psi, \qquad\qquad (6)$$

    then the frequency of the carrier given in expression 4 is

$$\omega_0 + \phi \qquad\qquad (7)$$

and, letting $r_r$ and $r_i$ be defined by

$$r_r = \frac{1}{2} c w, \qquad\qquad (8)$$

$$r_i = \frac{\delta}{2\omega_0} c w, \qquad\qquad (9)$$

the resonance circuit, the transfer function of which is given in expression 5, being driven by the carrier in expression 4, outputs the carrier the amplitude of which is

$$\sqrt{p^2 + q^2}, \qquad\qquad (10)$$

where $p$ and $q$ satisfy equations given by

$$\frac{d}{dt}p = q\phi - p\delta + r_r, \qquad\qquad (11)$$

$$\frac{d}{dt}q = -p\phi - q\delta + r_i; \qquad\qquad (12)$$

(c) a first order delay which, letting the DC voltage generated by rectifying the carrier outputted by the resonance circuit be $z$, is represented by the following differential equation concerning $z$

$$\mu \frac{d}{dt}z + z = \nu \sqrt{p^2 + q^2}, . \qquad\qquad (13)$$

where $\mu$ and $\nu$ are a time constant and a multiplier at a rectification circuit respectively;
(d) feedback where, letting $k$, $d$, $E$, $A$, and $B$ be positive numbers and $\lambda$ be a reference voltage respectively, the DC voltage $z$ in expression 13 from the rectification circuit is compared with the reference voltage $\lambda$ and the voltage difference between $z$ and *lambda* is fed back to the frequency of the carrier $\phi$ in expression 6, which is expressed on the assumption that $\phi > 0$ by the transfer function having a pole located at the origin as

$$\phi = k\,d\,\frac{(E + A\,s + B\,s^2)}{s}\,(z - \lambda); \qquad\qquad (14)$$

(e) a system of differential equations where uniting expression 14, expressions 11, expression 12, and expression 13 makes the system of differential equations as

$$\frac{d}{dt}p \;=\; q\phi - p\delta + r_r \tag{15}$$

$$\frac{d}{dt}q \;=\; -p\phi - q\delta + r_i \tag{16}$$

$$\frac{d}{dt}z \;=\; \frac{-z + \nu\,\sqrt{p^2 + q^2}}{\mu} \tag{17}$$

$$\frac{d}{dt}\phi \;=\; kEd\,(z - \lambda) + \frac{kAd\left(-z + \nu\,\sqrt{p^2 + q^2}\right)}{\mu}$$
$$+\,kBd\left(-\frac{\sqrt{p^2 + q^2}\,(\nu + \nu\,\mu\,\delta)}{\mu^2} + \frac{z}{\mu^2} + \frac{\nu\,(q\,r_i + p\,r_r)}{\sqrt{p^2 + q^2}\,\mu}\right); \tag{18}$$

(f) an equilibrium point where, letting $(p_e, q_e, z_e, \phi_e)$ be the equilibrium point of the system of differential equations, then $p_e$, $q_e$, and $z_e$ are given in functions of $\phi_e$ as

$$p_e \;=\; \frac{\phi_e r_i + \delta\,r_r}{\phi_e{}^2 + \delta^2}, \tag{19}$$

$$q_e \;=\; -\frac{-\delta\,r_i + r_r\phi_e}{\phi_e{}^2 + \delta^2}, \tag{20}$$

$$z_e \;=\; \nu\sqrt{\frac{r_i{}^2 + r_r{}^2}{\phi_e{}^2 + \delta^2}}, \tag{21}$$

$$\lambda \;=\; \nu\sqrt{\frac{r_i{}^2 + r_r{}^2}{\phi_e{}^2 + \delta^2}}; \tag{22}$$

(g) a characteristic polynomial where, letting m(h) be the characteristic polynomial of the differential equation system approximating the above system of differential equations linearly in the neighborhood of the equilibrium point, and letting m(h) be expressed as

$$m(h) = a_0 h^4 + a_1 h^3 + a_2 h^2 + a_3 h + a_4, \tag{23}$$

then, letting $r$ be defined by

$$r = \sqrt{r_r{}^2 + r_i{}^2}, \tag{24}$$

then coefficients $a_0$, $a_1$, $a_2$, $a_3$, and $a_4$ are given as

$$a_0 = 1, \tag{25}$$

$$a_1 = \frac{2\mu\delta + 1}{\mu}, \tag{26}$$

$$a_2 = \frac{2\sqrt{\phi_e^2 + \delta^2}\delta + kd\nu B\phi_e r + \mu\left(\phi_e^2 + \delta^2\right)^{3/2}}{\sqrt{\phi_e^2 + \delta^2}\mu}, \tag{27}$$

$$a_3 = \frac{\phi_e kd\nu Ar + \left(\phi_e^2 + \delta^2\right)^{3/2}}{\sqrt{\phi_e^2 + \delta^2}\mu}, \tag{28}$$

$$a_4 = \frac{\phi_e kd\nu Er}{\sqrt{\phi_e^2 + \delta^2}\mu}; \tag{29}$$

(h) modification in the case of $\phi \leq 0$ where the transfer function of the feedback circuit shown in expression 14 remains invariant by replacing $\phi$ with $-\phi$ which modifies expression 11 and expression 12 to

$$\frac{d}{dt}p = -q\phi - p\delta + r_r, \tag{30}$$

$$\frac{d}{dt}q = p\phi - q\delta + r_i; \tag{31}$$

(i) derivation in the case of $\phi \leq 0$ where unifying expression 14, expression 30, expression 31, and expression 13, on the assumption that the domain of $\phi$ is in $\phi > 0$, leads to the system of differential equations corresponding to expressions from 15 to 18, which is approximated linearly by the differential equation system in the neighborhood of the equilibrium point, and letting $m(h)$ be the characteristic polynomial of the differential equation system represented by

$$m(h) = a_0 h^4 + a_1 h^3 + a_2 h^2 + a_3 h + a_4, \tag{32}$$

$$r = \sqrt{r_r^2 + r_i^2}, \tag{33}$$

then coefficients $a_0$, $a_1$, $a_2$, $a_3$ are given regardless of the sign of $\phi$ by expressions from 25 to 29 ;
(j) introduction of a DC gain and consequent redefinition where, $k$, $d$, $v$, and $r$ being included as product $kdvr$ together with $A$, $B$ or $E$ in expressions from 25 to 29, $N$ is introduced by

$$kd\nu rA = N, \tag{34}$$

where $B'$ and $E'$ are defined by

$$k\,d\nu\,r\,B \;=\; B'\,N, \qquad (35)$$

$$k\,d\nu\,r\,E \;=\; E'\,N, \qquad (36)$$

or rather

$$B' \;=\; \frac{B}{A}, \qquad (37)$$

$$E' \;=\; \frac{E}{A}, \qquad (38)$$

then $B'$ and $E'$ are replaced with $B$ and $E$, coefficients $a_0$, $a_1$, $a_2$, $a_3$, and $a_4$ are rewritten to

$$a_0 \;=\; 1, \qquad (39)$$

$$a_1 \;=\; \frac{2\,\mu\,\delta + 1}{\mu}, \qquad (40)$$

$$a_2 \;=\; \frac{2\sqrt{\phi_e{}^2 + \delta^2}\,\delta + B\phi_e N + \mu\left(\phi_e{}^2 + \delta^2\right)^{3/2}}{\sqrt{\phi_e{}^2 + \delta^2}\,\mu}, \qquad (41)$$

$$a_3 \;=\; \frac{\phi_e N + \left(\phi_e{}^2 + \delta^2\right)^{3/2}}{\sqrt{\phi_e{}^2 + \delta^2}\,\mu}, \qquad (42)$$

$$a_4 \;=\; \frac{E\phi_e N}{\sqrt{\phi_e{}^2 + \delta^2}\,\mu}, \qquad (43)$$

as a function of $\phi_e$ ;
(k) resolution of the characteristic polynomial where the characteristic polynomial $m(h)$ defined in expression 23 and expression 32 is redefined by using coefficients given in expressions from 39 to 43 as

$$m(h) = a_0 h^4 + a_1 h^3 + a_2 h^2 + a_3 h + a_4, \qquad (44)$$

then characteristic polynomial $m(h)$ is expressed as

$$m(h) = \frac{\left((h+\delta)^2 + \phi^2\right) h (\mu h + 1)}{\mu} + \frac{\phi (h^2 B + h + E) N}{\sqrt{\phi^2 + \delta^2}\mu}; \qquad (45)$$

(I) derivation of the transfer function of the voltage generation circuit where, letting $F_w$ and $B_w$ be the transfer functions of the voltage generation circuit and the feedback circuit respectively, then without discriminating C $F_w$ and $1/C\,B_w$ for constant $C$, $F_w$ and $B_w$ are resoectively given by

$$F_w = \frac{N\phi}{\sqrt{\phi^2 + \delta^2}\,(\mu h + 1)\left((h+\delta)^2 + \phi^2\right)}, \qquad (46)$$

and

$$B_k = \frac{B\,h^2 + h + E}{h}, \qquad (47)$$

then the closed loop transfer function $F_w/(1 + F_w B_k)$ is expressed by

$$\frac{F_w}{1 + F_w\,B_k} = \frac{N\phi}{\mu\sqrt{\phi^2 + \delta^2}} \qquad (48)$$
$$\times \left(\frac{(\mu h + 1)\left((h+\delta)^2 + \phi^2\right)}{\mu} + \frac{N\phi\,(Bh^2 + h + E)}{h\mu\sqrt{\phi^2 + \delta^2}}\right)^{-1} .;$$

wherein the characteristic polynomial $m(h)$ coincides with the denominator of closed loop transfer function $F_w/(1 + F_w B_k)$, and stable feedback in the sense that all the roots of the denominator of the closed loop transfer function has a negative real part is realized by selecting $E$, $B$, and $N$ to be such that all the roots of the characteristic polynomial have a negative real part

2. From expression 45 in Claim 1 which expresses characteristic polynomial $m(h)$ as

$$m(h) = \frac{\left((h+\delta)^2 + \phi^2\right) h (\mu h + 1)}{\mu} + \frac{(h^2 B + h + E) N\phi}{\sqrt{\phi^2 + \delta^2}\mu}, \qquad (49)$$

the first term becomes positive in $h$ such as $h < -1/\mu$ and, letting domain $S$ in $h$ be defined as

$$S = \left\{h \,\middle|\, h < -\frac{1}{\mu}\right\} \cap \left\{h \,\middle|\, B\,h^2 + h + E \geq 0\right\}, \qquad (50)$$

then for an arbitrary $h$ in $S$, $m(h) > 0$ holds regardless of $\phi$, and the real root of $m(h) = 0$ belongs to the complement of $S$, hereupon letting $m(h)$ be thought to be function $E_h(\phi)$ of $\phi$ defined by

$$E_h(\phi) = m(h). \tag{51}$$

in domain $R$ where $R$ is defined by

$$R = \left\{ h \,\middle|\, h < -\frac{1}{\mu} \right\} \cap \left\{ h \,\middle|\, B\,h^2 + h + E < 0 \right\} \tag{52}$$

on the assumption that $R$ is not empty, then there exists such an unique $\phi_h$ for $h$ in $R$ that $E_h(\phi)$ becomes minimum at $\phi_h$, and

$$E_h(\phi_h) = \frac{\left( \delta^2 \,(h+\delta)^2 - \phi_h{}^2 \left( \delta^2 + 2\,\phi_h{}^2 \right) \right) h\,(\mu\,h + 1)}{\delta^2 \mu}, \tag{53}$$

wherein it is possible to define function $F$ for an arbitrary $h$ in $R$ by

$$F : h \rightarrow E_h(\phi_h) \tag{54}$$

where $m(h) > 0$ regardless of $\phi$ for such $h$ in $R$ that satisfies

$$F(h) > 0. \tag{55}$$

and, $F$ being dependent on $E$, $B$, and $N$, it is possible to limit real roots of equation $m(h) = 0$ in range by evaluating $E$, $B$, and $N$.

3. A power supply providing a stabilized DC voltage comprising a voltage generation circuit which includes:

   (a) a driver circuit generating a carrier which is the high-frequency alternating current;
   (b) a resonance circuit which is driven by the carrier, and
   (c) a rectification circuit by which the output of the resonance circuit is rectified to be a DC voltage which is the output of the rectification circuit and the output voltage of the power supply;

   and a feedback circuit which includes:

   (a) an error amplifier which outputs the voltage difference between the output voltage of the power supply and a reference voltage supplied externally, and
   (b) a voltage controlled oscillator (VCO) which generates the frequency decided by the output of the error amplifier and is provided with means for controlling the driver circuit so as to equate the frequency of the carrier with the frequency generated by the VCO;

   feeds back the output voltage of the power supply to the frequency of the carrier where the feedback moves the output voltage in a single direction to depart from the ground, wherein the stabilization of the output voltage against a wide range of load is realized by such characteristic polynomial 44 given in Claim 1 that has a real dominant root separated from imaginary roots.

4. As for the power supply described in claim 3 where, letting the transfer function of the feedback circuit expressed with positive constants $E$ and $B$ by

$$\frac{E}{s} + 1 + B\,s, \tag{56}$$

satisfy

$$E\,\mu^2 - \mu + B < 0, \tag{57}$$

$$E\,B < \frac{1}{4}, \tag{58}$$

then the dominant root of the characteristic polynomial defined in expression 44 is a real root located between-$1/\mu$ and the origin, wherein, $F(h)$ defined in Claim 2 being dependent on $N$, $E$, and $B$, evaluating $N$, $E$, and $B$ so as to realize such $F(h)$ that limits real root in a fixed interval makes the dominant root of the characteristic polynomial to be a real root separated from imaginary roots.

**5.** As for the power supply described in Claim 3 where the transfer function of the feedback circuit expressed with positive constants $E$ and $B$ by

$$\frac{E}{s} + 1 + B\,s, \tag{59}$$

$N$ and $B$, being concerned with the amplification and the differentiation of the ripples respectively and thereby limited in magnitude in the case that ripples are superimposed on the output voltage, are selected to be

$$E < \frac{1}{\mu}, \tag{60}$$

$$B \sim \frac{1}{\delta}, \tag{61}$$

then, letting $\xi$ be the dominant root near the origin, $\xi$ is estimated to be

$$\xi < 2\,E \tag{62}$$

and the time constant of the rise of the output voltage is al least longer than 1/2 $E$, wherein the closed loop gain is augmented by attenuating by a filter the ripples outside of the bandwidth where the feedback is effective.

**6.** Feedback for stabilizing DC voltage produced from a resonance circuit, where the transfer function of the feedback circuit that feeds back the voltage difference as described in Claim 1 between output voltage $z$ from the rectification circuit and the reference voltage $\lambda$ to frequency $\phi$, is not the transfer function defined in expression 14 in Claim 1, but the transfer function without the pole located at the origin defined by

$$\phi = k\,d\,(A + B\,s)\,(z - \lambda) + \phi_C \tag{63}$$

where *k, d, A,* and *B* are positive constants, $\phi$ such as $\phi > 0$, and $\phi_C$ is a constant, comprising:

(a) the transfer function 63 expressed by

$$\phi = k\,d\,A\,(z - \lambda) + B\,\frac{d}{dt}z + \phi_C, \tag{64}$$

expression 13

$$\frac{d}{dt}z = \frac{-z + \nu\sqrt{p^2 + q^2}}{\mu}, \tag{65}$$

and the expression derived from expressions 64 and 65 as

$$\phi = kdA\,(z - \lambda) + \frac{kdB\left(-z + \nu\sqrt{p^2 + q^2}\right)}{\mu} + \phi_C; \tag{66}$$

(b) by using expression 66, expressions 11 and 12 is rewritten to

$$\tag{67}$$

$$\frac{d}{dt}p = \left(kdA\,(z - \lambda) + \frac{kdB\left(-z + \nu\sqrt{p^2 + q^2}\right)}{\mu} + \phi_C\right)q - \delta\,p + r_r,$$

$$\frac{d}{dt}q = -\left(kdA\,(z - \lambda) + \frac{kdB\left(-z + \nu\sqrt{p^2 + q^2}\right)}{\mu} + \phi_C\right)p - \delta\,q + r_i; \tag{68}$$

(c) then unifying expressions 68, 69, and 65 leads to the system of differential equations as follows:

$$\tag{69}$$

$$\frac{d}{dt}p = \left(kdA\,(z - \lambda) + \frac{kdB\left(-z + \nu\sqrt{p^2 + q^2}\right)}{\mu} + \phi_C\right)q - \delta\,p + r_r,$$

$$\tag{70}$$

$$\frac{d}{dt}q = -\left(kdA\,(z - \lambda) + \frac{kdB\left(-z + \nu\sqrt{p^2 + q^2}\right)}{\mu} + \phi_C\right)p - \delta\,q + r_i,$$

$$\frac{d}{dt}z = \frac{-z + \nu\sqrt{p^2 + q^2}}{\mu}; \qquad (71)$$

(d) letting $p_e$, $q_e$, and $z_e$ be the equilibrium point of the system of differential equations, then $p_e$, $q_e$, $z_e$, and $\lambda$ are expressed as a function of $\phi_e$ by

$$p_e = \frac{\phi_e r_i + \delta r_r}{\phi_e^2 + \delta^2}, \qquad (72)$$

$$q_e = -\frac{-\delta r_i + r_r \phi_e}{\phi_e^2 + \delta^2}, \qquad (73)$$

$$z_e = \nu\sqrt{\frac{r_i^2 + r_r^2}{\phi_e^2 + \delta^2}}, \qquad (74)$$

$$\lambda = \frac{1}{k\,d\,A}\left(-\phi_e + kdA\nu\sqrt{\frac{r_i^2 + r_r^2}{\phi_e^2 + \delta^2}} + \phi_C\right); \qquad (75)$$

(e) letting $m(h)$ be the characteristic polynomial of the differential equation system approximating linearly the system of differential equations in the neighborhood of the equilibrium point, and letting $m(h)$ be represented by

$$m(h) = a_0 h^3 + a_1 h^2 + a_2 h + a_3 \qquad (76)$$

with coefficients $a_0$, $a_1$, $a_2$, and $a_3$, then $a_0$, $a_1$, $a_2$, and $a_3$ are expressed by

$$a_0 = 1, \qquad (77)$$

$$a_1 = \frac{1 + 2\mu\delta}{\mu}, \qquad (78)$$

$$a_2 = \frac{\phi_e kdBr\nu + 2\delta\sqrt{\phi_e^2 + \delta^2} + \mu\left(\phi_e^2 + \delta^2\right)^{3/2}}{\mu\sqrt{\phi_e^2 + \delta^2}}, \qquad (79)$$

$$a_3 = \frac{\phi_e kdA\nu\, r + \left(\phi_e^2 + \delta^2\right)^{3/2}}{\mu\sqrt{\phi_e^2 + \delta^2}}, \qquad (80)$$

where $r$ is defined by

$$r = \sqrt{r_r{}^2 + r_i{}^2}, \tag{81}$$

(f) in the case that $\phi \leq 0$, the transfer function of the feedback circuit which feeds back the voltage difference to the frequency of the carrier is given by expression 66 as

$$\phi = kdA\,(z - \lambda) + \frac{kdB\left(-z + \nu\,\sqrt{p^2 + q^2}\right)}{\mu} + \phi_C \tag{82}$$

and expressions 11 and 12 is rewritten by replacing $\phi$ with $-\phi$ to

$$\frac{d}{dt}p \;=\; -q\phi - p\delta + r_r, \tag{83}$$

$$\frac{d}{dt}q \;=\; p\phi - q\delta + r_i. \tag{84}$$

and expressions 83 and 84 where $\phi$ is substituted by expression 82 are equivalent to expressions 68 and 69, the system of differential equations thus derived being equivalent to the system of differential equations composed of expressions 70, 71, and 71, and therefore the characteristic polynomial of the differential equation system is given regardless of the range of the diving frequency by expressions 76, 77, 78, 79 and 80;

(g) $k$, $d$, $\nu$ and $r$ being included in expressions 77 and 80 as a product $k\,d\,\nu\,r$ together with A or B, N is introduced by

$$k\,d\,\nu\,r\,A = N, \tag{85}$$

and $B'$ is defined by

$$k\,d\,\nu\,r\,B = B'\,N, \tag{86}$$

then $B'$ thus defined is replaced again with $B$, hereby expressions from 77 to 80 are rewritten to

$$a_0 \;=\; 1, \tag{87}$$

$$a_1 \;=\; \frac{2\,\mu\,\delta + 1}{\mu}, \tag{88}$$

$$a_2 \;=\; \frac{\mu\left(\phi_e{}^2 + \delta^2\right)^{3/2} + \phi_e BN + 2\delta\,\sqrt{\phi_e{}^2 + \delta^2}}{\mu\,\sqrt{\phi_e{}^2 + \delta^2}}, \tag{89}$$

$$a_3 = \frac{\phi_e N + \left(\phi_e{}^2 + \delta^2\right)^{3/2}}{\mu \sqrt{\phi_e{}^2 + \delta^2}}; \qquad (90)$$

(h) then the characteristic polynomial $m(h)$ defined in expression 76 is redefined by using coefficients in expressions from 87 to 90 as

$$m(h) = a_0 h^3 + a_1 h^2 + a_2 h + a_3, \qquad (91)$$

then $m(h)$ is expressed by

$$m(h) = \frac{\left((h+\delta)^2 + \phi^2\right)(\mu h + 1)}{\mu} + \frac{\phi (hB + 1) N}{\sqrt{\phi^2 + \delta^2}\mu}; \qquad (92)$$

(i) letting $F_w$ and $B_w$ be the transfer functions of the voltage generation circuit and the feedback circuit respectively, then without discriminating $C\,F_w$ and $1/C\,B_w$ for a common constant $C$, $F_w$ and $B_w$ are given respectively by

$$F_w = \frac{N\phi}{\sqrt{\phi^2 + \delta^2}\,(\mu h + 1)\left((h+\delta)^2 + \phi^2\right)}, \qquad (93)$$

and

$$B_k = B\,h + 1, \qquad (94)$$

then closed loop transfer function $F_w/(1 + F_w B_w)$ is given by

$$\frac{F_w}{1 + F_w B_k} = \frac{N\phi}{\mu\sqrt{\phi^2 + \delta^2}}$$
$$\times \left(\frac{(\mu h + 1)\left((h+\delta)^2 + \phi^2\right)}{\mu} + \frac{N\phi(Bh + 1)}{\mu\sqrt{\phi^2 + \delta^2}}\right)^{-1}; \qquad (95)$$

wherein, characteristic polynomial $m(h)$ coinciding with the denominator of closed loop transfer function $F_w/(1 + F_W B_W)$ except for multiplication of a constant, the stable feedback in the sense that roots have a negative real part in the denominator of the closed loop transfer function composed of the voltage generation and the feedback circuits is implemented by evaluating $B$ and $N$ so that all the roots of characteristic polynomial $m(h)$ have a negative real part

**7.** From expression 92 in Claim 6 which expresses characteristic polynomial $m(h)$ as

$$m(h) = \frac{\left((h+\delta)^2 + \phi^2\right)(\mu\, h + 1)}{\mu} + \frac{\phi\, N\,(hB + 1)}{\mu\,\sqrt{\phi^2 + \delta^2}} \qquad (96)$$

then the first term becomes negative in $h$ such as $h < -1/\mu$ and, letting $S$ be the domain of $h$ defined by

$$S = \left\{ h \,\middle|\, h < -\frac{1}{\mu} \right\} \cap \{ h \,|\, B\,h + 1 \le 0 \} \qquad (97)$$

then for an arbitrary $h$ in $S$, $-m(h) > 0$ holds regardless of $\phi$, and the real roots in $m(h) = 0$ are included in the complement of $S$,
hereupon let $-m(h)$ be thought to be function $E_h(\phi)$ of $\phi$ for arbitrary $h$ in $R$ defined by

$$E_h(\phi) = -m(h). \qquad (98)$$

where $R$ is defined by

$$R = \left\{ h \,\middle|\, h < -\frac{1}{\mu} \right\} \cap \{ h \,|\, B\,h + 1 > 0 \} \qquad (99)$$

on the assumption that $R$ is not empty, then there exists such an unique $\phi_h$ for $h$ in $R$ that $E_h(\phi)$ takes the minimum $E_h(\phi_h)$ at $\phi_h$, and

$$E_h(\phi_h) = -\frac{\left(\delta^2\,(h+\delta)^2 - \phi_h{}^2\left(2\,\phi_h{}^2 + \delta^2\right)\right)(\mu\, h + 1)}{\delta^2 \mu}, \qquad (100)$$

wherein it is possible to define $F$ mapping arbitrary $h$ in $R$ uniquely to $E_h(\phi_h)$ by

$$F : h \to E_h(\phi_h). \qquad (101)$$

where $-m(h) > 0$ regardless of $\phi$ for such $h$ in $R$ that satisfies

$$F(h) > 0, \qquad (102)$$

and, $F$ being dependent on $B$ and $N$, it is possible to limit real roots of equation $m(h) = 0$ in range by evaluating $B$ and $N$.

8. In the power supply providing a stabilized DC voltage described in Claim 3 where the transfer function of the feedback circuit is not provide with the pole located in the neighborhood of the origin, the feedback stabilizing the output voltage works in a single direction to make the output voltage depart from the ground, wherein the output voltage supplying a wide range of the load connected to the power supply is stabilized when the dominant root is a real root separated from imaginary roots in the characteristic polynomial in expression 91 described in Claim 6

9. As for characteristic polynomial $m(h)$ defined in expression 91 in Claim 6, an inflection point $h_\tau$ of the graph $y = -m(h)$ is given regardless of $\phi$ by

$$h_\tau = -\frac{1}{3}\frac{2\mu\delta+1}{\mu} = -\frac{a_1}{3}, \qquad (103)$$

then the sufficient condition that the dominant root is a real root separated from imaginary roots in $m(h) = 0$ is

$$-m(h_\tau) > 0, \qquad (104)$$

hence the sufficient condition that the dominant root is a real root separated from imaginary roots regardless of $\phi$ is

$$F(h_\tau) > 0, \qquad (105)$$

wherein, by utilizing $F$ being dependent on $B$ and $N$, it is possible to evaluate $B$ and $N$ so as that $F$ satisfies expression 105.

10. In the power supply providing a stabilized DC voltage described in Claim 3, the ripples caused by rectification and superimposed on the output voltage is higher in frequency than the effective bandwidth of feedback which is dependent on the dominant root of characteristic polynomial $m(h)$ defined in expression 91, then a large closed-loop gain is implemented by attenuating by a filter frequencies higher than the bandwidth where the feedback is effective.

11. In the power supply providing a stabilized DC voltage described in Claim 3, wherein selecting the frequency of the carrier to be lower than the resonance frequency avoids temporary shifts of the output voltage directly caused by the change of the frequency, where the temporary shifts impede the corresponding change of the output voltage following increase or decrease of the frequency of the carrier through the frequency dependence of the resonance characteristic, which stabilizes the feedback of the output voltage to the frequency of the carrier.

12. In the power supply providing a stabilized DC voltage described in Claim 3, wherein the stable feedback is implemented by suppressing fast change of the carrier in frequency.

# List of Figures

1 . . . . . . . . . . . . . . . . . . . . . . . . . . . . . . . . . . . . . . . . . . . . . . . . . . 83
2 . . . . . . . . . . . . . . . . . . . . . . . . . . . . . . . . . . . . . . . . . . . . . . . . . . 84
3 . . . . . . . . . . . . . . . . . . . . . . . . . . . . . . . . . . . . . . . . . . . . . . . . . . 85
4 . . . . . . . . . . . . . . . . . . . . . . . . . . . . . . . . . . . . . . . . . . . . . . . . . . 86
5 . . . . . . . . . . . . . . . . . . . . . . . . . . . . . . . . . . . . . . . . . . . . . . . . . . 87
6 . . . . . . . . . . . . . . . . . . . . . . . . . . . . . . . . . . . . . . . . . . . . . . . . . . 88
7 . . . . . . . . . . . . . . . . . . . . . . . . . . . . . . . . . . . . . . . . . . . . . . . . . . 89
8 . . . . . . . . . . . . . . . . . . . . . . . . . . . . . . . . . . . . . . . . . . . . . . . . . . 90
9 . . . . . . . . . . . . . . . . . . . . . . . . . . . . . . . . . . . . . . . . . . . . . . . . . . 91
10 . . . . . . . . . . . . . . . . . . . . . . . . . . . . . . . . . . . . . . . . . . . . . . . . . . 92
11 . . . . . . . . . . . . . . . . . . . . . . . . . . . . . . . . . . . . . . . . . . . . . . . . . . 93
12 . . . . . . . . . . . . . . . . . . . . . . . . . . . . . . . . . . . . . . . . . . . . . . . . . . 94
13 . . . . . . . . . . . . . . . . . . . . . . . . . . . . . . . . . . . . . . . . . . . . . . . . . . 95
14 . . . . . . . . . . . . . . . . . . . . . . . . . . . . . . . . . . . . . . . . . . . . . . . . . . 96
15 . . . . . . . . . . . . . . . . . . . . . . . . . . . . . . . . . . . . . . . . . . . . . . . . . . 97
16 . . . . . . . . . . . . . . . . . . . . . . . . . . . . . . . . . . . . . . . . . . . . . . . . . . 98
17 . . . . . . . . . . . . . . . . . . . . . . . . . . . . . . . . . . . . . . . . . . . . . . . . . . 99
18 . . . . . . . . . . . . . . . . . . . . . . . . . . . . . . . . . . . . . . . . . . . . . . . . . . 100
19 . . . . . . . . . . . . . . . . . . . . . . . . . . . . . . . . . . . . . . . . . . . . . . . . . . 101
20 . . . . . . . . . . . . . . . . . . . . . . . . . . . . . . . . . . . . . . . . . . . . . . . . . . 102
21 . . . . . . . . . . . . . . . . . . . . . . . . . . . . . . . . . . . . . . . . . . . . . . . . . . 103
22 . . . . . . . . . . . . . . . . . . . . . . . . . . . . . . . . . . . . . . . . . . . . . . . . . . 104
23 . . . . . . . . . . . . . . . . . . . . . . . . . . . . . . . . . . . . . . . . . . . . . . . . . . 105
24 . . . . . . . . . . . . . . . . . . . . . . . . . . . . . . . . . . . . . . . . . . . . . . . . . . 106
25 . . . . . . . . . . . . . . . . . . . . . . . . . . . . . . . . . . . . . . . . . . . . . . . . . . 107
26 . . . . . . . . . . . . . . . . . . . . . . . . . . . . . . . . . . . . . . . . . . . . . . . . . . 108
27 . . . . . . . . . . . . . . . . . . . . . . . . . . . . . . . . . . . . . . . . . . . . . . . . . . 109
28 . . . . . . . . . . . . . . . . . . . . . . . . . . . . . . . . . . . . . . . . . . . . . . . . . . 110
29 . . . . . . . . . . . . . . . . . . . . . . . . . . . . . . . . . . . . . . . . . . . . . . . . . . 111
30 . . . . . . . . . . . . . . . . . . . . . . . . . . . . . . . . . . . . . . . . . . . . . . . . . . 112
31 . . . . . . . . . . . . . . . . . . . . . . . . . . . . . . . . . . . . . . . . . . . . . . . . . . 113
32 . . . . . . . . . . . . . . . . . . . . . . . . . . . . . . . . . . . . . . . . . . . . . . . . . . 114
33 . . . . . . . . . . . . . . . . . . . . . . . . . . . . . . . . . . . . . . . . . . . . . . . . . . 115
34 . . . . . . . . . . . . . . . . . . . . . . . . . . . . . . . . . . . . . . . . . . . . . . . . . . 116
35 . . . . . . . . . . . . . . . . . . . . . . . . . . . . . . . . . . . . . . . . . . . . . . . . . . 117
36 . . . . . . . . . . . . . . . . . . . . . . . . . . . . . . . . . . . . . . . . . . . . . . . . . . 118
37 . . . . . . . . . . . . . . . . . . . . . . . . . . . . . . . . . . . . . . . . . . . . . . . . . . 119

Fig. 1:

Amplitude Ratio

Fig. 2:

Fig. 3:

**Amplitude Ratio**

Fig. 4:

Fig. 5:

Fig. 6:

Fig. 7:

Carrier Modulated
in Amplitude

Direct Current
Voltage

| Resonance Circuit | Rectification Circuit |

Fig. 8:

Envelope of Carrier
Modulated in Amplitude

Direct Current
Voltahe

Virtual Resonance
Circuit

Virtual Rectification
Circuit

Fig. 9:

Fig. 10:

Fig. 11:

Fig. 12:

Fig. 13:

Fig. 14:

Fig. 15:

Fig. 16:

EP 2 083 509 A1

Fig. 17:

Fig. 18:

Fig. 19:

Fig. 20:

Fig. 21:

R = 0.8 Ω      L = 346 mH      C = 4.6 nF

$C_{d1}$ = 100 nF  $C_{d2}$ = 16.8 pF   N = 136.5

Fig. 22:

$I_1$

$I_2$

Primary $E_1$ $E_2$ Secondary

1 : n

Fig. 23:

F : Current Controlled Current Source
E : Voltage Controlled Voltage Source

Fig. 24:

LO=0
HI=8
GAIN=10000

30V*SIN(6.283185*(200K*TIME - 40K*(V(%IN))))

B

GAIN= -10000
HI=8
LO=0

A

SDT(V(%IN))

Fig. 25:

Fig. 26:

Fig. 27:

Fig. 28:

Fig. 29:

Fig. 30:

Fig. 31:

Fig. 32:

Fig. 33:

Fig. 34:

Fig. 35:

Fig. 36:

Fig. 37:

## INTERNATIONAL SEARCH REPORT

International application No.

PCT/JP2007/000477

A. CLASSIFICATION OF SUBJECT MATTER
*H02M3/00*(2006.01)i, *H02M3/24*(2006.01)i

According to International Patent Classification (IPC) or to both national classification and IPC

B. FIELDS SEARCHED

Minimum documentation searched (classification system followed by classification symbols)
H02M3/00, H02M3/24

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A<br>Y<br>X | JP 2005-137085 A  (Japan Science and Technology Agency),<br>26 May, 2005 (26.05.05),<br>Par. Nos. [0023] to [0031], [0035] to [0036], [0054] to [0059], [0064] to [0086]; Figs. 1 to 11<br>(Family: none) | 1-10<br>11<br>12 |
| A<br>Y | JP 2-7116 A  (RCA Licensing Corp.),<br>11 January, 1990 (11.01.90),<br>Page 2, lower right, line 3 to page 6, lower right, line 12; Figs. 1 to 2<br>& US 4729085 A1          & EP 452981 A1<br>& DE 3778524 A | 1-10<br>11,12 |

☒ Further documents are listed in the continuation of Box C.  ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| | |
|---|---|
| Date of the actual completion of the international search<br>12 July, 2007 (12.07.07) | Date of mailing of the international search report<br>24 July, 2007 (24.07.07) |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2007/000477 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2005-80424 A  (Taiyo Yuden Co., Ltd.),<br>24 March, 2005 (24.03.05),<br>Full text; all drawings<br>(Family: none) | 1-12 |
| A | JP 7-123700 A  (Fuji Electric Co., Ltd.),<br>12 May, 1995 (12.05.95),<br>Full text; all drawings<br>(Family: none) | 1-12 |

Form PCT/ISA/210 (continuation of second sheet) (April 2005)

**EP 2 083 509 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2002359967 A

- WO 2005137085 A